# EUROPEAN PATENT SPECIFICATION

(11) **EP 0 469 571 B1**
(45) Date of publication and mention of the grant of the patent: **12.11.1997**
(21) Application number: 91112864.3
(22) Date of filing: 31.07.1991
(51) Int. Cl.: G06F 11/20

(54) **Redundant semiconductor memory device**
Redundante Halbleiterspeicheranordnung
Dispositif de mémoire à semi-conducteurs redondant

(30) Priority: 31.07.1990 US 560720
(43) Date of publication of application: 05.02.1992
(73) Proprietor: TEXAS INSTRUMENTS INCORPORATED, Dallas Texas 75265 (US)
(72) Inventor: McAdams, Hugh P., Houston, Texas 77084 (US)
(74) Representative: Leiser, Gottfried, Dipl.-Ing.

(56) References cited:
- EP-A- 0 180 212
- EP-A- 0 284 102

## Description

This invention relates to integrated circuits, and in particular to integrated circuits devices formed in a semiconductor substrate, for example memory devices such as dynamic random access memories.

The development of very large scale integrated circuits (VLSI) semiconductor devices of the Dynamic Random Access Memory (DRAM) type is well known. Over the years, the industry has steadily progressed from DRAMs of the 16K type (as shown in the U.S. Pat. 4,055,444 issued to Rao) to DRAMs of the 1MB type (as shown in U.S. Pat. 4,658,377 issued to McElroy), and progressed to DRAMs of the 4MB type. A 16MB DRAM, wherein more than 16 million memory cells and associated circuitry are integrated on a single memory chip, is the next generation of DRAM scheduled for production.

Presently in designing VLSI semiconductor memory devices of the 16MB type, designers are faced with numerous challenges.

One cause for concern, for example, is the elimination of defects. The development of larger DRAMs has been fostered by the reduction in memory cell geometries, as illustrated in U.S. Pat. 4,240,092 to KUO (a planar capacitor cell) and as illustrated in U.S. Pat. 4,721,987 to Baglee et. Al. (a trench capacitor cell). The extremely small geometries of the 16 MB DRAM will be manufactured using sub-micron technology. The reduction in feature size has meant that particles that previously did not cause problems in the fabrication process, now can cause circuit defects and device failures.

In order to ameliorate defects, redundancy schemes have been introduced. The redundancy schemes normally consist of a few extra rows and columns of memory cells that are placed within the memory array to replace defective rows and columns of memory cells. Designers need new and improved redundancy schemes in order to effectively and efficiently repair defects and thereby increase yields of 16 MB DRAM chips.

A redundancy scheme for the replacement of defective main memory cells with redundant main memory cells is disclosed in European Patent Application 85113807.3 (INMOS Corp.), corresponding to document EP-A- 0 180 212.

The memory array contains a portion of each main memory column and/or row and one or more spare columns and/or rows. When a portion of an addressed main column and/or row is defective a spare replacement column and/or row is accessed in place of the defective portion of the addressed portion.

However, this redundancy scheme does not fully address the problem of replacing larger scale defects in the memory. An embodiment of the present invention has the advantage that redundant columns and rows of memory cells are provided, and that row and column addresses are encoded which are better utilised by the circuitry for reading and writing information to and from memory cells.

According to the present invention there is provided a memory device comprising a plurality of memory arrays having memory cells, each memory array including a section of redundant memory cells to substitute for a section of defective main memory cells, circuitry to read information from the main memory cells and to write information into the main memory cells, the circuitry being responsive to the address of a section of defective main memory cells and arranged to select a section of redundant memory cells, a first redundant decoder that is programmable to receive the address of a section of defective main memory cells and to store the address of said section of defective main memory cells, a second redundant decoder that is programmable to hold the address of the array containing the section of defective main memory cells, redundant enabler circuitry for enabling a section of redundant memory cells in only the memory array containing the section of defective main memory cells, and characterised in that the first redundant decoder generates redundant row or column decode signals and redundant row or column factor enable signals, and that the second redundant decoder receives said redundant row or column decode signals and generates an array select signal, the redundant enabler circuitry being arranged to receive the row or column factor enable signals and the array select signal, the column or row factor enable signals identifying the address of the section of defective main memory cells and the array select signal identifying the array of main memory cell containing the section of defective main memory cells.

Preferably, the first redundant decoder includes: a two-part programmable redundant decoder, programmable to hold the defective section address and programmable to hold information identifying the memory array containing the defective section of memory cells.

The memory device may be a dynamic random access memory, for example.

According to a further aspect of the present invention there is provided a method of replacing defective main memory cells in a semiconductor memory device having a plurality of memory arrays of main memory cells, which method comprising the steps of: reading information from the memory cells and writing information into memory cells, determining the address of a section of defective main memory cells, and selecting a section of redundant memory cells in only the memory array having a section of defective memory cells, programming a first redundant decoder with the address of a section of defective main memory cells, and programming a second redundant decoder with the address of the array containing the section of defective main memory cells, enabling, using redundant enabler circuitry, a section of redundant memory cells in only the array containing the section of defective main memory cells, and characterised in that the method further comprises the steps of:
- said first redundant decoder generating redundant row or column decode signals and redundant row or column factor enable signals;
- said second redundant decoder receiving said redundant row or column decode signals and generating an array select signal; and
- said redundant enabler circuitry receiving the row or column factor enable signals and said array select signal;
the row or column factor enable signal identifying the address of the section of defective main memory cells and the array select signal identifying the array of main memory cells containing the section of defective main memory cells.

As part of this application, an exemplary two-stage redundancy decoding scheme for a semiconductor memory device is disclosed. The redundant row decoder is a two-stage decoder having a first redundant decoder that is programmable to hold the address of a defective row, that receives row addresses, and generates redundant row decode signals and redundant row factor enable signals. The second redundant decoder is programmable to hold the location of the array containing the defective row. It receives the redundant row decode signals and provides array select signals. A third enabler stage that is connected to the redundant rows of memory cells and that is responsive to the redundant row factor enable signals and the array select signals may be added to enable the selected redundant row of memory cells of the memory array containing the defective row of memory cells. The redundant column decoder is programmable to hold the address of a defective column. It receives columns addresses and generates redundant column decode signals and redundant column factor enable signals. The second redundant decoder is programmable to hold the location of the array containing the defective column. It receives the redundant column decode signals and produces array select signals. A third enabler stage that is connected to the redundant columns of memory cells and that is responsible to the redundant column factor enable signals and the array select signals may be added to enable the selected redundant column of memory cells of the memory array containing the defective column of memory cells. The decoding scheme uniquely identifies the section of memory requiring repair, thereby more efficiently using the available redundant memory cells.

Other objects, advantages and features of the invention will become apparent to those of ordinary skill in the art, having reference to the following description of embodiments of the invention which together with the accompanying drawings are provided by way only of example.

In the drawings:
FIG. 1 is a block system level drawing illustrating a 16MB Dynamic Random Access Memory chip incorporating an embodiment of the invention,
FIG. 2 is a top view drawing illustrating the pin designations of the packaged memory chip,
FIG. 3 is a three-dimensional view of the packaged memory chip wherein the encapsulating material is rendered transparent,
FIG. 4 is an assembly view if FIG. 3,
FIG. 5 is a cross-sectional view of FIG. 3,
FIG. 6 is a top view drawing illustrating the bond pad designations of the memory chip,
FIG. 7 is a top view drawing illustrating a portion of the memory array,
FIG. 8 is a cross-sectional view of a portion of the memory array,
FIG. 9 is a side view of the cross-sectional view of FIG. 8,
FIG. 10 illustrates the CL1, or Column Logic Circuit.
FIG. 11 illustrates the RBC, or Ras Before Cas Circuit.
FIG. 12 illustrates the RBC_ RESET Circuit, or the Ras Before Cas Reset Circuit.

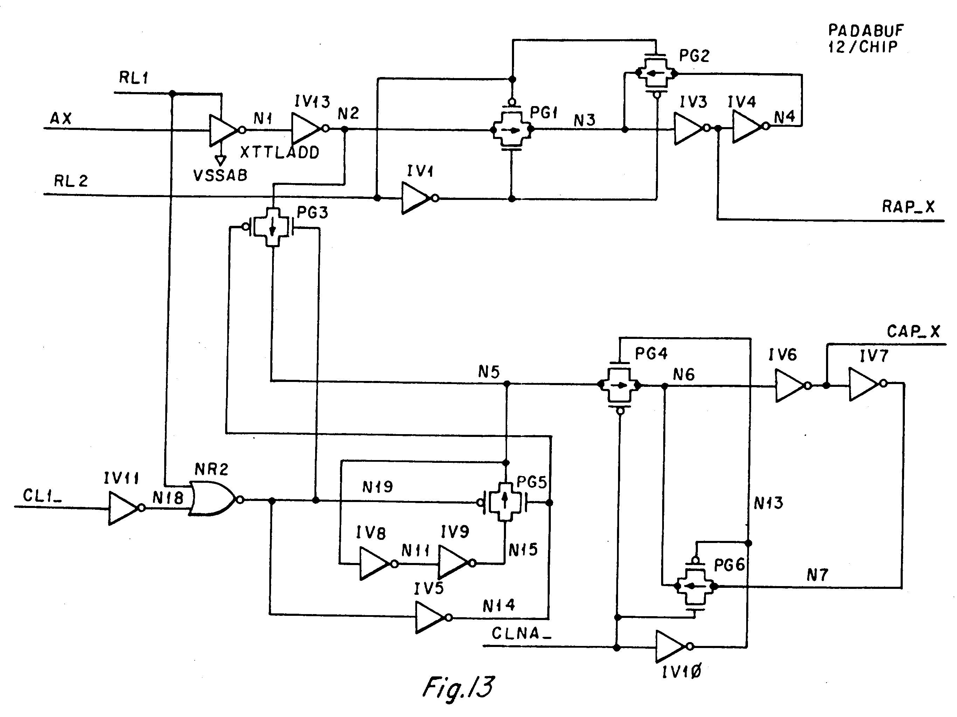

FIG. 13 illustrates the PADABUF Circuit, or the Pad Address Buffer Circuit.
FIG. 14 illustrates the RADR, or Row Address Driver Circuit.
FIG. 15 illustrates the BITCOUNT, or Bit Count Circuit.
FIG. 16 illustrates the RF, of Row Factor Circuit. Code in appendix A1.
FIG. 17 illustrates the RLEN_, or Row Logic Enable Circuit.
FIG. 18 illustrates the RLXH, or Row Logic X (Word) High Circuit.
FIG. 19 illustrates the RDDR, or Row Decoder Driver Circuit. code in Appendix A3.
FIG. 20 illustrates the BNKPC_, or Bank Select Pre-charge Circuit.
FIG. 21 illustrates the XDECM, or Row Decoder Circuit.
FIG. 22 illustrates the RRA, or Row Redundancy Address Circuit.
FIG. 23 illustrates the RRDEC, or Row Redundancy Decoder Circuit.
FIG. 24 illustrates the RRX, or Row Redundancy X Factor Circuit.
FIG. 25 illustrates the RRXE, Row Redundancy X Factor Emulator Circuit.
FIG. 26 illustrates the RRQS, or Row Redundancy Quadrant Select Circuit.
FIG. 27 illustrates the RXDEC, or Redundancy X (Word) Decoder Circuit.
FIG. 28 illustrates the RRDSP circuit, Row Redundancy
FIG. 29 illustrates the RRATST circuit, Row Redundancy Address Test Circuit.
FIG. 30 illustrates the SDXWD, or Sense Clock X-Word Detect Circuit.
FIG. 31 illustrates the SDS1, or Master Sense Clock Circuit.
FIG. 32 illustrates the DSD2, or Sense Clock-2 Circuit.
FIG. 33 illustrates the SDS3, or Sense Clock-3 Circuit.
FIG. 34 illustrates the SDS4, or Sense Clock-4 Circuit.
FIG. 35 illustrates the BNKSL, or Bank Select Circuit. code in Appendix A9.
FIG. 36 illustrates the BSS_DR, or Bank Select Driver Circuit.
FIG. 37 illustrates the LENDBNKSL, or Left End Bank Select Circuit.
FIG. 39 illustrates the 11234, or Sense Clock 1234 Circuit.
FIG. 40 illustrates the PCNC, or P charge and N charge Circuit.
FIG. 41 illustrates the SA, or Sense Amplifier Circuit. Code in Appendix A11.
FIG. 42 illustrates the SA_END, or Sense Amplifier End Circuit.
FIG. 43 illustrates the CABUF01, or Column Address Buffer 01 Circuit.
FIG. 44 illustrates the CABUF29, or Column Address Buffer 29 Circuit.
FIG. 45 illustrates the CLEN, or Column Logic Enable Circuit.
FIG. 46 illustrates the CF07, or Column Factor 0, 7 Circuit. Code in Appendix A13.
FIG. 47 illustrates the CF07DR, or Column Factor 0, 7 Driver Circuit.
FIG. 48 illustrates the CF815, or column factor 8 through 15 Circuit.
FIG. 49 illustrates the YDEC, or Y Decoder Circuit.
FIG. 50 and 54 illustrates the CRDEC, of Column Redundancy Coder Enable Circuit.
FIG. 51 illustrates the CRRA, or Column Redundancy Row Address Circuit. Code in Appendix A35.
FIG. 52 illustrates the CRCA, or Column Redundancy Address Circuit. Code in Appendices A37 and A39.
FIG. 53 illustrates the CREDC_, or Column Redundancy Decoder Circuit.
FIG. 55 illustrates the CRY, or Column Redundancy Y Factor Circuit. Code in Appendix A41.
FIG. 56 illustrates the CRSS, or Column Redundancy Segment Select Circuit.
FIG. 57 illustrates the CRQS, or Column Redundancy Quadrant circuit.
FIG. 58 illustrates the CRYS, or Column Redundancy Y Select Circuit.
FIG. 59 illustrates the CRIOS, or Column Redundancy U Select Circuit.
FIG. 60 illustrates the CRDPC, or Column Delay Redundancy pre-charge Circuit.
FIG. 61 illustrates the CROSP circuit,
FIG. 62 illustrates the CATD, or the Column Address Transition Detector Circuit.
FIG. 63 illustrates the Column Logic Summation Circuit, or CLSUM.
FIG. 64 illustrates the Column Sum Logic Driver Circuit, CLSUMDR.
FIG. 65 illustrates the Quadrant Select Circuit, QDDEC. Code in Appendix A15.
FIG. 66 illustrates the Global Amplifier Select End Circuit, GASEC.
FIG. 67 illustrates the Global Amplifier Select Circuit, GASEL.

APPENDIX A1 depicts the table of Row Factor codes. The Row Factor codes showed the relationship between the RF signals and the RAX, RAW signals. The RFR signals are outputs of the twelve instances of schematic 16.

APPENDIX 2 depicts the Row Decoder Driver codes. The Row Decoder driver circuit shown in schematic 19 is used 32 times in each of the four quadrants of the circuit. The RDDR_CODE table depicted in Appendix A2 explains the relationships between the output signals, RDj0k0 through RDj7k3, to the signals in each quadrant.

APPENDICES 3 and 4 depict the Row Redundancy Address codes in two tables, the first labeled RRA CODE1 and the second labeled RRA_CODE2. Schematic 22 the Row Redundancy Address circuit, is used 120 times in the chip. Tables RRA_CODE1 and RRQA_CODE2, shown in appendix pages A5 and A7 respectively, illustrate how the 120 instances of the RRA circuit are used in the chip to produce 120 output signals labeled RRAO-RRA119.

APPENDIX 5 depicts the Bank Select Codes. The Bank Select Codes illustrate how the 15 instances of the BNKSL circuit, schematic 35, are used to produce 16 unique outputs for each quadrant.

APPENDIX 6 depicts the Sense Amplifier codes. The SA circuit, schematic 41 is used 7,680 times in each quadrant. The SA_CODE table illustrates how these instances of the SA circuit are connected.

APPENDIX 7 depicts the Column Factor Codes. The Column Factor codes illustrate how the 16 Column Factor circuits are issued. There are 8 instances of the column factors schematic CF07, schematic 46, and eight instances of the column factor schematic CF815, schematic 48. The CF_CODE table illustrated in Appendix 7 indicates how these 16 circuits are connected.

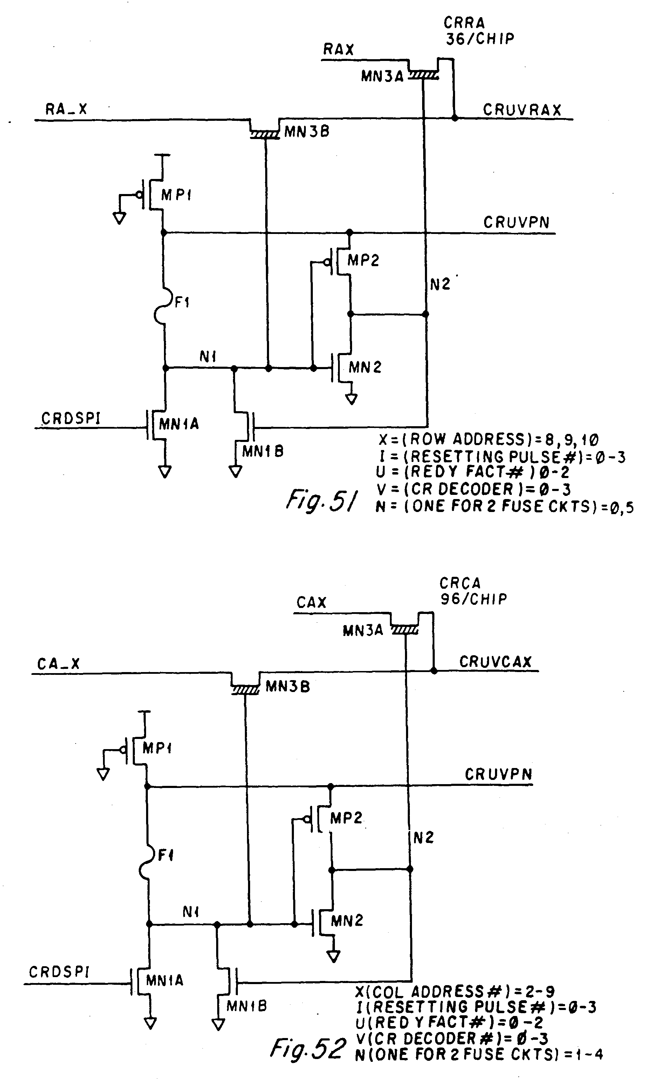

APPENDIX 8 illustrates the Column Redundancy Row Address Code table. The Column Redundancy Row Address Code table is used to depict how the circuit CRRA, illustrated on FIG. 51 is used in the DRAM. The CRRA circuit is used 36 times in the DRAM, and the table CRRA_CODE depicted on Appendix page 8 details how the 36 instances of the circuit are connected.

APPENDICES 9 and 10 depict the CRCA_CODE tables. The Column Redundancy Column Address Circuit, illustrated on FIG. 52 is used 96 times in the DRAM. The tables on Appendix pages 9 and 10 detail how the 96 occurrences of the CRCA circuit are connected.

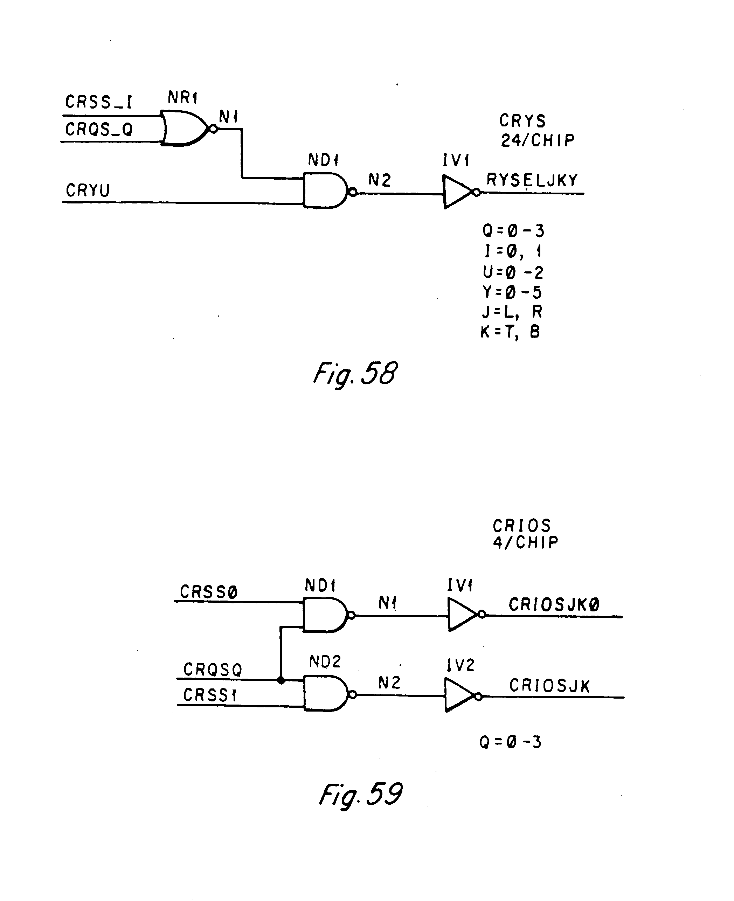

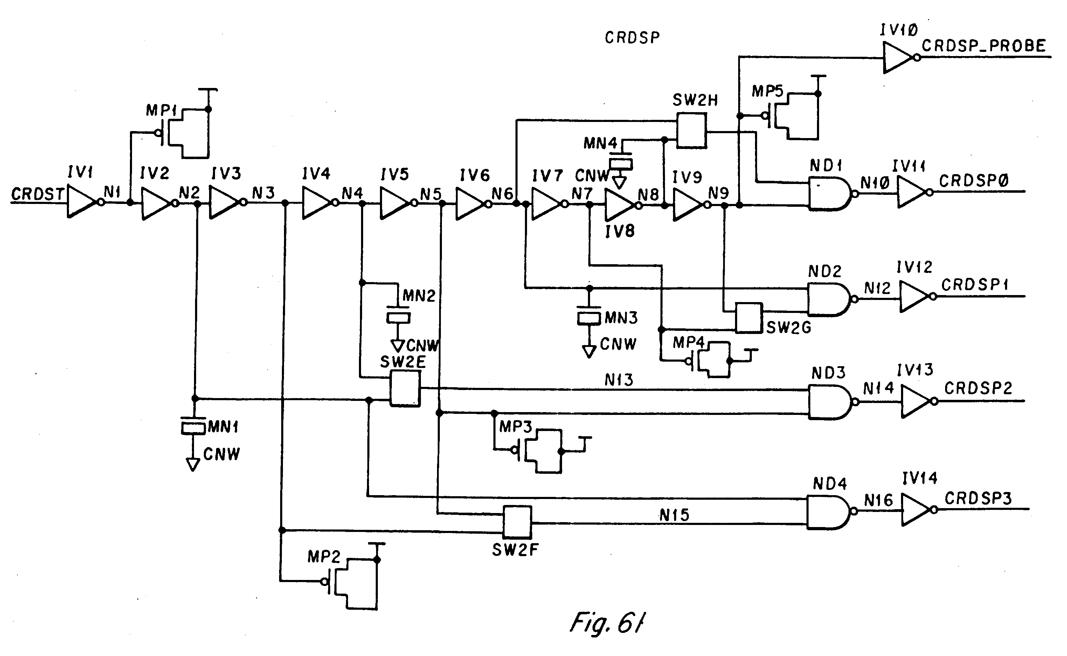

APPENDIX 11 illustrates the CRYS_CODE table. The CRYS circuit, illustrated of FIG. 58 is used 24 times in the DRAM. The CRYS_CODE table depicted on Appendix page A11 details how the 24 occurrences of the CRYS circuit are connected.

APPENDIX 12 depicts the Quadrant Select Codes. The Quadrant Select Codes illustrate the decoding scheme for the selection of the active quadrant. The quadrant select circuit is illustrated in schematic 65. Referring to the QDDEC_CODE table one may determine which of the four quadrants is the currently selected quadrant according to the schematic 65.

APPENDICES 13 and 14 illustrate the codes for the Global Amplifier Select End circuit and the Global Amplifier Select circuit, respectively. The Global Amplifier Select circuits perform a one of eight decode. The codes shown in the appendix pages, in combination with schematic pages 66 and 67, illustrate how the decoding is done.

An exemplary embodiment of the invention and a memory chip including the invention will now be described.

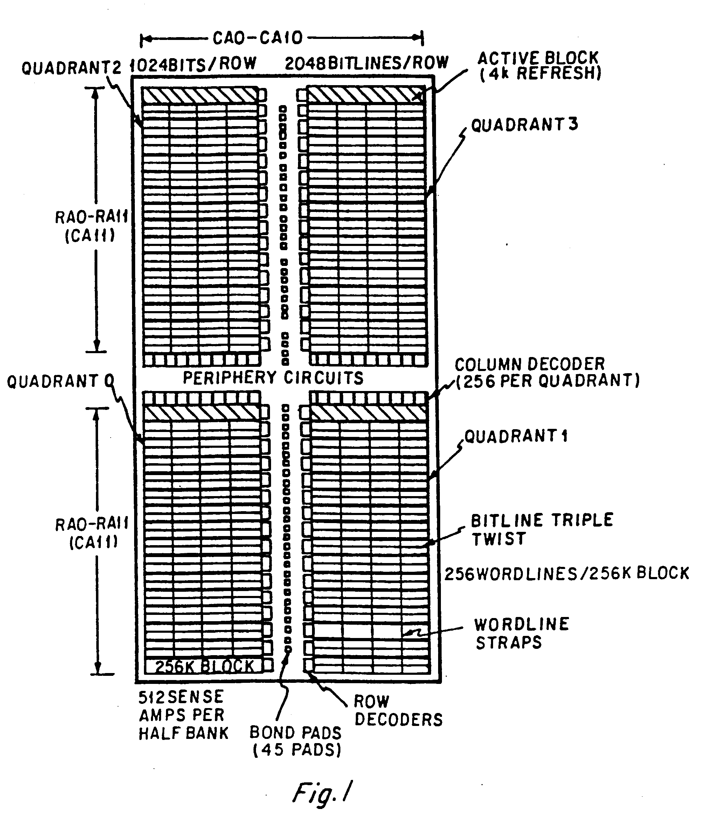

Fig. 1 illustrates a 16MB Dynamic Random Access Memory Chip referred to as a 16MB DRAM. The chip size is about 325 X 660 mm. The chip is partitioned into four memory array quadrants. Each memory array quadrant contains 4 Megabits. A 4MB memory array quadrant contains 16 memory blocks. Each memory block contains 256 Kilobits. The Column Decoders lie along the vertical axis of the chip adjacent to their respective memory array quadrants. The ROW decoders lie along the horizontal axis of the chip, adjacent to their respective memory array quadrants. The periphery circuits containing such devices as the input and output buffers and the timing and control circuits are centrally located along both the horizontal and the vertical axis of the chip. The bond pads are centrally located along the horizontal axis of the chip.

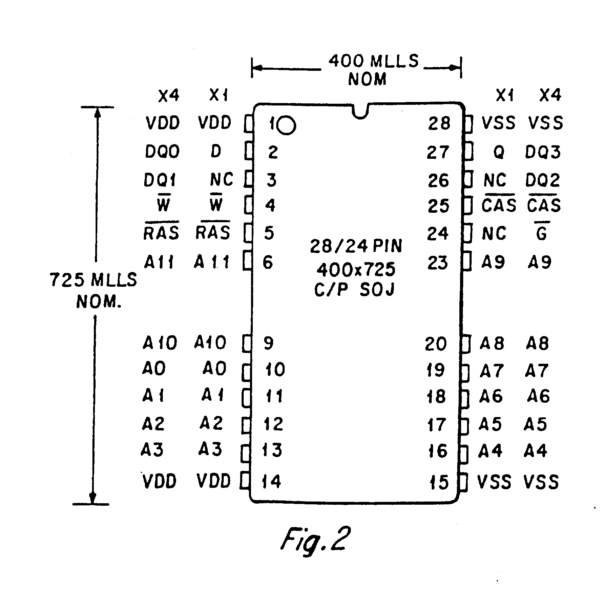

FIG. 2 is a top view drawing illustrating the package/pin out of the device. The chip is center bonded and encapsulated in a thin plastic, small outline J-type package. Among other features, the DRAM is bond programmable as either an X1 or an X4 device. The pin designations for both the X1 and X4 modes of operation are illustrated.

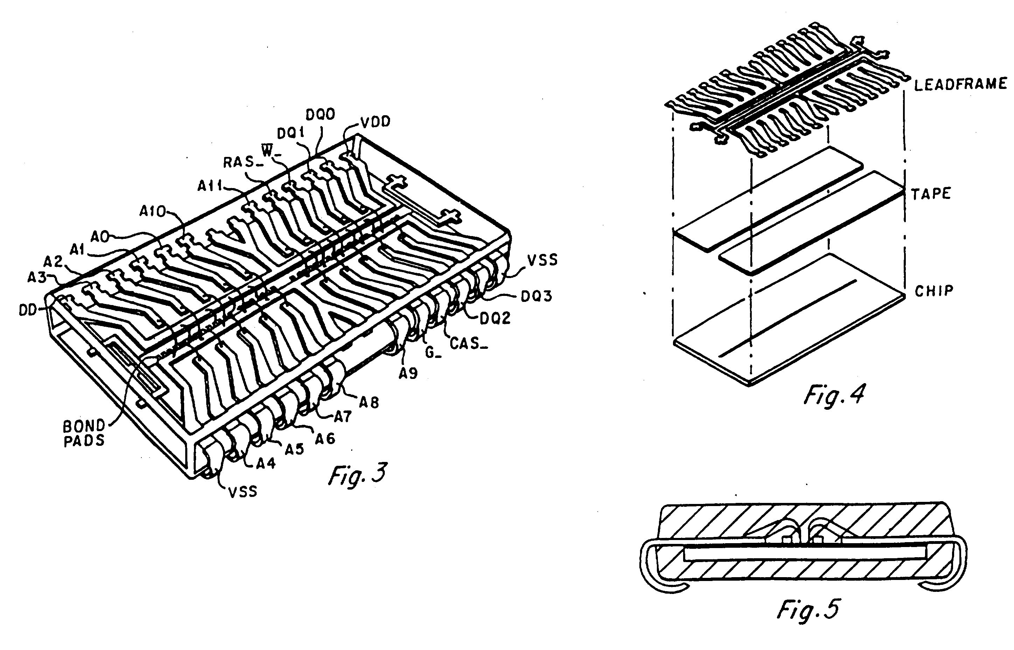

FIG. 3 is a three-dimensional view of the encapsulated chip wherein the encapsulating plastic is rendered transparent. The pin designations shown correspond to the X4 option. The TSOJ package is of the lead over chip with center bond (LOCCB) type. Basically, the chip lies underneath the lead fingers. A polyamide tape attaches the chip to the lead fingers. Gold wires are wire-bonded from the lead fingers to the center bonding pads of the chip.

FIG. 4 is an assembly view of the packaging concept and FIG. 5 is a cross-section view of the packaged device.

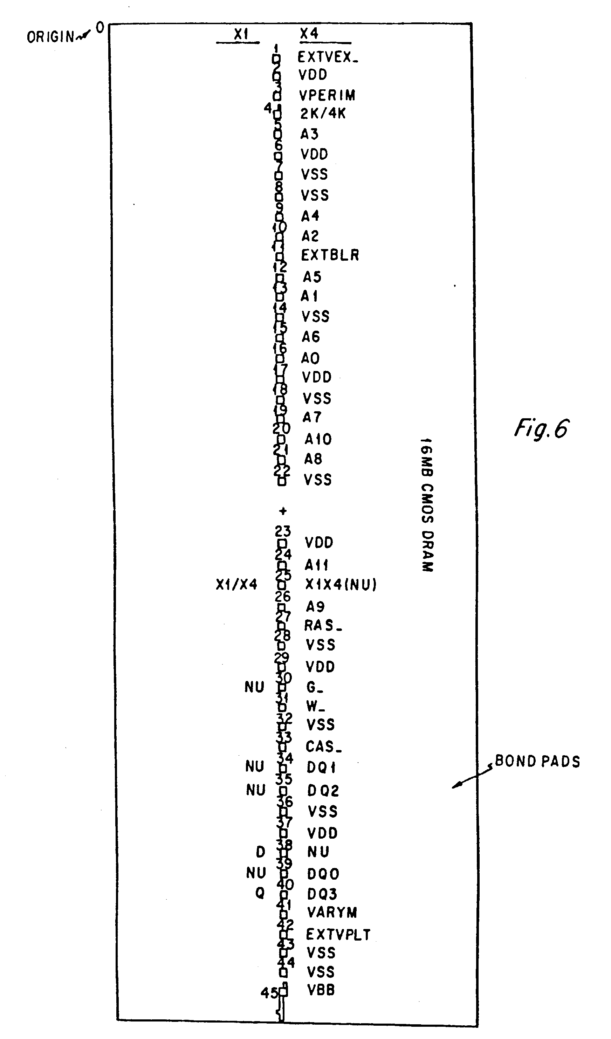

FIG. 6 is a diagram illustrating the names and sequence of the bond pads. The sequence for both the X1 and the X4 options are illustrated. EXT BLR is a pad that is for in-house only. The brackets, such as those for bond pad 4 and 25 indicate that this is a bond pad option.

General characteristics of the 16MB DRAM device of FIG. 1 follow. The device receives external VDD of typically 5 volts. On chip internal voltage regulation powers the memory arrays at 3.3 volts and the periphery circuits at 4.0 volts to reduce power consumption and channel hot carrier effects. The substrate is biased at -2 volts. The organization is bond programmable X1/X4. The X1 or X4 option may be selected during manufacture by putting in place a bond wire between bond pad 25 (FIG. 6) and V_{SS} for a X1 device and omitting the bond wire for a X4 device. The resulting pin outs for the ten options may be seen in FIG. 2. The bond wire may be run between pad 25 and the V_{SS} bus 3 of the lead frame (FIG. 3).

The enhanced page mode is the preferred option, with a metal mask programmable option for a write per bit (data mask) operation.

The preferred option for the refresh scheme is 4096 cycles at 64ms. However, the DRAM is bond programmable for 2048 cycle refresh. Option selection may be achieved in a way analogous to that employed for the X1 or X4 option selection. The relevant bond pad is 4, bonded to V_{SS} for 2K refresh, otherwise the 4K refresh option is exercised.

The DRAM has numerous design-for-test features. Test mode entry 1 is through WCBR with no address key for 16X internal parallel test with mode data compare. Test mode entry 2 is WCBR with over-voltage and address key only thereafter (8 volts on A11). Exit from test mode occurs from any refresh cycle (CBR or RAS only). Test mode entry 1 is the industry standard 16X parallel test. This test is similar to those used on the 1MB and 4MB DRAMS, except that 16 bits are compared simultaneously instead of 8 bits. The valid address keys are A0, A1, A2, and A6. Test mode entry 2 contains numerous tests. There is a 32X parallel test with data compare and a 16X parallel test with data compare. Different hexadecimal addresses are keyed for the different parallel tests. A storage cell stress test and a VDD margin test allows connection of the external VDD to internal VARY and VPERI device supply lines through the P-channel devices. Other tests include a redundancy signature test, a row redundancy roll call test, a column redundancy roll call test, a row transfer test, a word-line leakage detection test, clear concurrent test modes, and a reset to normal mode. The DRAM also contains a test validation method that indicates if it has remained in a test mode.

Although not illustrated in FIG. 1, for clarity, the DRAM contains redundancy features for defect elimination. It has four redundant rows per 256K memory block. All four may be used at one time. There are 3 decoders per redundant row and 11 row addresses per redundant row decoder. It uses fuses for row redundancy with, on-average, 10 fuses blown for a single repair. The row redundancy uses a two stage programmable concept to more efficiently to enable repair. There are 12 redundant columns per quadrant and four decoders per redundant column. There are 8 column addresses and 3 row addresses per decoder. The total fuse count for column repair is about, on average, 10 fuses blown for a single repair. Column redundancy also has a two-stage programmable feature to more efficiently enable repair.

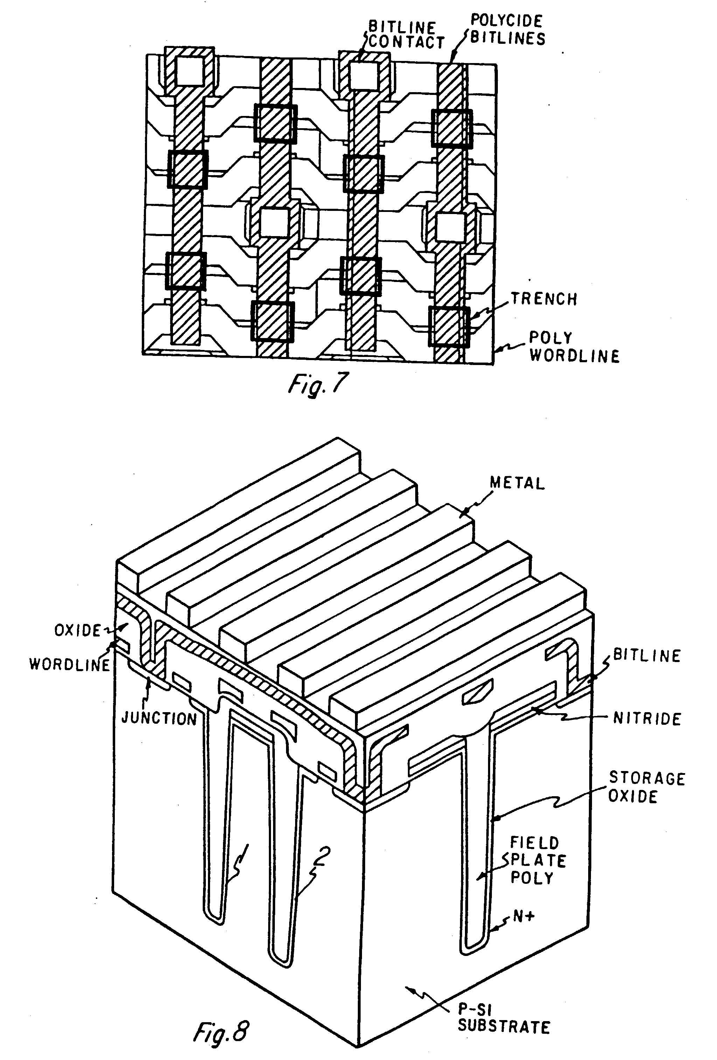

FIG. 7 is a top view of the capacitor cell layout. The bit lines are poly-3 (TiSi₂) polyside. No bitline reference is used and the bitlines are triple twisted for noise immunity. The supply line voltage is about 3.3 volts. The word lines are segmented poly-2. They are strapped every 64 bits with metal 2. The memory cells are of the modified trench capacitor type and may be formed by a process such as disclosed in United States Patent 5,017,506 and European Patent Application 0410288.

Alternative suitable memory cells of the stacked trench-type are disclosed in United States Patent 4,978,634.

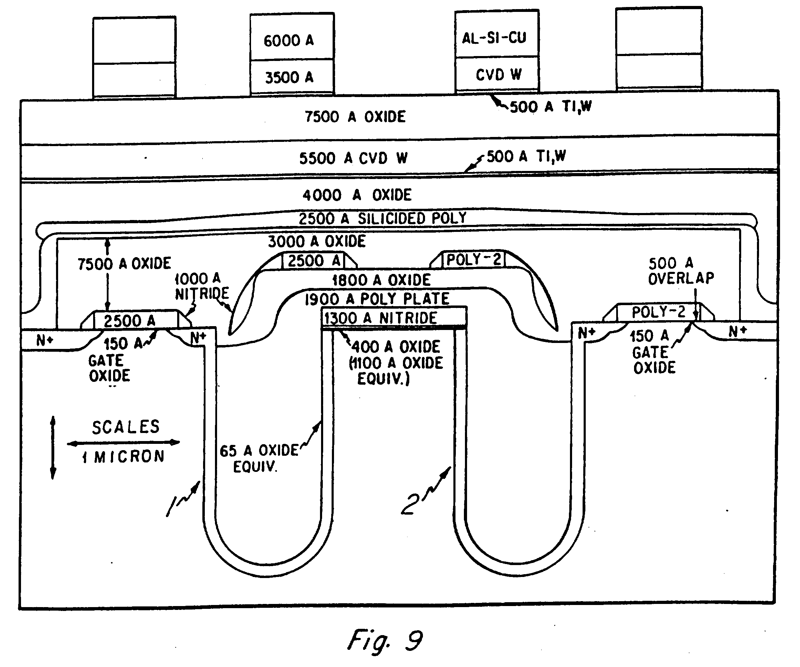

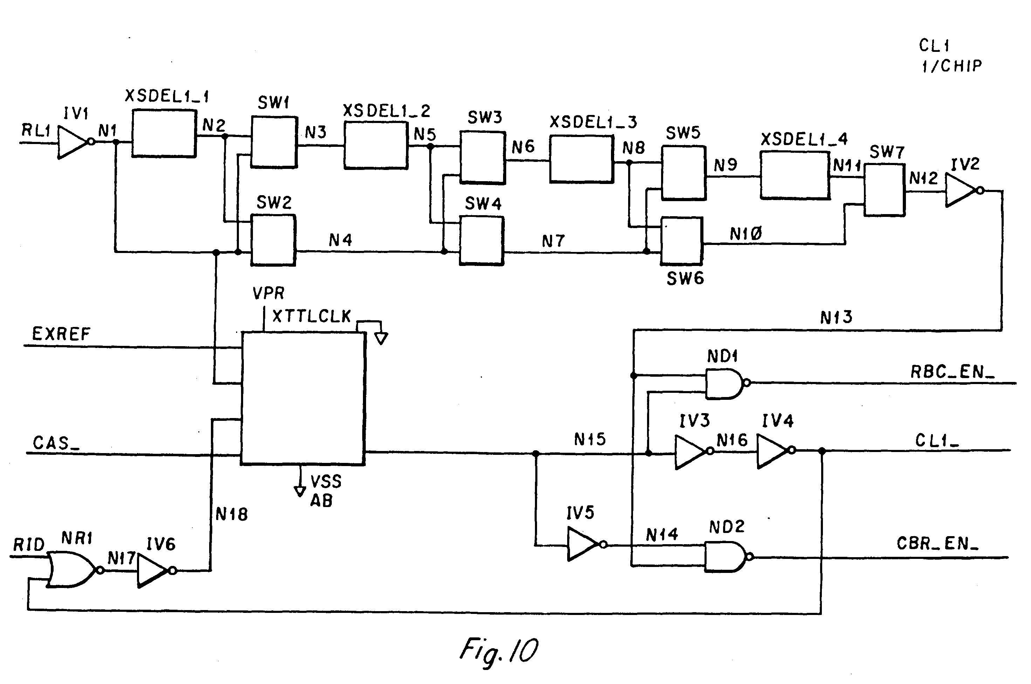

In FIG. 7, the dimensions include a 1.6um bit-line pitch by 3.0um double word line pitch, with a cell size of about 4.8um² obtained through 0.6 micron technology. The trench opening is about 1.1um and the trench depth is about 6.0um. The dielectric is of nitride/oxide, having a thickness of about 65A. Field plate isolation is utilized. The transistors have thin gate oxide. FIG. 8 is a cross-sectional view of the modified trench capacitor cell and FIG. 9 is a side view of the trench capacitor cell. The operation of the embodiment will now be considered in more detail.
- CL1: - COLUMN LOGIC
- schematic FIG. 10

This is a CBR detector. Besides checking for CBR status, it converts the external TTL_CAS signal logic level to CMOS logic levels and generates the internal CAS clock, CL1_.

The first part of the schematic is the TTL to CMOS convertor, XTTLCLK. It is controlled by the internal RAS clock, RL1_. Conversion of signal starts only when RL1 becomes asserted high. The feedback of the internal CAS clock, CL1_ enables the XTTLCLK to stay active even when RL1 changes state from active high to low. This configuration enables the device to operate in the 'EXTENDED CAS' mode, i.e. when CAS_ remains active low after RAS_ goes high. But the feedback loop of CL1_ is gated with the power up signal RID before going into the convertor. This is to avoid unnecessary switching on the convertor during power up.

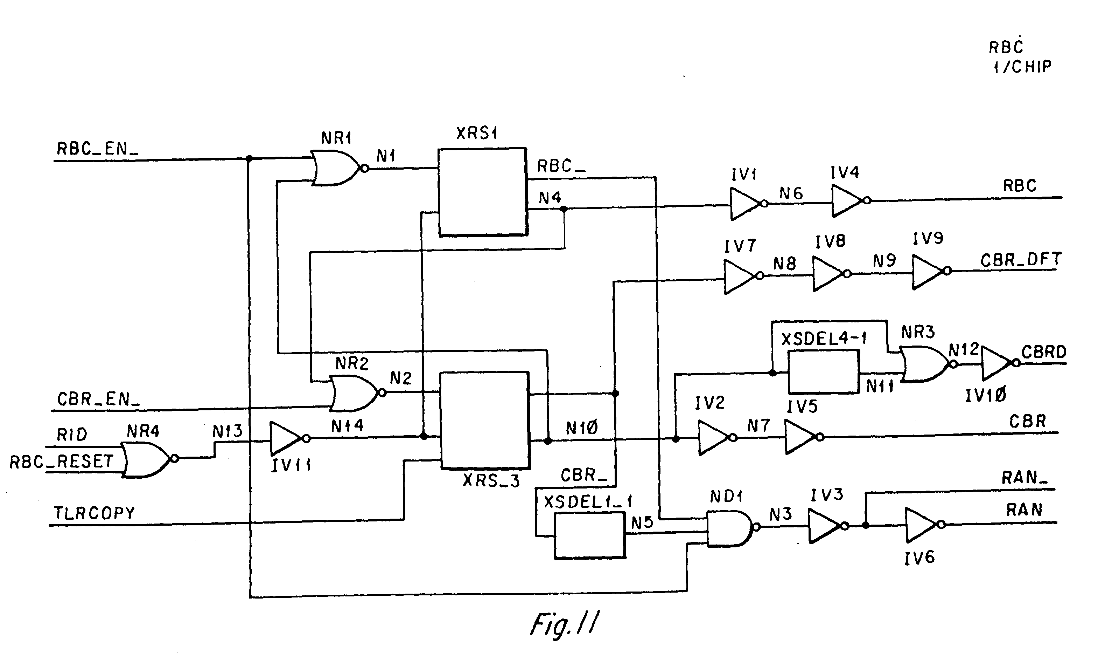

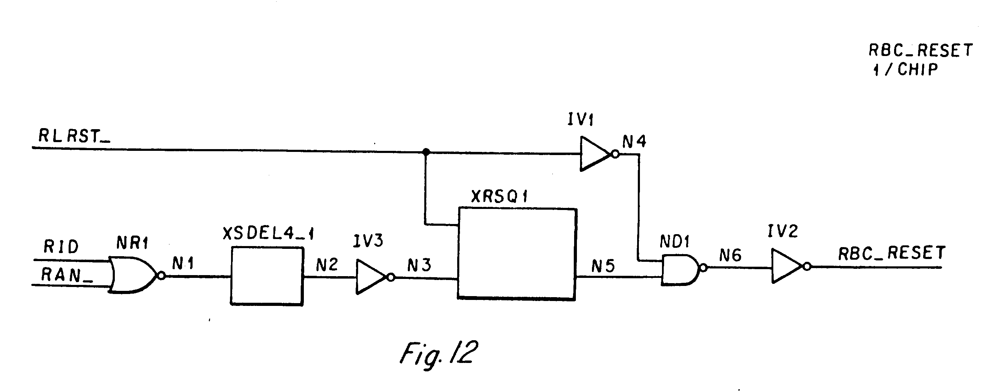

The second part of this schematic does the sampling of the CAS_ signal at the moment when RL1 goes high. If CAS_ is low at that time, meaning CAS_ fell before RAS_, CBR_EN_ goes to active low indicating a CBR cycle. RBC_EN_ remains high. But if CAS_ is high, the reverse logic level will be at the output, indicating a normal RBC cycle. There is no latching done here and the sampling continues as long as RL1 is asserted high. If the CAS_ signal changes state within this cycle, the output CBR_EN_ and RBC_EN_ change along with it. But these subsequent outputs are 'DON'T CARES': a latch of the initial outputs are done in the RBC circuit where a programmable delay is used to control the start of this sampling.
- RBC: - RAS BEFORE CAS
- RBC_RESET: - RAS BEFORE CAS RESET
- schematics FIG. 11 and 12

As discussed in the CL1 schematic, only the initial output of CBR_EN_ and RBC_EN_ reflects the type of cycle the device is operating, either RAS BEFORE CAS, or CAS BEFORE RAS. Hence, the initial output needs to be latched throughout the operating cycle. This latching is done in the RBC circuit. The RBC_RESET circuit resets the latch at the end of a cycle to prepare the device for the next cycle. Besides latching the CBR_EN_ and RBC_EN_, RBC generates the RAN signal for the gating of the row addresses.

Latching of the RBC_EN_ and CBR_EN_ signals is done through 2 interlocking latches, XRS1 & XRS_3. During precharge state, one of the two latches is activated through an active low signal from either RBC_EN_ or CBR_EN_. The activated latch then locks the second latch from being activated. The lock is deactivated at the end of RAS_ active cycle when goes low and a pulse, RBC_RESET is generated to reset the latch and lock (FIG.12). RLRST_ is a precharge signal that is generated at the rising edge of RL1_ after a certain delay.

In normal operation, either the output RBC for RAS BEFORE CAS cycle, or CBR, for CAS BEFORE RAS cycle is asserted high. Although the CBR_DFT signal follows the CBR logic, it is not used in the normal operation. A similar signal, but with delayed falling edge from CBR is generated. This is the CBRD signal. CBRD is used as incremental clock signal for CAS BEFORE RAS internal counter. The falling edge of this signal does the incrementation. Thus, by delaying the internal counter, it provides the device enough time to switch off its ROW ADDRESS BUFFER before changing the internal counter address.

If device is in DFT ROW COPY mode,the XRS_3 latch performs as an inverter for node N2 to output CBR_, and CBR is disabled to a low logic level. This is true as long as both node N2 and RBC_RESET are not at logic high at the same instant. Note that this state will not happen in the sequence of activities. With this setup, RBC will still be latched and locked off the CBR_EN_ signal, but in the CAS BEFORE RAS operation, CBR_EN_ needs to remain active throughout the cycle to have the output CBR_DFT. To achieve this, CAS_ remains low as long as RAS_ is low. Both CBR and CBRD are disabled high in this test mode. They are disabled to avoid the internal CBR counter to be used as row address when a CAS BEFORE RAS cycle is performed in this test mode.

Reset in this test mode is done by RBC_RESET in normal RAS BEFORE CAS cycle at the end of an active cycle. In the CAS BEFORE RAS cycle, at the end of the active cycle, logic high at CBR_EN_ does the reset.

The other part of the circuitry generates the ROW ADDRESS ENABLE signals, RAN & RAN_. These signals are generated through any active cycle. For a typical RBC type cycle, these signals need to be generated as quickly as possible. To accomplish this, the falling edge of RBC_EN_ is used to trigger the transitions on the RAN signals. To keep RAN signal active into the RAS_ precharge period, RBC_ signal is used to hold the RAN signals active. For CAS-BEFORE-RAS operation, it is necessary to delay the execution of the RAN signals to ensure that the address buffers function properly.

In these two circuits, the power up signal RID is used to preset the initial condition of the latches.

The delay stage, XSDEL1_1, delays the assertion of RAN from CBR_ and allows enough time for the CBR internal address to reach the ROW ADDRESS BUFFER before enabling the buffer with RAN. Thus, false data is not driven out of the ROW ADDRESSEE BUFFER. RAN_ is also used to reset RBC_RESET.
- PADABUF: - PAD ADDRESS BUFFER
- schematic FIG. 6.0

PADABUF multiplexes the data from the address pin and latches them as row address RAP_X and column address CAP_X accordingly.

In the first stage of the circuitry, the TTL signal for the address is converted to a CMOS level when the internal RAS signal, RL1_ goes low. The delayed RAS signal, RL2 then latches in the row address. There is also a delay in the delatch of the address by RL2. This is to allow time for device to disable through precharge before address disable. The address RAP_X logic when disabled is always a '1' with RL1_ inactive high.

At the mean time, CLNA_ is asserted low to allow the address to propagate as CAP_X, thus enabling the availability of column address even before CL1_ goes low. This enables the device to operate in 'ENHANCE PAGE MODE'. AS CL1_ goes low, it latches the column address at CAP_X.

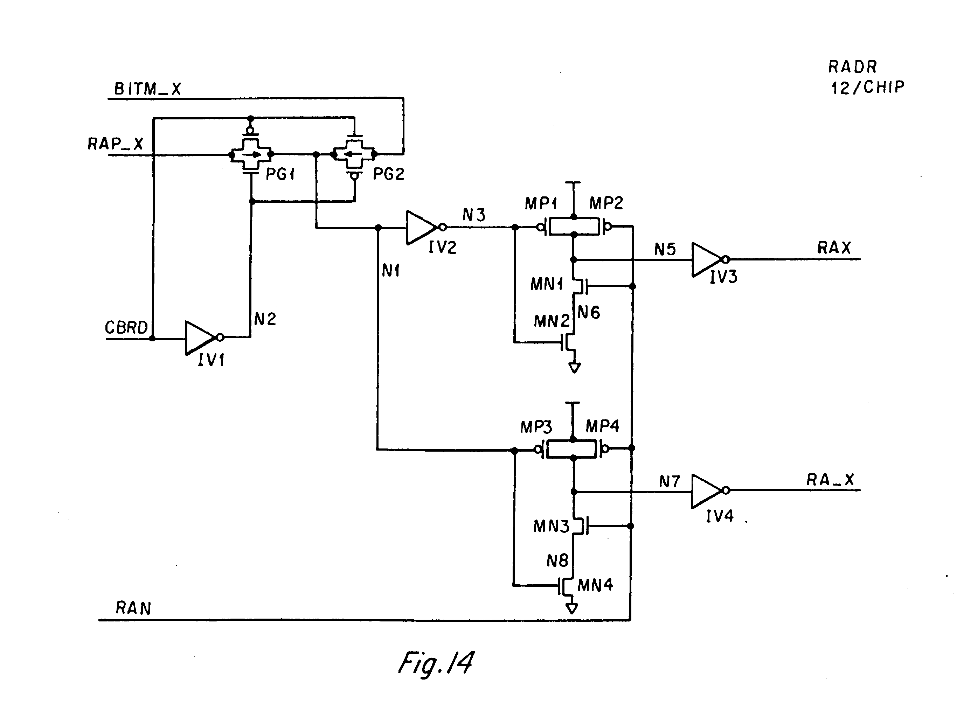

Lastly, during the precharge cycle when RL1_ goes high, the XTTLADD converter, is inhibited and thus not influenced by externally changing addresses. However, the output CAP_X is maintained.
- RADR: - ROW ADDRESS DRIVER
- schematic FIG. 14

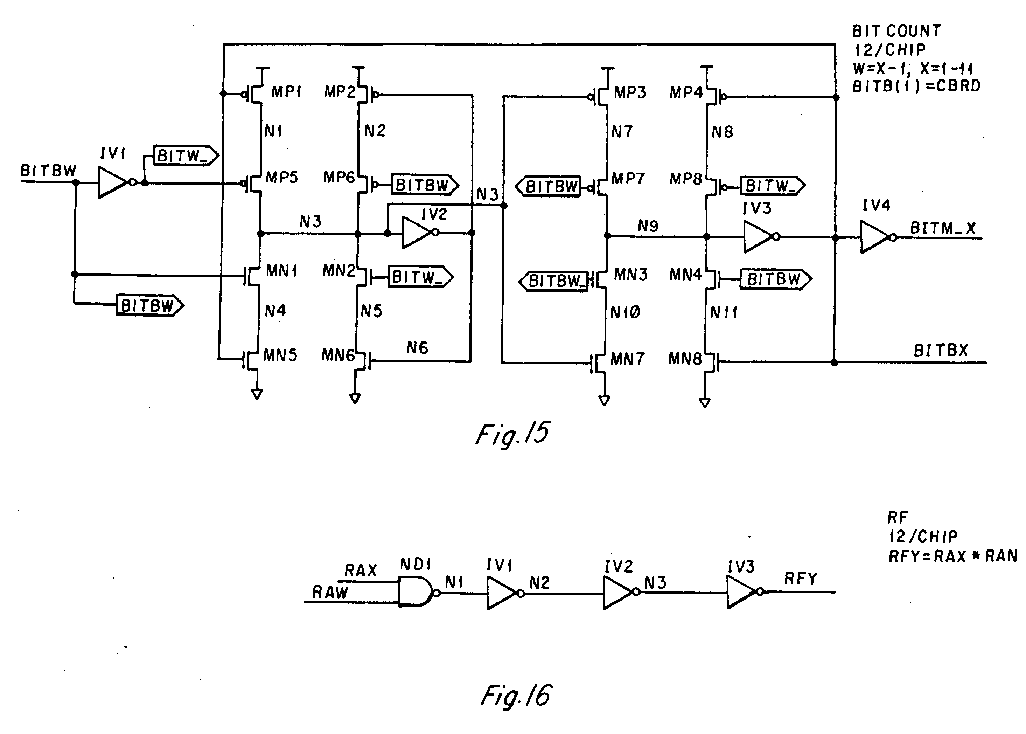

This is driver for the row address. Control signal, RAN starts the driving of the address signal. Besides being just a driver, it multiplexes the external latched row address and the CBR internal counter address before the driving.
- BITCOUNT: - CBR INTERNAL ADDRESS, BITCOUNT
- schematic FIG. 15

There are 12 sets of this circuit connected in series in the device. It serves as a 12 bit internal address used during a CBR cycle. The circuit is a flip-flop that activates on the falling edge of its input signal.

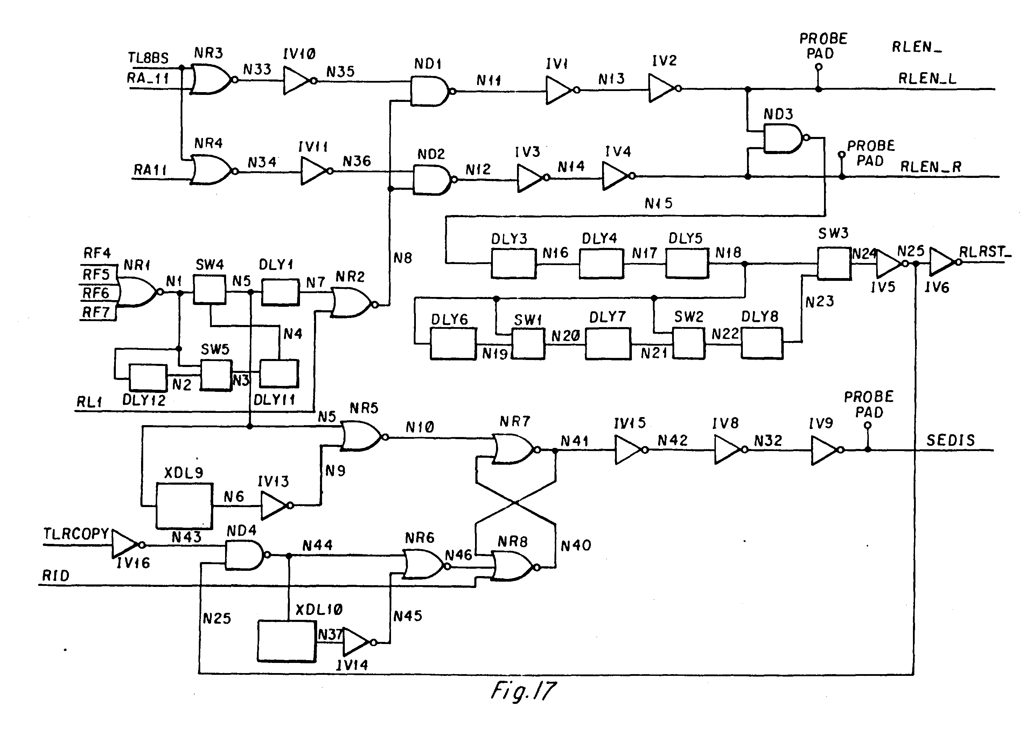

For the lowest significant set, the input is the CRBD signal and the output is the LSB of the CBR row address and it is also the input to the next set of BITCOUNT circuit. This continues in series until it makes 12 CBR address lines. Such a circuit does an incremental binary count based on the pulse on CBRD.
- RF & RF CODE: - ROW FACTOR
- schematic FIG. 16 and APPENDIX A1__

The row factors encode the row addresses into a form which is better utilized by later row circuits. ROW addresses 2 through 7, and their complements, are encoded through an 'AND' operation to generate 12 row factors.
- RLEN_: - ROW LOGIC ENABLE
- schematic FIG. 17

The purpose of the RLEN_ signal is to time the rising edge of RLXH, i.e. the MASTER WORDLINE DRIVER, with respect to the row factors. Besides this, RLEN_ circuit generates signal RLRST_ to signal for precharge, and SEDIS to signal for BL to BL_ equalization process.

RLEN_ is sometimes referred to as the ROW FACTOR DETECTOR. It uses row factors RF4 through RF7 to detect the completion of row factors encoding. Sensing the completion of the encoding, it enables 'NAND' gates ND1 and ND2 to propagate the address RA11 and RA.11 for the generation of RLEN_R and RLEN_L respectively. These are signals to activate the MASTER WORDLINE DRIVERS, RLXH_R or RLXH_L. Only one of the two drivers is active in a quadrant during normal operation. However, in DFT mode, which needs to access all eight octants of the array at the same time, TL8BS will be in active high. This causes both RLEN_R and RLEN_L to be active at the same. Thus, both MASTER WORDLINE DRIVERS, RLXH_R and RLXH_L are active.

Upon completion of row factor encoding, the RLRST_ state resets from logic low to high. On the other hand, at the end of an active cycle, rising edge of RL1_ causes RLRST_ high logic to go low after a programmable delay. Thus it signals the start of another precharge cycle.

The last component of the circuit is the SENSING EQUALIZATION DISABLE, SEDIS. As in RLRST_, it is used to signal the stop and start of the BL to BL_ equalization process. But it only uses the row factor encoding to trigger the stop of BL and BL_ equalization process. Here, this process is stop 4ns after the completion of row factors encoding. Then as RLRST_ goes active low to start the precharge cycle, it resets the SEDIS signal to logic '0' with a delay of 4ns. Thus, it enables the equalization process to start.

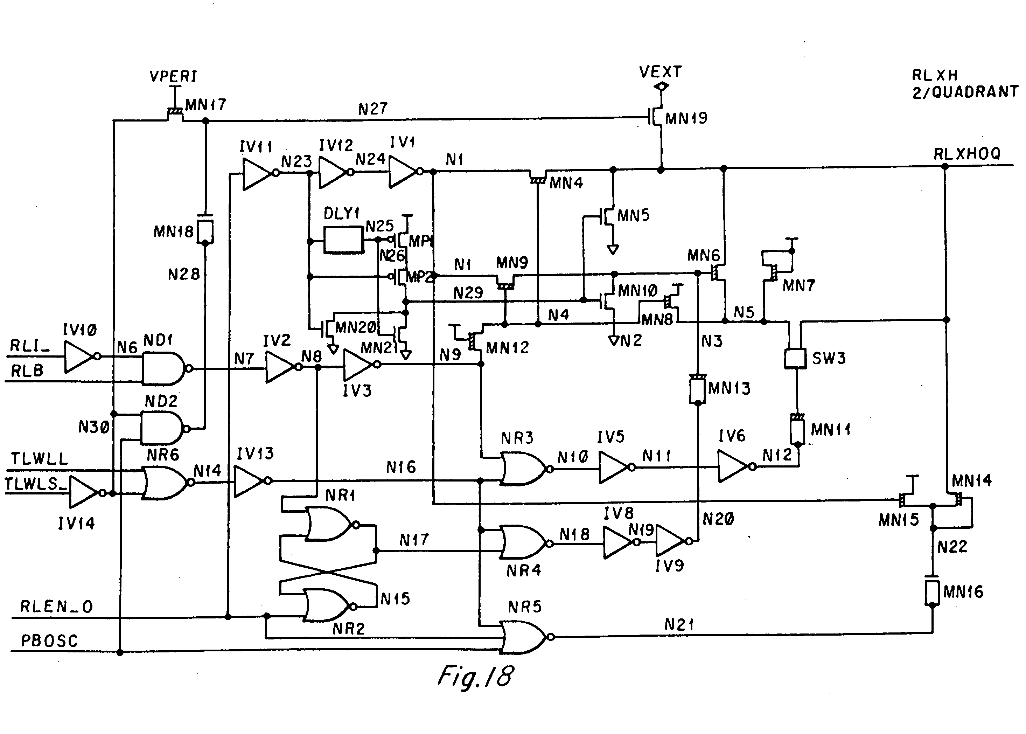

If the device is in the ROW COPY DFT mode, in the first cycle SEDIS changes state from logic low to high as in any normal cycle. But when the active cycle completes, RLRST_ goes low, SEDIS remains inhibited high throughout the inactive cycle and following cycles. This is due to the active TLRCOPY which disables the reset signal from RLRST_. Without the equalization process, the voltages of the BL and BL_ remain split, thus enabling the data on the BL or BL_ to be dumped into another row in the DFT row copy operation
- RLXH: - ROW LOGIC X(word) HIGH
- schematic FIG. 18

The output RLXH is the row logic's booted line which drives the wordlines and the redundancy wordlines. RLXH is also called the MASTER WORDLINE DRIVERS.

The circuit performs as follows:
A. AT PRECHARGE
   - node N4 idles at (Vperi - Vt) through the inactive logic of RL1_ and RLB.
   - Booting capacitor, MN11 charges to (Vperi - Vt) through MN7 and MN8.
   - Node N3 of capacitor MN13 pulled to ground level.
   - Wordline driver RLXH pulled low through transistor MN5 as RLEN_O is at logic high.
B. START OF AN ACTIVE CYCLE, RL1_ goes low
   - enables 'NAND' gate ND1 to prepare circuitry to respond to RLB, ROW LOGIC BOOT signal.
C. COMPLETION OF FACTORS ENCODING, RLEN_O goes active low
   - Node N4 is booted up to (Vperi + Vperi 1 Vt) through the high stray capacitance in N-channel transistor MN4 from node N1 to N4. N1 goes from logic low to high as RLEN_O goes to low logic.
   - With N4 booted up, node N5 of capacitor MN11 charges to full Vperi.
   - Node N3 of capacitor MN13 charges to Vperi through MN9.
   - Wordline driver goes to Vperi as does node N1 with transistor MN6 and MN4 turn on. MN5 and MN10 switch off.
D. START OF DRIVER BOOTING, RLB goes active high
   - Transistor MN4 shuts off, isolating the RLXH from node N1, thus protecting the CMOS device at node N1 when RLXH is booted up fully. MN9 also shuts off for the booting of node N3.
   - Node N12 goes to logic 1, as RLB turns active. This boots node N5 to (Vperi + Vperi - Vt). Node N3 is being booted at the same time with node N20 going to logic 1.
   - Booted node N3 caused full transfer of booted voltage at capacitor MN11 to the wordline driver, RLXH. Thus, wordline driver is booted and drives the addressed row.
E. END ACTIVE CYCLE, RL1_ and RLEN_ become inactive (logic high level)
   - Booted signals discharged through MN10 and MN5.
   - Sets nodes back to precharge state, as in point (A.).

Besides the normal operation as in point (A.) through (E.), signal PBOSC from an oscillator is activated during a LONG RAS cycle. This is to compensate for the leakage at the wordline by constantly booting RLHX through capacitor MN16.

In the two DFT modes, WORDLINE STRESS and WORDLINE LEAKAGE, the booting of the wordline driver is being disabled through 'NOR' gates NR3 and NR4. Transistor MN19 is turned on in the WORDLINE STRESS mode. Thus, with the booting disabled, it allows external voltage to be applied to the driver.

As for WORDLINE LEAKAGE mode, booting is disabled, so that the leakage test will just be a test on the wordline leakage and not the booting capacitor. Only disadvantage here is that it will not be a true check on the leakage, i.e. without the high voltage wordline. Wordline is at (Vperi - Vt) level.

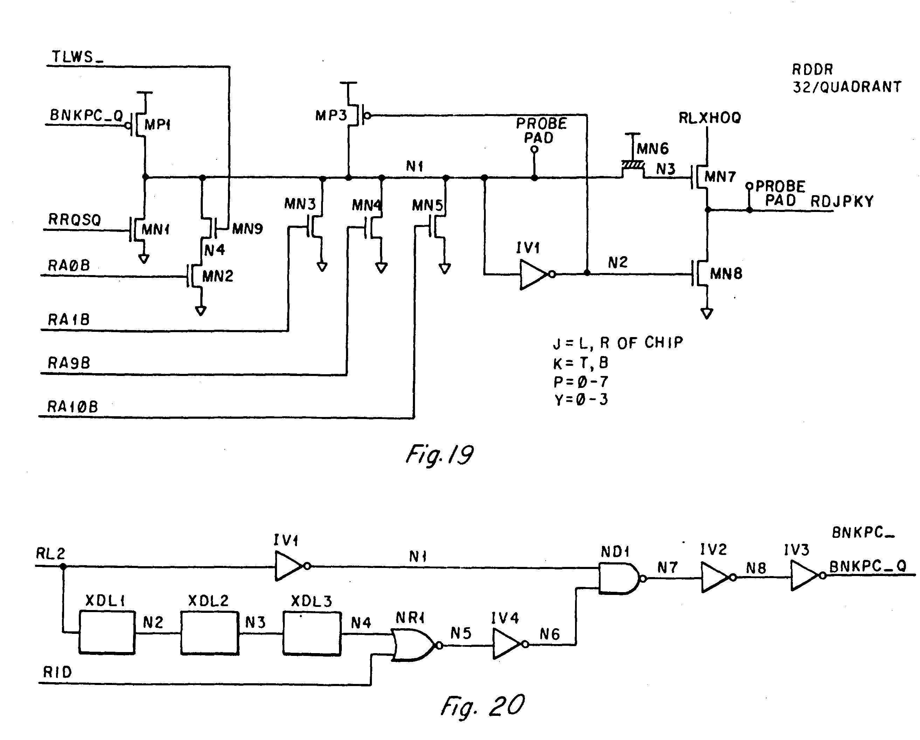

Oscillating signal from PBOSC is also disabled through 'NOR' gate NR5 during either one of these two DFT modes. This avoids recharging of word line through another source.
- RDDR: - ROW DECODER DRIVER
- schematic FIG. 19 CODE APPENDIX A3.

RDDR is the row predecoder of the device. It is used for initial address decoding. Each predecoder gates the RLXH signal and selects one of every four rows for two 256k array blocks in every quandrant.

The predecoder scheme is composed of a 5 input 'NOR' gate. Inputs used for predecoding are RA0, RA1, RA9 & RA10. The last input is the RRQSQ, which is used to disable the predecoder if that row is a programmed redundancy. At precharge, BNKPC_Q is used to charge the node N3. Inverter IV1 and transistor MP3 are used to sustain the high level at node N3 when selected, letting RLXH be driven to the word line decoder.

But if the device is operating in DFT WORDLINE STRESS mode, active low TLWLS_ signal disables the address decoding based on RA0. By doing so, it enables two adjacent rows to be selected.
- BNKPC_: - BANK SELECT PRECHARGE CLOCK GENERATOR
- schematic FIG. 20

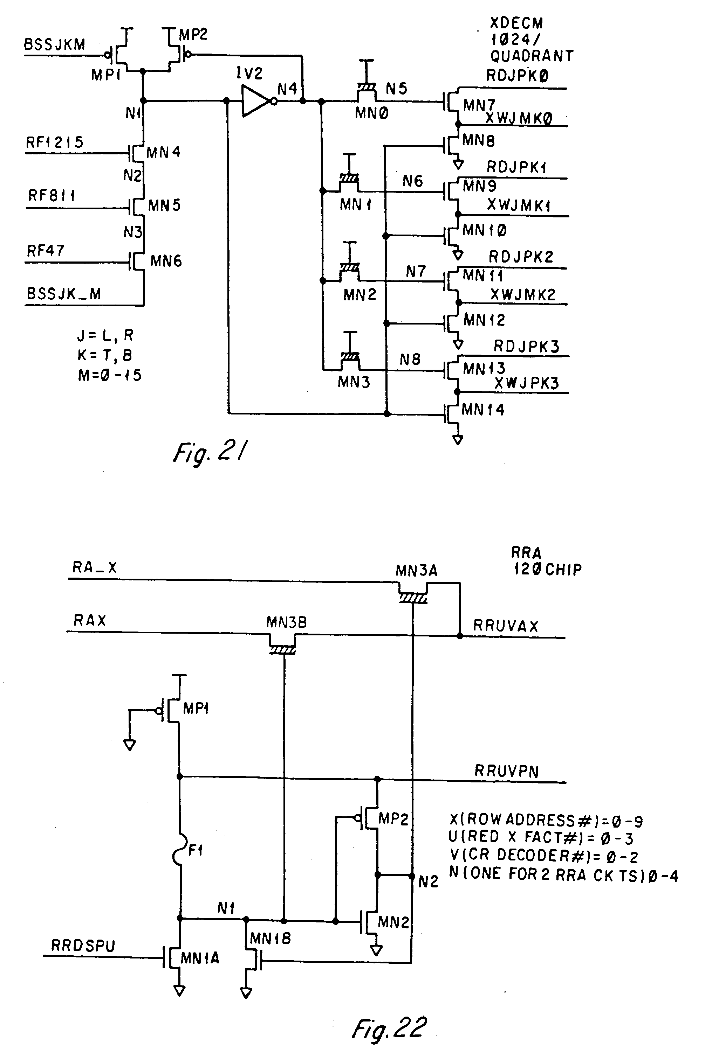

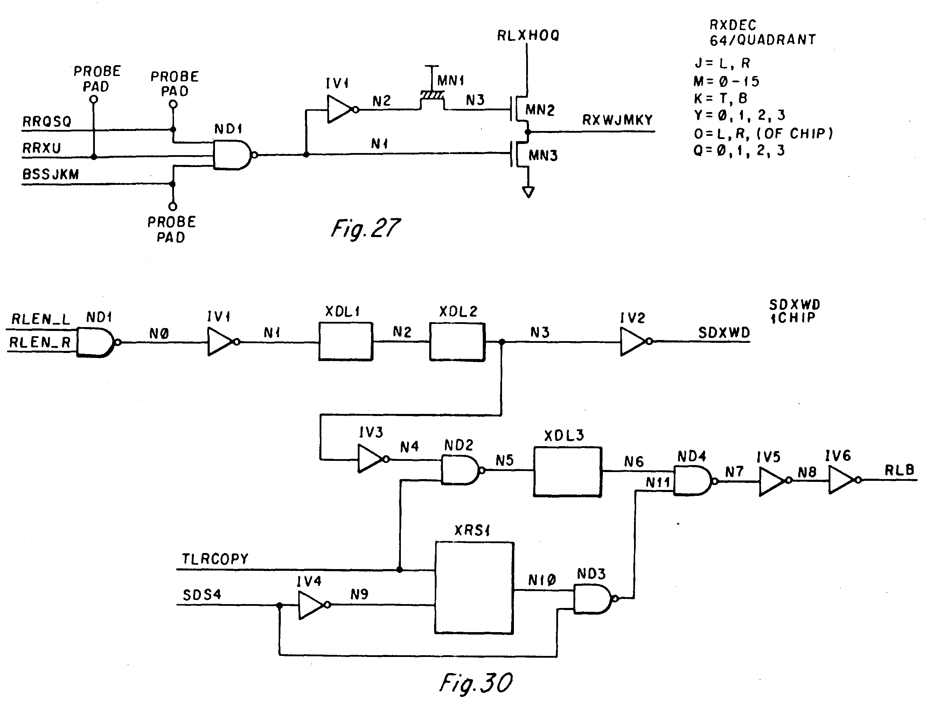

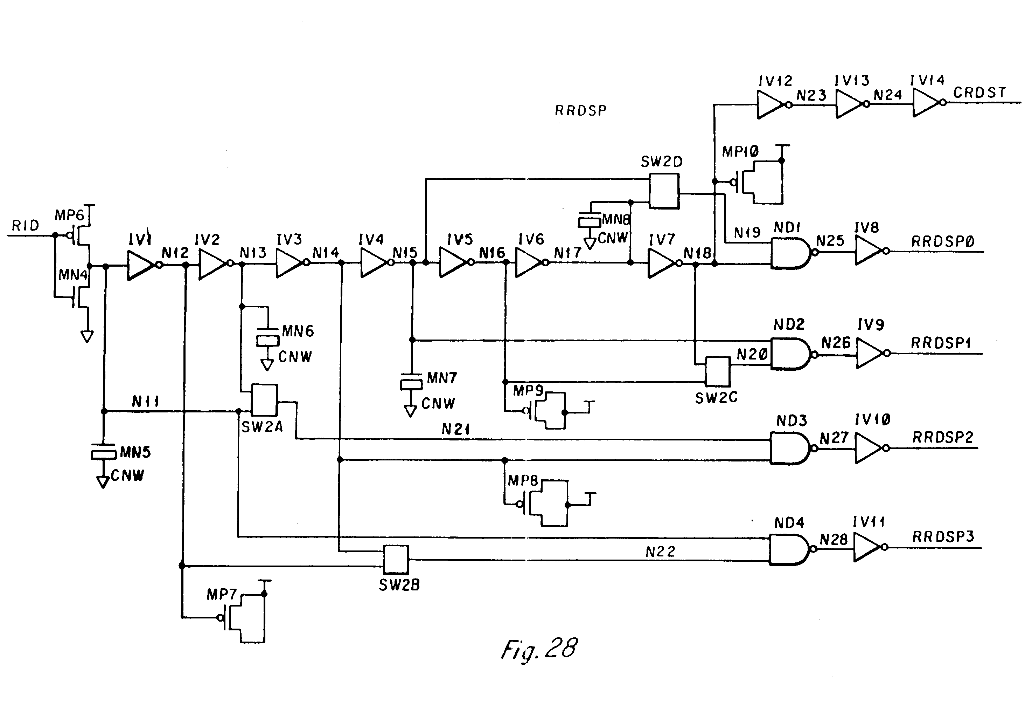

BNKPC_ is the BANK SELECT PRECHARGE CLOCK GENERATOR CIRCUIT. It is clocked off the reset pulse RID and RLT2. Its output signal, BNKPC_Q, activates the precharge decoders of the row decoder driver, RDDR, the bank select circuit BNKSL, and the left end bank select circuit and the right end bank select circuit, FIGs. 27 & 28.
- XDECM: - ROW DECODER
- schematic FIG. 21

The purpose of the row decoding is to do the final decoding of the address, thus allowing the only correct wordline to be selected.

Row decoder uses a three input 'NAND' gate. The inputs are the row factors, RF47, RF811 and RF1216. This does the selection of 1 of 64 sets of rows in every block of 256k array. The source of the 'NAND' gates transistor is connected to the block selects signal, BSSJK_M. BSSJK_M is decoded from RA8 through RA11. With this setup, only one of two active 256K array blocks with a set of four word lines is selected. The set of 4 word lines are XWJMK0, XWJMK1, XWMJK2 and XWJMK3. Note that, only one of these is active as it has already predecoded in RDDR circuit.

Signal BSSJKM is used to precharge N1 to a '1' whereas the inverter IV2 and transistor MP2 are used to sustain the signal when selected.

### ROW REDUNDANCY SCHEME OVERVIEW

The purpose of the row redundancy is to allow faulty wordlines to be replaced in order to repair the die to a sellable status.

There are 16 blocks of 256K array in a quadrant of 16meg. Each of these blocks has four physical redundant wordlines. All four redundancy rows are located on the right side of a 256K array block. Each of these redundant wordlines is capable of replacing any of the faulty rows within the same block. Note that there is no dummy wordline to limit the type of row replaceable by a redundant row, i.e. BL or BL_ rows.

In programming the redundancy, a quadrant is divided into two octants of eight blocks each. Any redundant row programmed in a block of an octant, a similar redundancy needs to be programmed into the image block of the other octant. This scheme is adopted due to the following reasons;
A. Circuit Minimization
   In various special operating modes such as DFT X32 parallel, and Row Copy, where an array block is operating in two octants, a complicated decoding scheme is needed to identify the octant with the redundant row and the one without. To avoid this, both octants are programmed to be symmetrical, thus the extra decoding scheme can be omitted.
B. Higher Access Speed
   By not decoding the RA11 address line, the access time of the redundant row is much faster.

There are 12 row redundancy decoders, RRDEC in a device. This allows for a total of 12 logical wordlines to be replaced in a die. Each logical row redundant line is comprised of a pair of physical rows in a quadrant, one in each octant. But note that the maximum replaceable rows in a 256K array block is only four rows, as there are only four physical redundant rows in each 256K array block.

Note that a total of 12 repairs can be made over the entire device, and there is no restriction on the location of the repairs. For example, all of the repairs could be made in one quadrant.
- RRA: - ROW REDUNDANCY ADDRESS
- schematic FIG. 22 Appendix A3 and A4

RRA generates the redundancy address for the redundancy decoders. In a device there are 120 RRA circuits. They are divided in 12 groups of 10 RRA circuits each. Row address RA0/RA_0 through RA9/RA_9 are used as inputs to each of these groups. Each group represents a logical redundant row address.

For redundancy programming, the fuse, F1 is blown if the address line is required to be a logic '1' to select the redundant row. Else, F1 is left intact. During an active cycle, this fuse programming causes the RRA output, RRUVAX, to be a logic '0' if the input address during the active cycle matches the redundant address. If the input address does not match the redundant address, RRUVAX gives a logic '1' output.

The way the circuit works is as follows:
- at power up, the RRDSPU input pulse signal is asserted high.
- the pulse latches in the redundant address, i.e.

| | BLOWN FUSE | | INTACT FUSE | |
|---|---|---|---|---|
| PROGRAMMED RED ADDRESS | 1 | | 0 | |
| OUTPUT, (RRUVAX) | RA_X | - NODE N1. | RAX, | - NODE N1 REMAINS HIGH. |
| | | - DISCHARGED. | | - MN3A OFF. |
| | | - MN3A ON. | | - MN3B ON. |
| | | - MN3A OFF. | | |
| | note; | - RA_X = 0 if input addr is '1'. (selected) - RA_X = 1 if input addr is '0'. (not selected) | note; | - RAX = 1 if input addr is '0' (not selected) - RAX = 0 if input addr is '1'. (selected) |

For example, lets take the row A72H to be programmed as a redundant row. Here a set of 10 RRA circuits use the addresses RA0/RA0_ through RA9/RA9 for programming.

### REDUNDANT PROGRAMMING

| RRA CIRCUIT WITH INPUTS | FUSE PROGRAMME | RED. ROW (binary) |
|---|---|---|
| RA9 & RA9_ | BLOWN | 1 |
| RA8 & RA8_ | INTACT | 0 |
| RA7 & RA7_ | INTACT | 0 |
| RA6 & RA6_ | BLOWN | 1 |
| RA5 & RA5_ | BLOWN | 1 |
| RA4 & RA4_ | BLOWN | 1 |
| RA3 & RA3_ | INTACT | 0 |
| RA2 & RA2_ | INTACT | 0 |
| RA1 & RA1_ | BLOWN | 1 |
| RA0 & RA0_ | INTACT | 0 |

Note that address RA11 & RA10 have not been used here. RAll is ignored since the selection of an octant in each quadrant is not needed. The RA10 is decoded in the RRDEC circuit.

Lastly, we have the node RRUVPN. This node serves as the power line for the inverter with MP2 and MN2. This is to prevent the voltage on N1 from going too low during power up if the fuse is left intact. If this occurred, MP1 might have difficulty in pulling up N1 since MP1 is mainly a current limiter.

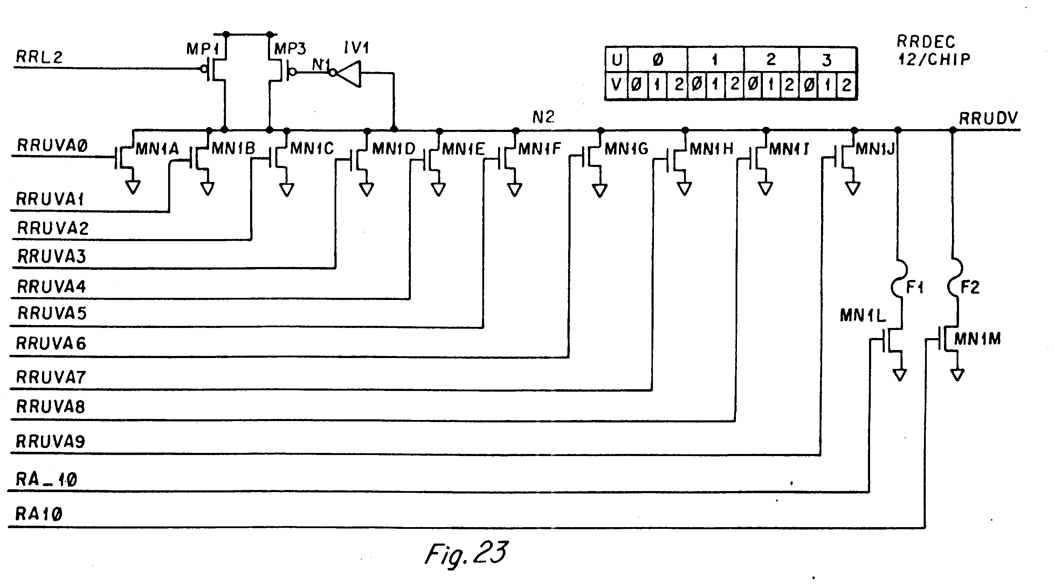

Due to layout constraints, two RRA circuits share the transistor MP1, of the size (w/l = 20/0.8); whereas in the schematic the size of MP1 is (w/l = 10/0.8). Thus RRUVPN is just a common node between two RRA circuits.
- RRDEC: - ROW REDUNDANCY DECODER
- schematic FIG. 23

This circuit decodes the redundancy addresses generated by the RRA circuits. A set of 10 RRA outputs forms the inputs of the 'NOR' structure decoder. The 10 RRA outputs are generated from row addresses RA0/RA0_ through RA9/RA9_. Besides this, RA10 and RA10_ are also connected as 'NOR' inputs through two fuses. The fuses serve as a circuit enable switch. At least one of them has to be blown to activate the circuit. If the programmed redundant RA10 is to be a logic '1', the fuse connected to the input RA10 is to be blown. Else, the other fuse is blown if it is to be programmed logic '0'. But if neither one of these fuses are blown, RRDEC stays inactive low during any active cycle. However, if both fuses are blown, it enables the device to ignore address R10/R10_ and selects two rows in an octant simultaneously.

During precharge, the output is precharged high with RRL2 switching 'on' the transistor MP1. All the inputs are in inactive low logic thus avoiding high current flow.

In an active cycle, when the addresses RA0 through RA10 match the programmed redundancy address, the output stays high signaling the selection of a redundant row has been detected.

Unlike the typical redundancy decoding scheme, where a single stage 'NOR' decoder is used,this uses a two-staged decoding system. RRA is a predecoder and RRDEC is used for the final decoding.

The advantages of this scheme are:
- Reduces the number of fuses needed on the chip. Conventional methods have both the true and complement address going into the decoder. Each of these needs a fuse.
- Speeds up the decoding, with less capacitance on the decoding node N2.

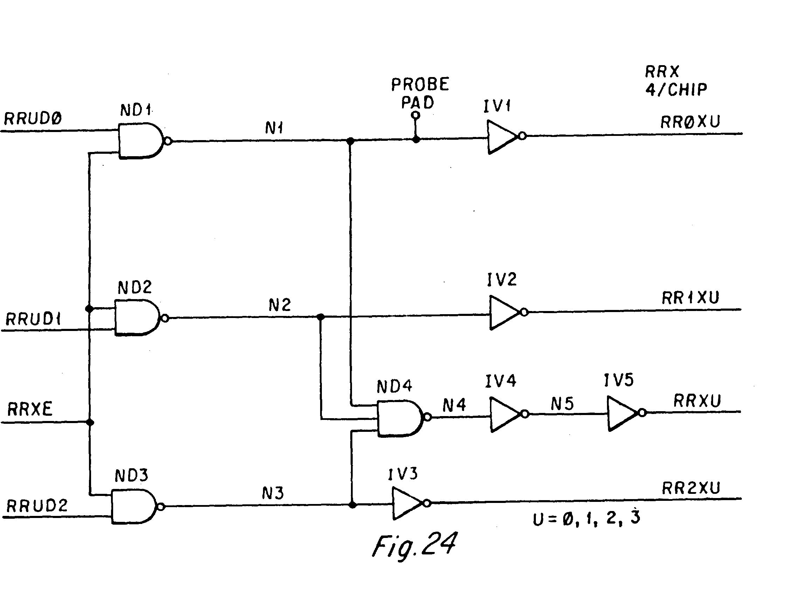

- RRX: - ROW REDUNDANCY X FACTOR
- schematic FIG. 24

There are four of these circuits in the DRAM. Each of these gates three of the 12 RRDEC outputs and at the same time selects in parallel 1 of 4 redundant rows in every 256K block. The output signals are channelled to RRQS, the ROW REDUNDANCY QUADRANT SELECT circuit.

RRXE signal enables the three 'NAND' gates. Here it is critical that RRXE start the enables only after the redundancy decoding has completed, i.e. after the unselected RRUDV signals have gone low. If the RRXE signal comes too early, the interval between the rising edge of RRXE and falling edge of the unselected RRUDV signals causes a high pulse at the outputs RR0XU, RR1XU, or RR2XU. A high pulse on these outputs will discharge the RRQSQ signal, and the determination of which quadrant is using redundancy cannot then be accurately made.

Another important point in the RRXE timing for gating is that, it needs
to switch off the gating as early as possible after an active cycle.

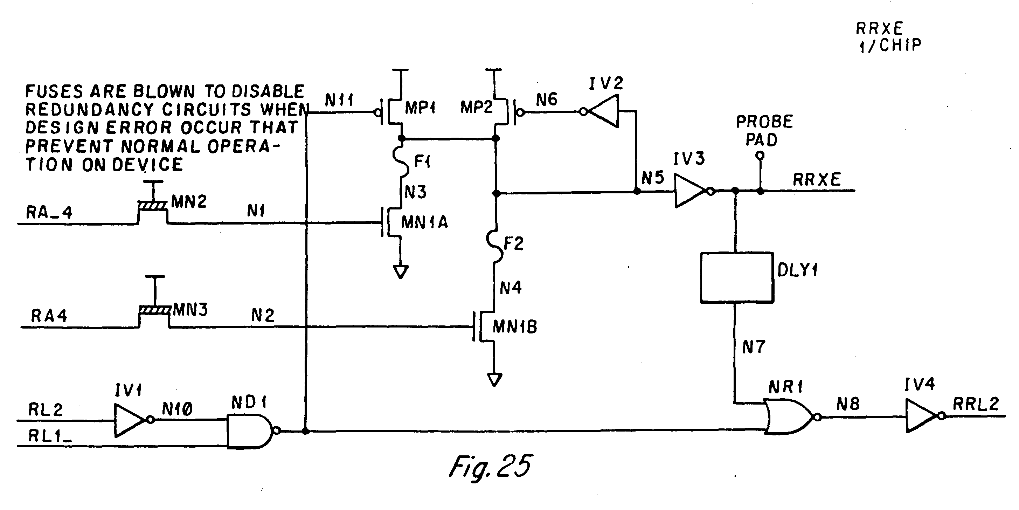

This is to disable the 'NOR' gate RRQS decoders so that in precharge there will not be a high current flow.
- RRXE: - ROW REDUNDANCY X FACTOR EMULATOR
- schematic FIG. 25

To achieve the correct timing as mentioned in RRX schematic section, RRXE circuit is designed as a mock ROW REDUNDANCY DECODER, RRDEC. By doing this, it enables the proper sequence of the RRXE signal to enable the gating in RRX circuit.

In RRXE, RA0 and RA0_ are used to simulate the redundancy addresses in RRDEC. P-channel transistor MP1 which is used to precharge the circuit is sized much larger than the one in RRDEC circuit. It is to provide a slow switching off, thus delaying the start of RRXE. Further delay is provided by the inverter, IV2. The bigger transistor also provides a fast pull up of node N2 to disable the inputs of RRQS 'NOR' gates, thus avoiding high current draw. The 2 passgates MN2 and MN3 are used to match the passgates in RRA.

RL1_ and RL2 signals are gated together to provide the precharge signal at the gate of MP1. This enables early switching off of precharge with the falling edge of RL1_ and late turning on of the precharge with the falling edge of RL2. The gated RL1_ and RL2 signal is finally gated with the delayed RRXE signal to generate the precharge signal for the row redundancy circuits, ie RRL2. The reason for doing so, is to provide an interlock such that, the RRXE circuit is to be in precharge cycle before other row redundancy circuits go in to precharge. Thus, in precharging the RRXE circuit, it disables the various decoders input, before the active RRL2 starts the precharge of these decoders. Hence, there will not be an overlap where there is decoder with active inputs and is in precharge cycle. If this occurs, high current is drawn in the decoder.

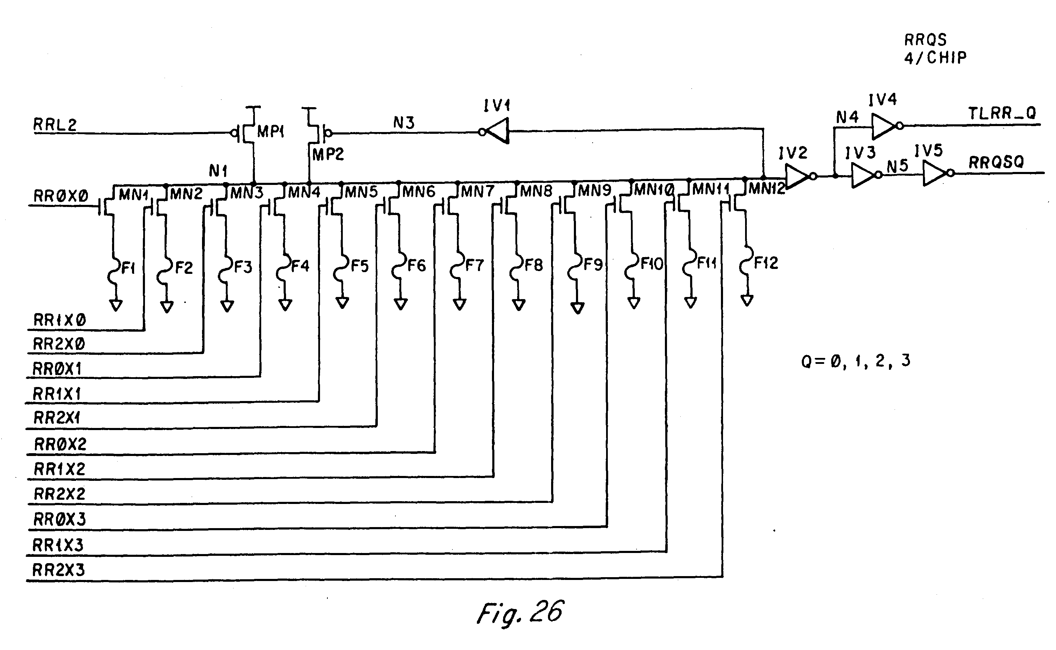

Note that, by blowing the two fuses here, we can disable the row redundancy scheme for the entire device.
- RRQS: - ROW REDUNDANCY QUADRANT SELECT
- schematic FIG. 26

Up to now, the previous circuits have decoded and identified row addresses which are used in redundancy. RRQS, the QUADRANT SELECT, does a further decoding to identify which quadrant the redundant row belongs to. There are 4 RRQS circuits in a device. Each of these selects a quadrant of the array.

The RRQS circuit is designed as a 12 input 'NOR' gate. In programming this circuit, if a redundant address does not belong to the repaired quadrant the corresponding fuse of the RRQS is to be blown. Fuses are left intact for a repaired row in its quadrant. By doing so, whenever a redundant row is addressed, and if it belongs to that quadrant, node N2 is pulled low, thus generating active output RRQS signals, i.e. TLRR_Q and RRQSQ. Node N2 remains high if the redundant row does not belong to that quadrant or if the addressed row is not a redundant row.

Signal RRL2 is used to turn on MP1 during precharge and charge N2 high. MP2 with the inverter are used to sustain the precharge level at node N2 if not selected.

Note that, the design enables a redundant address to select any number of quadrants to be active. This is done by not blowing the fuse corresponding to the selected address in the RRQS circuit relating to the quadrant with the repaired row.
- RXDEC: - REDUNDANCY X(word) DECODER
- schematic FIG. 27

RXDEC serves as the final decoding of a redundant row. Upon decoding, it propagates the booted voltage level from the wordline driver to the redundant row. Each physical redundant row is generated by an RXDEC circuit.

The redundancy decoding is done with a 3 input 'NAND' gates. With a given redundancy address, RRQSQ identifies the quadrant and RRXU decodes 1 of 4 redundant rows in every 256K array blocks. Finally, with the normal row decoding done, the block signal, BSSJK_M selects one of 16 array blocks, thus completing the row redundancy decoding.
- RRDSP: - ROW REDUNDANCY DECODER SET PULSE
- schematic FIG. 28

The purpose of this circuit is to generate pulses to the RRA and CRRA circuits for redundancy address generation during power up.

This circuit is a series of inverters and capacitors concatenated together. Input and output stages of those inverters are gated with 'NAND' gates to provide the pulses.

The circuit is activated upon power up, using the RID signal as an input. Here four output pulses are generated at different times to the 120 RRA circuits instead of just a single pulse to all the RRA circuits.

This is to avoid activating all the RRA circuits at the same time which will cause high peak current.

Besides this, metal mask changes on SW2A and SW2B and SW2C and SW2D, combines the pulse width of RRDSP0 with RRDSP1, and RRDSP2 with RRDSP3, respectively, thus generating two sets of pulses instead of four sets of pulses.

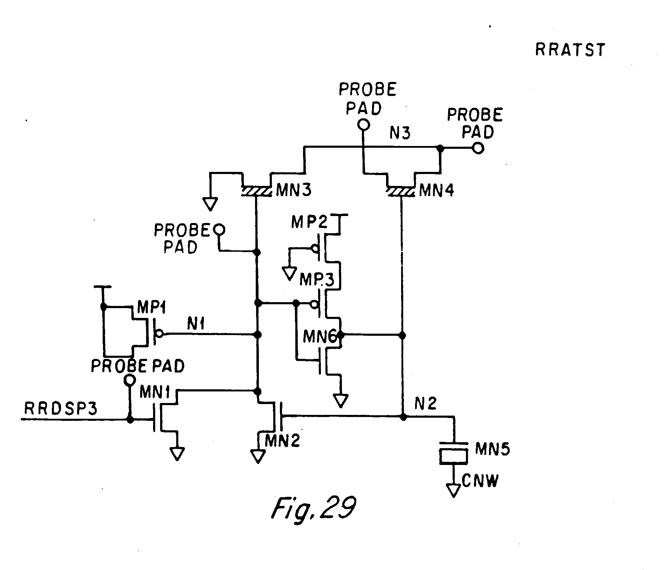

Upon completion of the pulse generation, output CRDST is activated. This is to start the columns redundancy address latching pulse in the CRDSP circuit.
- RRATST: -
- schematic FIG. 29

The objective of the circuit is to check if the pulse generated by RRDSP is enough to latch the RRA addresses. This is only to be used for internal probing.

RRATST is similar to RRA circuit except the fuse used in RRA is replaced with a capacitor, MP1. Instead of using normal inputs, a probe pad for external signal is placed on RA_X. As for RAX input, it is grounded. Extra probe pad is connected in parallel to the RRDSPU signal. This allows alternate signal to do the latching. Capacitor MN5 is to pull node N2 low at the moment of power up.

The way this circuit works is that it checks if the RRDSPU pulse width is enough to discharge none N1 of capacitor MP1. The status is monitored from probe pads at node N1 and N3.

### SENSE CLOCKS

Sense clocks are the chain of activities that do the sequencing of the data sensing in the device. These activities are activated upon the completion of row address decoding in any active cycle. It involves the generation of various clocks to switch on the selected sense amplifier.

Before going into the individual sense clocks schematic, lets take a look at the 16meg sense amplifier scheme (refer to FIGs 151, 152, and 153). Firstly, a quadrant is divided into 16 blocks of 256K memory array, i.e. BLK0 through BLK15. 17 banks of sense amplifiers are located in a quadrant. These sense amplifier banks are laid out from the END01 to the END02 side of the quadrant. There is a sense amplifier bank separating each 256K block from the neighbor block. The banks are labeled as S0 through S16, with S0 on the END01 side of array BLK0 and S16 on the END02 side of array BLK15.

To minimize the area usage, 16meg is designed with shared sense amplifier. In the shared sense amplifier scheme, every sense amplifier bank is shared by two array blocks, i.e. one on the END01 side and the other on the END02 side of the bank with the exception of the end banks S0 and S16. Note that these two banks have an array block only on one side of them.

Every sense amplifier bank has 512 sense amplifiers, thus a bank supports 512 columns of array from the block at its END01 side and another 512 column of array from the block at its END02 side.

For array symmetry reasons, the columns supported on the END01 side of a bank is always the odd addressed column, whereas those on the END02 side is always the even addressed column. As for S0, it only supports the odd column of array BLK0, and for S15, it is the even column of array BLK15. Thus in every array blocks, 512 (even address) columns go to the sense amplifier bank on the END01 side and the other 512 (odd addressed columns) go to the sense amplifier bank on the END02 side.

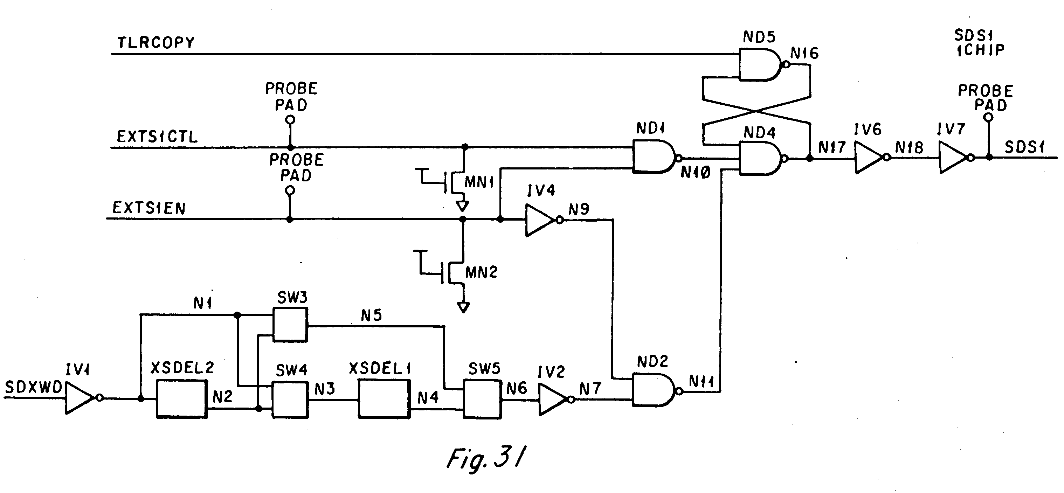

Point to take note on this scheme is that the 2 columns that share a same sense amplifier do not have the same Y-address, as one is an odd address and the other is an even address. Another point is that an access to a row in an array block activates two sense amplifier banks, one on the END01 side and the other on the END02 side of the array block.
- SDXWD: - SENSE CLOCK X-WORD DETECT
- schematic FIG. 30

This circuit times the sense clocks with respect to the activation of wordline. In previous DRAM generations, voltage level at the mock wordline had been used to trigger this circuit. But in 16meg, the mock wordline has been omitted.

Instead of using the mock wordline, a delay of 4ns is being used. Upon the completion of row factor encoding, ie when one of the RLEN signals goes active low, a high signal is generated at the output, SDXWD after the delay. This signal is channeled to the MASTER SENSE CLOCK, SDS1 to activate the sensing activities.

Besides this, SDXWD circuit times the booting of wordline, with the RLB signal. In normal cycle, the sense clock SDS4 is used to activate the wordline booting. But if in DFT ROW COPY mode, the sense clocks are inhibited after the first cycle. In the subsequent cycle, the RLB is activated along with the RLEN signals after a delay.
- SDS1: - MASTER SENSE CLOCK
- schematic FIG. 31

SDS1 is the MASTER SENSE CLOCK. It controls and generates other sense clocks needed for sensing operation.

During an active cycle, upon receiving the delayed SDXWD signal it generates SDS1 signal. But if device is operating in DFT ROW COPY mode, the circuit is inhibited during the second active cycle. Thus in the second cycle, when the based row is identified, the row data is sensed and kept inhibited in the BL & BL_ with the MASTER SENSE CLOCK active high.

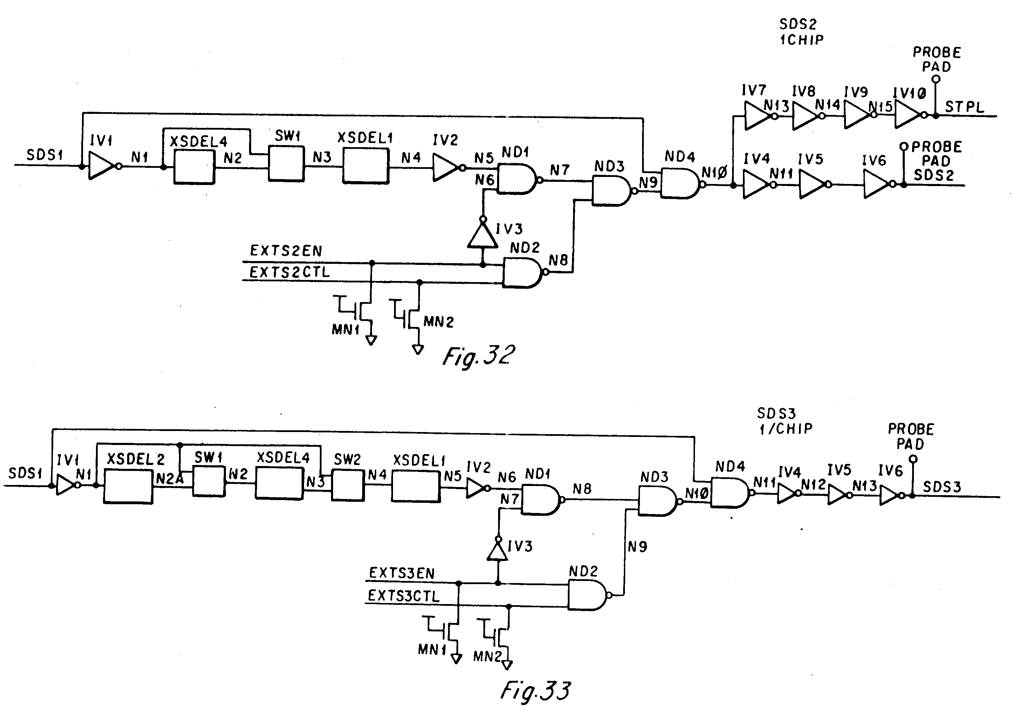

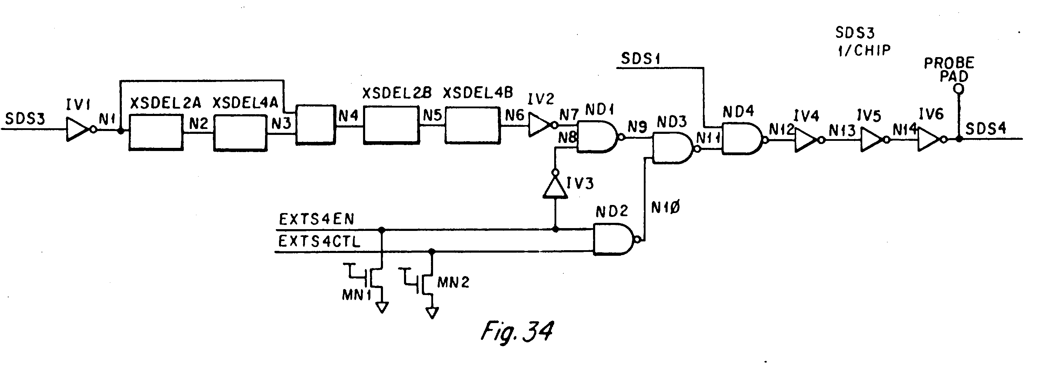

There are two probe pads that allows SDS1 signal to be controlled by externally injected signals. These two probe pads are normally held low through two N-channel transistors. By injecting a logic '1' voltage to probe pad EXTS1EN, the circuit is forced to select the signal from probe pad EXTS1CTL, while locking out the SDXWD signal.
- SDS2: - SENSE CLOCK-2
- SDS3: - SENSE CLOCK-3
- SDS4: - SENSE CLOCK-4
- schematic FIG. 32 to 34

These three sense signals are the chain of clocks generated by SDS1 signal with programmable delays. These three signals and the SDS1 are clocks that control the switching of the sense amplifier through the PC ( P-channel) and NC (N-channel) transistors.

The structure of these three circuits are basically the same. They use SDS1 for the circuit enable signal. At the same time, except for SDS4 circuit, they propagate the SDS1 signal through a programmable delay stage to generate the respective sense clocks. For SDS4 circuit, instead of using SDS1 signal, SDS3 signal is used to propagate through the delay stage for the generation on SDS4 signal. This is provide interlocking of the SDS4 signal with the SDS3 signal.

Like the SDS1 circuit, these three circuits have two input probe pads for internal testing. These probe pads allow external signals to control the timing of the sense clock generation.

In SDS2 circuit, an extra signal is generated, ie the STPL_ signal. It is a signal of the same timing as SDS2 but of different polarity. This signal is used to time the start BL/BL_ isolation from the sense amplifier.

### SENSE AMPLIFIER BANK

As previously mentioned, the sense amplifier bank that is located between 2 array blocks is different from those located at the END01 side of array BLK0 and those at the END02 side of array BLK15. Hence, the sense amps that are located at the ends of a quadrant are controlled by seperate select circuits, and the sense amp banks S1 through S15 are controlled by a repeated bank select circuit.
- BNKSL, the BANK SELECT, these are used to select the banks which are shared by two array blocks.
- LENDBNKSL, the LEFT END BANK SELECT, used to select the bank at the END01 side of array BLK0.
- RENDBNKSL, the RIGHT END BANK SELECT, used to select the bank at the END02 side of array BLK15.

The purpose of the BANK SELECT circuits is to decode the row addresses and select the sense amplifier banks for the desired array blocks. Besides this, they do a partial row decoding, i.e. the block select decoding to provide BSSJK_M signal to the row decoders for array block identification. Every sense amplifier bank has its own BANK SELECT circuit.

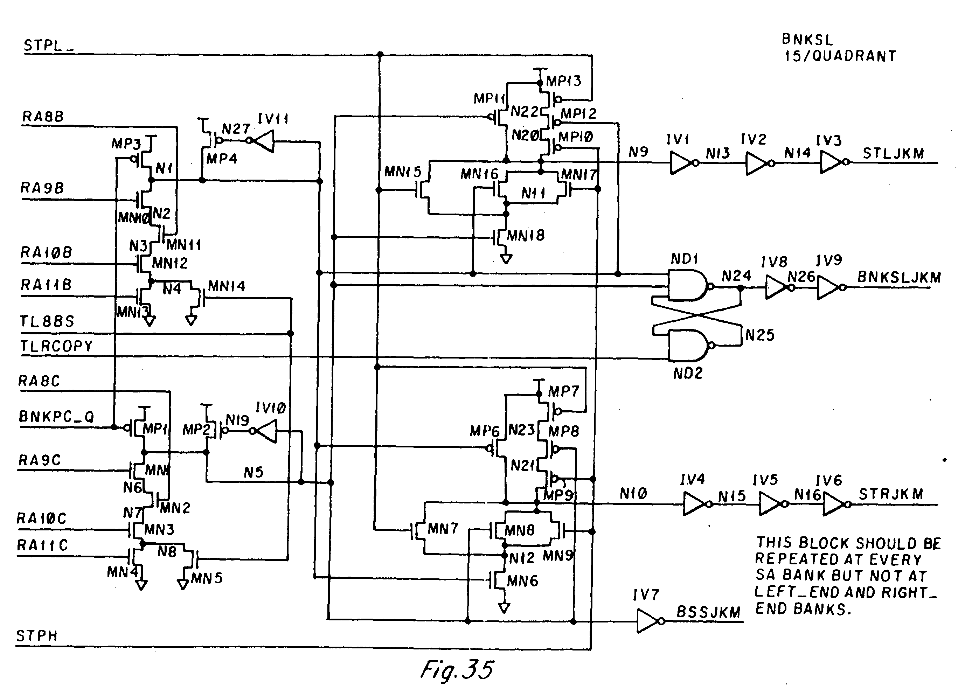

The address decoding scheme for each these banks can be found in APPENDIX A5. Besides the addresses, APPENDIX A5 depicts all the corresponding clock names for all sense amp banks.
- BNKSL: - BANK SELECT
- schematic FIG. 35 Code Appendix A5

Every BNKSL supports two array blocks. Hence, it needs to decode for two sets of addresses. The address lines used are RA8 or RA8_ through RA11 or RA11_.

In the 1st portion of the circuit, two sets of similar decoding logic with different address line combinations are used to decode the sense amplifier bank selection. The output of these two decoders are combined in the 'NAND' gate ND1 for the generation of BNKSL signal. Selection of any of the two decoders causes BNKSL signal to be active, thus indicating the selection of that bank. Besides the address lines, TL8BS signal is used as input in the decoder logic. This signal is 'OR'ed with RA11/RA11_. Output of this serves as inputs to both of the NAND gate decoders. With this setup, it allows address RA11 to be ignored in 2K refresh selection, i.e. with TL8BS tied to LOGIC '1'. Thus, in a quadrant without PA11, two sense amplifier banks are always selected.

The second portion of the circuit generates the STL/STR pulse for the BL & BL_ isolation from the sense amplifier for sensing enhancement. It includes two interlocking logic circuits. As this is a shared sense amplifier scheme, the sense amplifiers are connected to two sets of BL & BL_. But in active cycle, only 1 set of these needs to be activated. To achieve this, the logic circuit uses the two decoder outputs to identify the set of BL/BL_ which needs to be activated. The unselected set of BL/BL_ will have its STR or STL signal kept low through out the operating cycle. As for the selected set, a high pulse is generated at its STR or STL output. The start of the high pulse is timed by STPL_ whereas as the stop is timed by STPH signal.

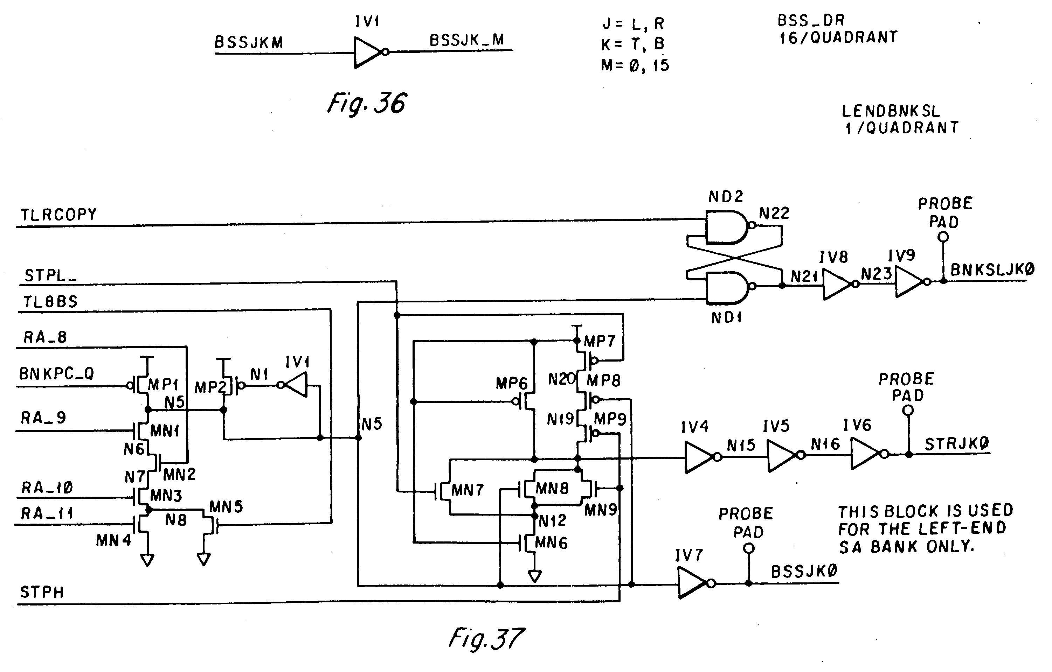

Lastly, the output from the NAND decoder that decodes the array on the END02 side of the bank (RIGHT SIDE), also generates the BSSJKM signal. This is used in row decoding as BLOCK SELECT signal. Note that the other NAND decoder is not used for block select. This is because to select any row in an array block, two sense amplifier banks are activated. For row decoding, only the right side of the BNKSL decoding scheme is used to generate the BLOCK SELECT signal.
- LENDBNKSL: - LEFT END BANK SELECT
- RENDBNKSL: - RIGHT END BANK SELECT - schematic FIG. 36 and 37

The structure of these two circuits are basically the same as the one in BNKSL, except instead of having two sets of decoders and BL/BL_ isolation logic, they only have 1 set. This is because the bank to be selected is identified with a single unique address.

As in BNKSL, address RA8/RA8_ through RA11/RA11_ and TL8BS are used in the address decoding. STPL_ and STPH are used to time the BL/BL_ isolation upon selection.

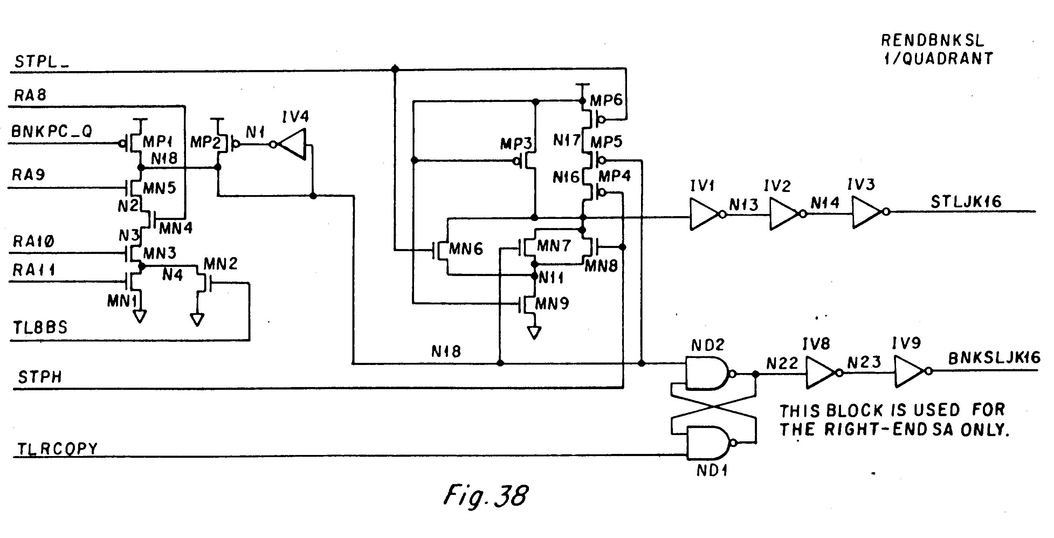

In RENDBNKSL, there is no BSSJKM signal output as the BLOCK SELECT has already been provided from the other bank associated with the array block.
- BSS_DR: -
- schematic FIG. 38

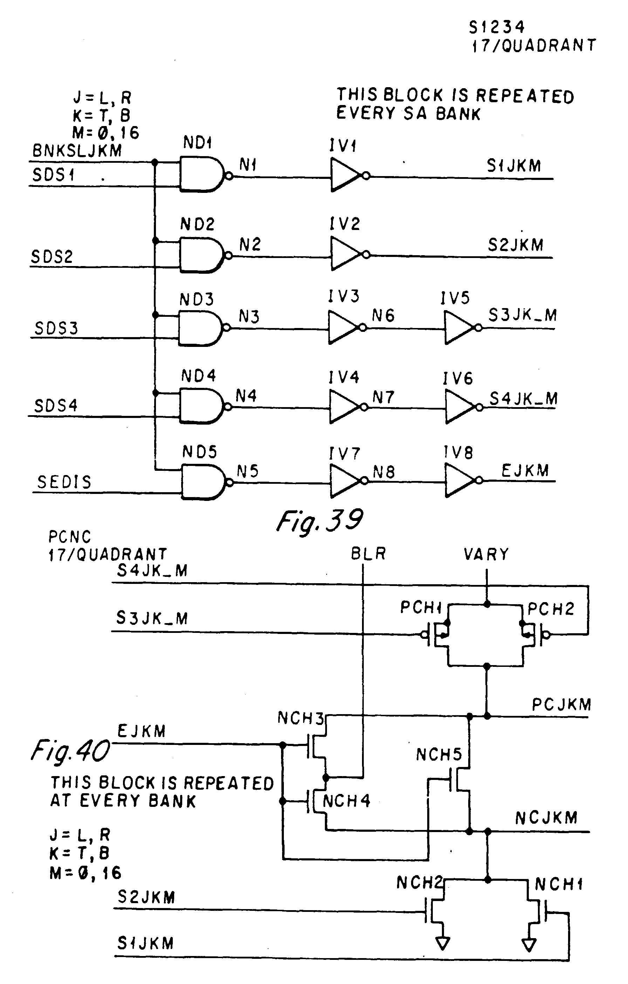

This serves as a buffer for the BSSJKM signal. It provides the correct polarity signals to the row decoder for selecting a block of row decoders and precharging the circuit. Note that if the row decoder is not selected, the decoder circuit is always in precharge mode.
- S1234: - SENSE CLOCK 1234
- schematic FIG. 39

The purpose of this circuit is to allow the propagation of all the sense clocks through to the selected sense amplifier banks, and filters out the clocks signal if the sense amp banks are not selected.

In the S1234 circuit, the clocks SDS1 through SDS4 and the SENSE EQUALIZATION DISABLE, SEDIS, signals are combined with the BANK SELECT signal. Thus only the selected banks will have these signals asserted high. The proper polarity of the clocks are set here: for PC clocks, it is active low; whereas for NC clocks, it is active high.
- PCNC: - P Channel and N Channel
- schematic FIG. 40

This is the circuit that does the pull up and pull down for the voltage differential at the BL and BL_ pair during the sensing. The S1JKM and S2JKM that are connected to the two N-channel transistors,do the pull down of the low side bitline, whereas S3JK_M and S4JK_M which are connected to the P-channel transistors do the pull up of the high side bitline.

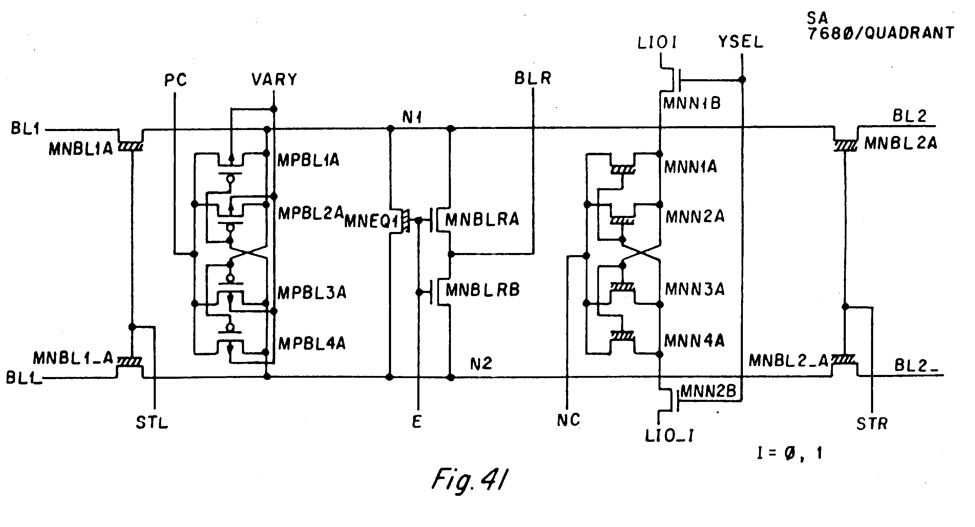

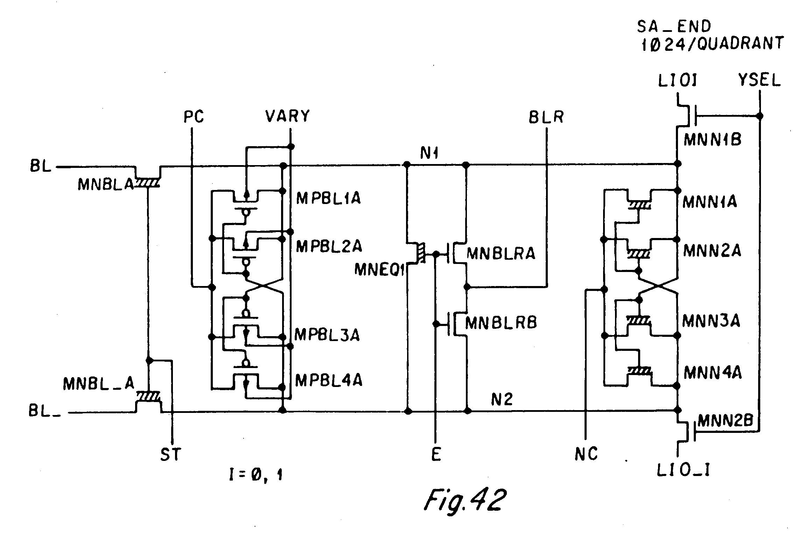

BLR signal is also connected to equalize both the node PCJKM and NCJKM during the precharge cycle. This supports and speeds up the BL and BL_ equalization process.
- SA: - SENSE AMPLIFIER
- SA_END: - SENSE AMPLIFIER END - schematics FIG. 41 and 42
Code Appendix A6

These are the sense amplifiers schematic. SA is the shared sense amplifier and SA_END is the sense amplifier located at the end banks in a quadrant. The BL and BL_ are connected to the sense amplifier through a pair of low Vt n-channel transistors. In the SA circuit, these transistors serve two purposes. Their first purpose is to isolate the non-selected BL/BL_ pair from the sense amplifier. The second purpose is to provide an isolation pulse to the selected BL/BL_ pair for sensing enhancement reasons. As for SA_END circuit, the two transistors are needed only for sensing enhancement reasons.

During precharge, the signals E and BLR are used to equalize the BL and BL_. In active cycle the signal E is inactive allowing the sense amplifier to split the voltage level between BL and BL_ as NC and PC do the pull down and pull up. Upon completion of sensing, the data from BL and BL_ can be transferred into the LOCAL I/O, LIOI and LIO_I lines if the YSEL signal is asserted high.

### COLUMN CLOCKS

The column clocks are a short series of activities that selects sense amplifiers data to be propagated into the LOCAL I/O lines. The activities involves the generation of column factors to the selection of sense amplifiers. In supporting the ENHANCE page mode, these activities are triggered off by the ROW CLOCKS and SENSE CLOCKS instead of the Column Address Select (CAS) clock.

### COLUMN CLOCKS DECODING SCHEME

The column decoding that is done here is just a partial column decoding. It uses CA2/CA2_ through CA9/CA9_. Column decoding with CA0, CA1, CA10 and CA11 and the address complements are done in the I/O circuits.

First, lets take a look at the memory array as whole. It is divided into four quadrants. Each quadrant is identified with the address CA10 and CA11. Hence, these two column address lines do the quadrant selection only and not the physical column selection. For a X4 device, CA10/CA10_ and CA11/CA11_ will remain high. Anyway this portion is part of the I/O circuits.

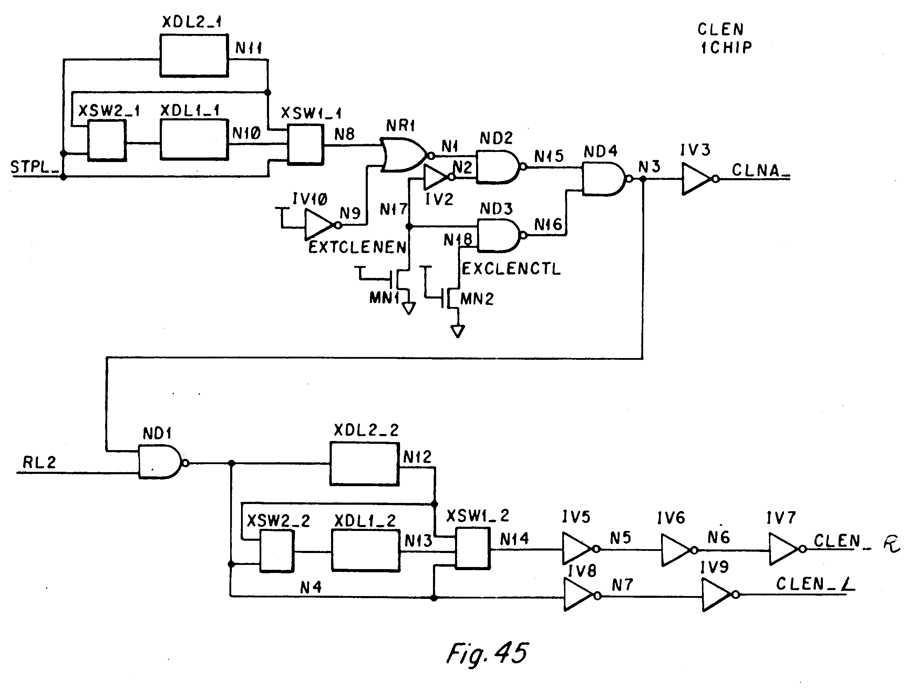

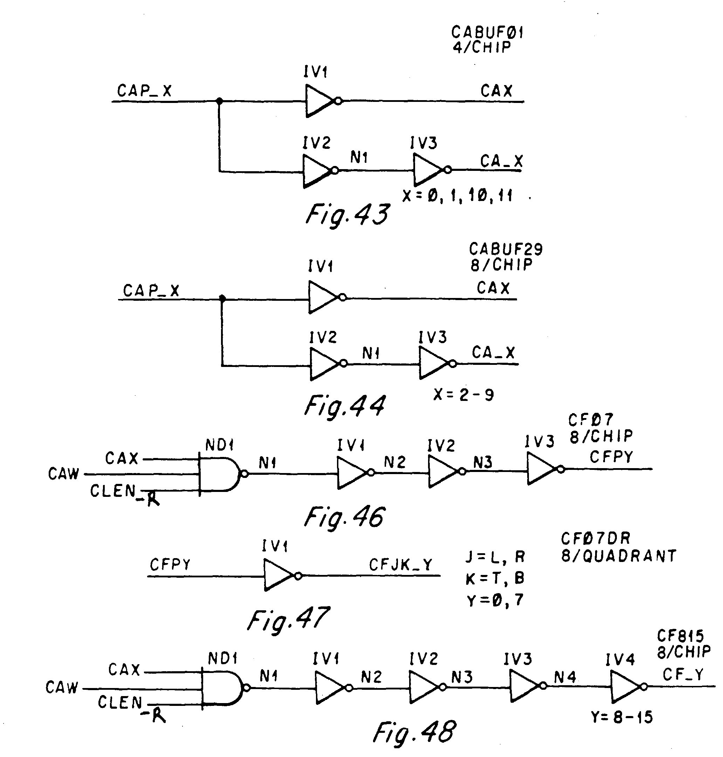

Next, in a quadrant, there are 1024 columns. These columns are decoded with addresses CA0 through CA9 and their complements. They are grouped into 4 columns of the common CA2 through CA9. Each of these groups is identified with a single YSEL signal. Thus, four sets of data from four adjacent columns are propagated into the LOCAL I/O lines and this completes the COLUMN CLOCKS DECODING SCHEME. Selection of the final addressed column is done in the I/O circuits.
- CABUF01: - COLUMN ADDRESS BUFFER 01
- CABUF29: - COLUMN ADDRESS BUFFER 29
- schematics FIG. 43 and 44

These two circuits act as buffers to the column addresses. They generate the true and complement addresses that will be used for decoding purposes in subsequent circuits.

CABUF29 is for column address CA2 through CA9 and CABUF01 is for CA0, CA1, CA10 and CA11. Even though these circuits are presently the same, they are grouped as two schematics to identify the various stages these address lines are used in decoding and as such, have different loading requirements. With two schematics, the output driver sizes can be easily changed within the two separate blocks.

CABUF29 buffers are address lines used for column factors generation whereas CABUF01 are address lines used in the I/O decoding.
- CLEN: - COLUMN LOGIC ENABLE
- schematic FIG. 45

CLEN enables the propagation of the column factor generation and activates one ADDRESS TRANSITION DETECTOR circuit.

CLNA_ a delayed STPL_ signal, enables the external address to propagate as a column address. By doing so, it is actually using the start of sense amplifier sensing, (i.e. the moment when BL & BL_ is isolated from the sense amplifier), to multiplex the external address to be a column address. Note that, by doing so it supports the `ENHANCED PAGE ' mode operation, i.e. the column address is propagated to the decoders even before the CAS_ signal is activated.

The STPL_ signal is also propagated through a series of inverters and then combined with RL2 signals to generate CLEN_R and CLEN_L. These are signals that start the column factors generation and activate an Address Transition Detector, respectively.

Probe pads EXTCLENEN and EXTCLENCTL can be used to disable the circuits normal operation and use the externally supplied signal to generate the outputs.
- CF07: - COLUMN FACTOR 0,7
- CF07DR: - COLUMN FACTOR 0,7 driver
- CF815: - COLUMN FACTOR 8,15
- CF_CODE: - COLUMN FACTOR CODE
- schematic FIG. 46 through 48
APPENDIX A7

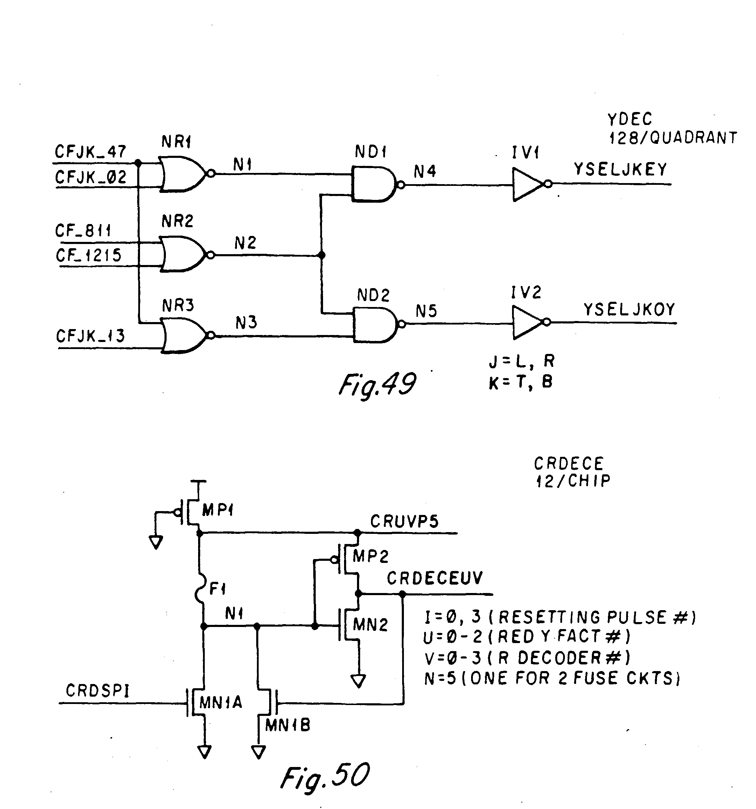

The column factors are encoded here for better column decoding scheme. They are encoded with a `NAND' function. The series of inverters is to enhance the driving capabilities of these factors.
- YDEC: - Y DECODERS
- schematic FIG. 49

YDEC decodes the input address through the column factors and when asserted high will turn on the transfer gates of the selected sense amps and connect the LOCAL I/O lines to the bit lines. The circuit is basically a two `NOR' gate decoder with four inputs each. The four inputs come from the combination of the four sets of column factors. The reasons for not merely designing `NOR' gates with 4 inputs, but a combination of `NOR' gates, `AND' gates and inverters are;
- layout constraints.
- high capacitive loading for 4 input `NOR' gates.

### COLUMN REDUNDANCY SCHEME

As in Row redundancy, its purpose is to replace the faulty columns to make a fully operational die.

A memory array in a die is divided into 4 quadrants. Each quadrant has 16 array blocks of 1024 columns. In every array block, there are 12 redundant columns. These redundant columns are located at the side facing the center of the die. A redundant column comprises of a pair of bitlines (BL & BL_) and a sense amplifier.

Unlike the row redundancy scheme, where a redundant row can replace any faulty row, column redundancy repair is governed by the data path of the faulty columns. Every array block is supported by two sense amplifier banks. Each of these banks has two data paths to two different GLOBAL I/O lines. Hence for a repair, only the redundant column with the same GLOBAL I/O line is usable.

The redundant column array has the same topology as the block array topology. The redundant sense amplifier banks are a continuation of the regular sense amplifier banks. There are six redundant sense amplifiers in each of these banks. The first three of these sense amplifiers are connected to the even GLOBAL I/O while the other three sense amplifiers are connected to the odd GLOBAL I/O. For a redundancy repair first we need to know which sense amplifier the faulty column is connected to. Once the faulty column and rejected sense amplifier is identified, it is replaced with a redundant column whose sense amplifier has the same GLOBAL I/O.

In redundancy programming, for every faulty column in an array block, two adjacent columns need to be replaced. The two columns have the common column address CA11 through CA1. At the same time two other columns of the same address with in a block in the next octant will be replaced. Reasons for doing two octant repairs simultaneously are the same as in the row redundancy scheme.

Besides repairing two columns at one time, there is an option to replace adjacent four columns of common CA11 through CA2 with the same redundancy decoder. There is also an option of how many quadrants are to be replaced with the same redundancy decoder.

The limitations on how many columns are replaceable are:
- 12 redundancy decoders, thus only 12 logical column replaceable.
- 12 physical redundant columns per array block but each repair uses at least two columns. Thus in each array block, there are only six repairable locations.
- six redundant sense amplifiers per bank. Three of these are connected to the even GLOBAL I/Os and the other three the odd GLOBAL I/Os. This limits the maximum of columns replaceable with the same GLOBAL I/O to three.
- Repairs for columns of same address but from different blocks need to have independent redundancy decoders if they do not share the same RA8 through RA9 address.

### COLUMN REDUNDANT DECODE ENABLE CIRCUIT

- CRDECE: -
- schematic FIG. 50

The column redundancy decode enable circuit CRDECE is an enabler circuit for the column redundancy decoders. There are 12 CRDECE circuits on the chip. When the fuse F1 is blown, the corresponding column redundancy decoder is enabled.
- CRRA: - COLUMN REDUNDANCY ROW ADDRESS
- CRCA: - COLUMN REDUNDANCY COLUMN ADDRESS
- schematic FIG. 51 and 52
CODE APPENDIX 8, 9 and 10

These circuits are the same as the RRA circuit of ROW REDUNDANCY. CRRA and CRCA are used to program the column redundancy address, where CRCA is to program the column CA2 through CA9, while CRRA is used to program the RA8 through RA10 for array block identification.

The redundancy programming is done by blowing the fuses in the circuit. Refer to row redundancy RRA schematic for programming explanation.

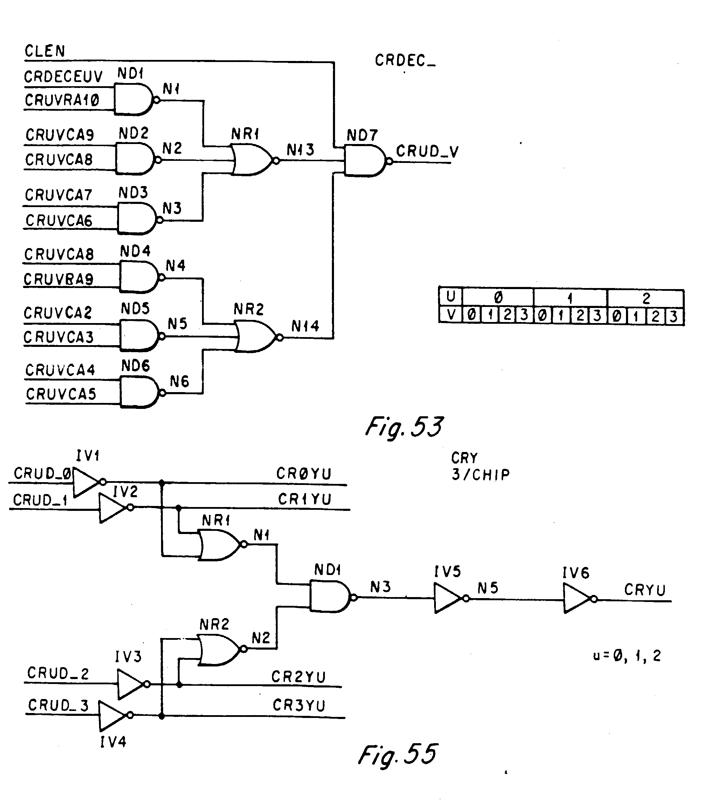

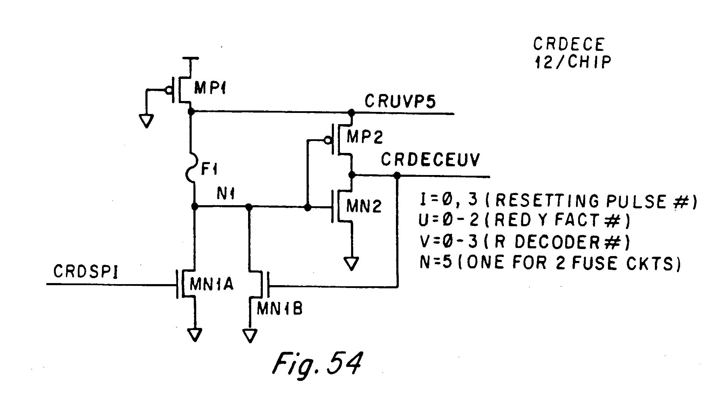

These redundancy addresses are latched during the power up sequence when a pulse CRDSPI is propagated into the circuits. The latched address determines the value of the address output signals output to the redundancy decoders.
- CRDEC_: - COLUMN REDUNDANCY DECODER
- CRDECE: - COLUMN REDUNDANCY DECODER ENABLE
- schematics FIG. 53 and 54

There are 12 CRDEC_ circuits in a device. CRDEC_ decodes the address generated from CRCA and CRRA to determine if the input address is the redundant column address. Each of these decoders is associated with one CRDECE circuit.

To enable the CRDEC_, its corresponding CRDECE fuse is blown. The CRDECE circuit works in the same manner as the CRRA, CRCA and RRA circuits. During power up, node N1 is pulled to low. If its fuse is blown, N1 remains at low level. Else, MP1 pulls it back to high. With this, the output, CRDECEUV will be a logic '1' if the fuse is blown and logic '0' otherwise. Logic '1' signifies that its corresponding decoder is enabled.

CRDECEUV, together with the output from respective CRRA and CRCA, form the inputs of the redundant decoder, CRDEC_. These signals are initially combined with 'NAND' gates and then followed by 'NOR' gates. Finally, they are combined with a control signal, CLEN.

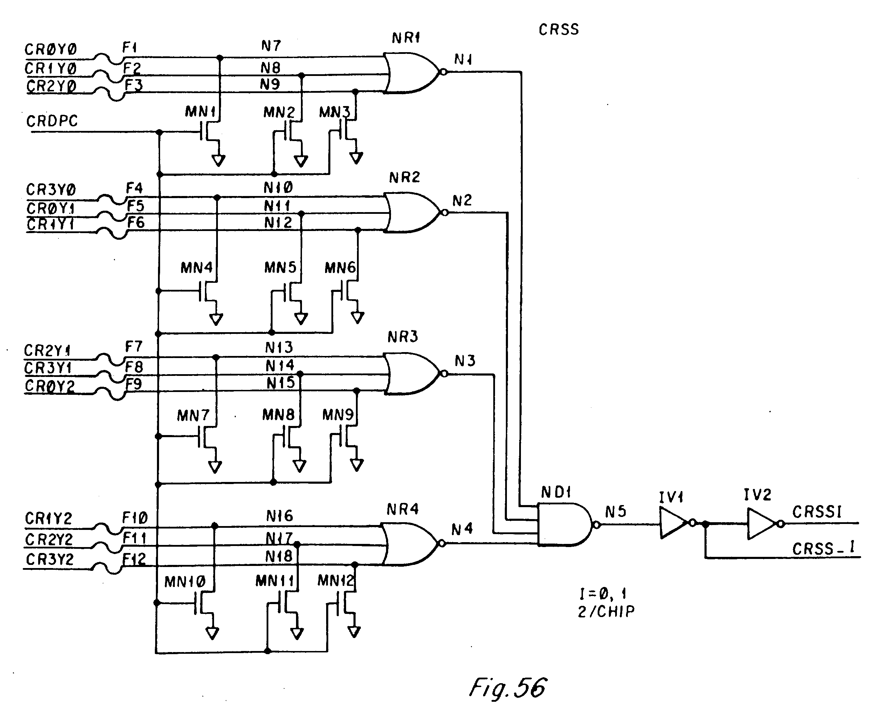

CLEN serves as a control signal that activates the decoding upon the completion of row decoding. Also, it forces the decoder output to always be inactive high during the precharge cycle.
- CRY: - COLUMN REDUNDANCY Y FACTOR
- schematic FIG. 55
CRY circuit serves two purposes. First it groups the redundancy decoders and identifies them with the available physical redundant columns. Secondly, it buffers the decoder outputs as these outputs have low driving capability.

The 4 redundancy decoder outputs are combined to generate the CRYU signal. As long as any 1 of the 4 decoders is active, the output CRYU is asserted high. As there are 12 decoders, three CRYU signals are generated from three CRY circuits. Each CRYU signal identifies a pair of redundant sense amplifiers from every bank of the four quadrants: one of the sense amplifiers is to the even GLOBAL I/O and the other is to the odd GLOBAL I/O lines of the sense amplifier bank. Thus CRY does a partial selection of the physical redundant column.

The decoder outputs are buffered through the inverters to enhance driving capabilities.
- CRSS: - COLUMN REDUNDANCY SEGMENT SELECT
- schematic FIG. 56

There are two CRSS circuits in a device. As mentioned earlier, in every sense amplifier bank, there are two data paths, i.e. one to the even GLOBAL I/O and the other to the odd GLOBAL I/O lines. During normal column addressing, a selected sense amplifier bank has two sets of data propagating to the GLOBAL I/O lines, both the even and the odd. These two sets of data from two columns are selected by CA11 through CA2 and CA0. CRSS enables the selection in replacing any one of these two columns. It also allows these two columns of the same sense amplifier bank to be replaced simultaneously.

CRSS is a 12 input 'NOR' structure of gates. Its inputs come from the CRY circuits. In column redundancy programming, if a column address CA9 through CA2 selects the column with even GLOBAL I/O, its corresponding fuse for that decoder address in CRSS0 is left intact. Thus, upon selection, the active column redundancy decoder will have its node N5 pulled high, generating active CRSS0_ and CRSS0 outputs.

At the same time, it is not desired to indicate that the other column with odd GLOBAL I/O is a redundant column. To do this, the fuse for the corresponding decoder signal in CRSS1 is blown.

If only the column with odd GLOBAL I/O is to be selected, the fuse in CRSS1 is left intact while the fuse in CRSS0 is blown. But if we want both columns to be redundant columns, both corresponding fuses for these two circuits are left intact.

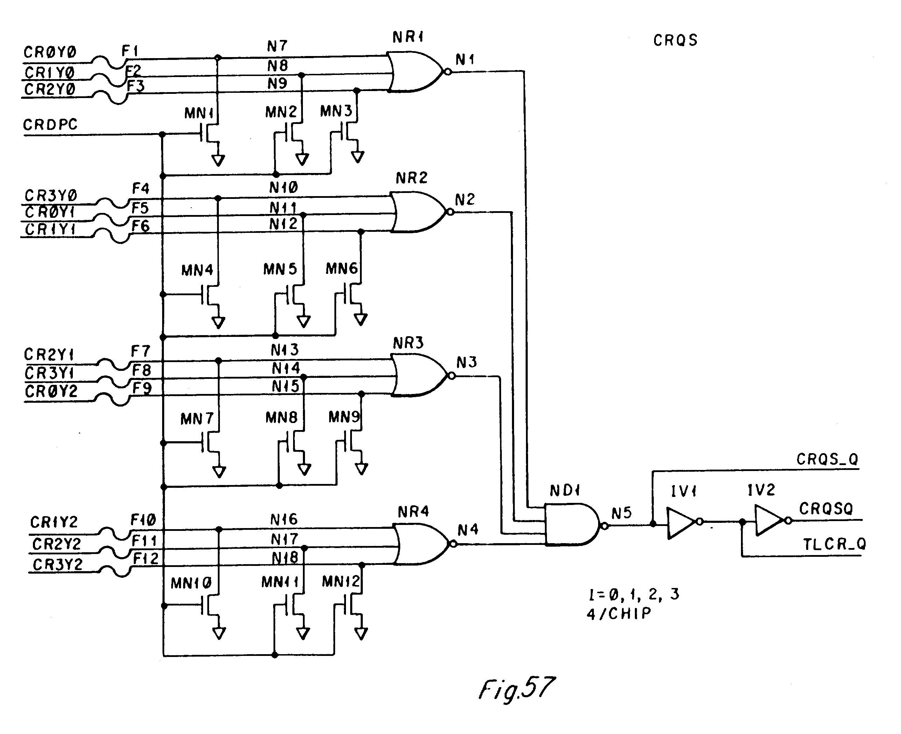

The pull down transistors on all the inputs of the 'NOR' gates are controlled by the CRDPC signal. In a precharge cycle, it grounds all the inputs. But in an active cycle, CRDPC is biased to the region of 1.5 - 1.6V. This is to keep the input that has its fuse blown to the precharged low level. Selected biasing here is with the consideration that it does not ground a high input at an unblown fuse.
- CRQS: - COLUMN REDUNDANCY QUADRANT SELECT
- schematic FIG. 57

The purpose of CRQS is to identify the quadrant the redundant column belongs to. There are four CRQS circuits in a device. Each CRQS represents a quadrant. Programming in the CRQS circuits is independent of each other, which thus allows a same column address to be programmed in more than a single quadrant with a single redundancy decoder.

CRQS structure is basically the same as CRSS structure. It has a 12 input 'NOR' gate with CRDPC as the precharge signal. CRPPC and the pull down transistors serve the same purpose as in CRSS. The inputs to the 'NOR' gates are the buffered outputs from CRY. In precharge, it has the same problem of high current flow as in CRSS, and it uses the same remedy as in CRSS.

In redundancy programming, the fuse corresponding to the output of the required address is left intact to indicate that the redundant column belongs to a quadrant. To indicate the redundant column does not belong to the specific quadrant, the fuse for the decoder output is blown for that CRQS.

Besides the normal quadrant select signals, CRQS_Q and CRQSQ, another signal TLCR_Q is generated. This is used for DFT COLUMN REDUNDANCY ROW CALL.
- CRYS: - COLUMN REDUNDANCY Y SELECT
- schematic FIG. 58 CODE APPENDIX 11

This circuit does the final decoding of the redundancy address and activates the redundancy sense amplifiers transfer gate to propagate its data onto the GLOBAL I/O lines. The output signal is equivalent to the YSEL signal from YDEC circuit, except this signal activates two sense amplifiers in an array block instead of four sense amplifiers.
- CRIOS: - COLUMN REDUNDANCY I/O SELECT
- schematic FIG. 59

As mentioned earlier, there are the odd and even GLOBAL I/O lines for every sense amplifier bank. The activation of either even or odd redundant sense amplifiers depends on the programming on the CRSS0 and CRSS1 circuits. But note that this programming merely activates the redundant sense amplifiers for data propagation into their respective GLOBAL I/O lines. The normal sense amplifiers operation in the array block is not interrupted; data will propagate from the normal sense amplifier banks to the GLOBAL I/O lines.

CRIOS does the selection of which sets of data are actually being passed into the GLOBAL I/O lines. There are four CRIOS circuits. Each controls a quadrant of the array. CRIOS takes the CRSS0 and CRSS1 signals and combines them with CRQSQ to generate the multiplexing signals CRIOSJK0 and CRIOSJK1.

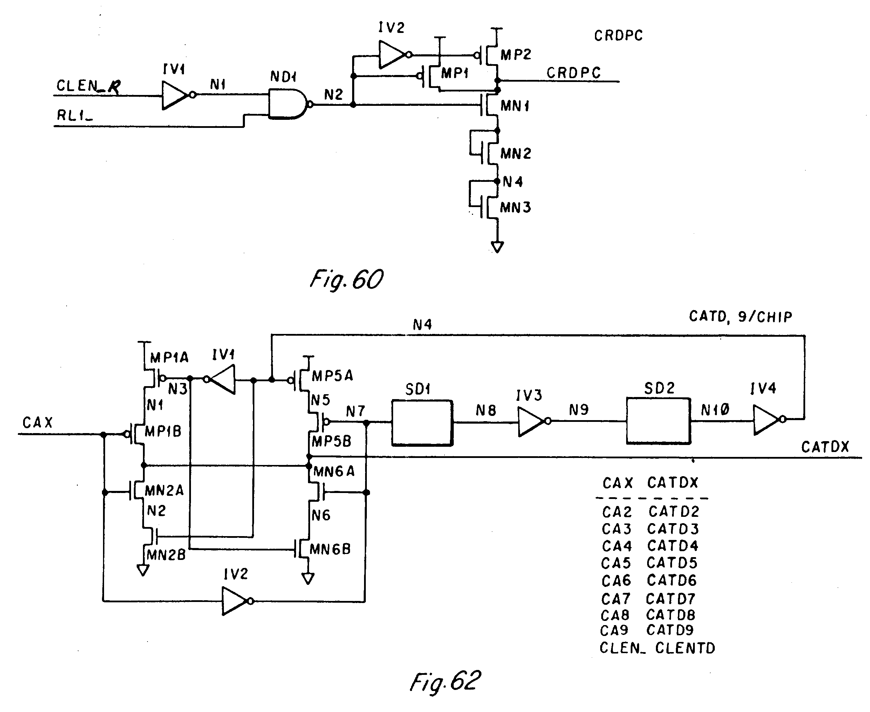

CRIOSJK0 is used to select the even GLOBAL I/O lines while CRIOSJK1 is used for the odd GLOBAL I/O lines.
- CRDPC: - COLUMN DELAY REDUNDANCY PRECHARGE
- schematic FIG. 60

CRDDPC generates a constant 1.5 - 1.6V output. This output is used to regulate the pull down transistors in CRSS and CRQS. To minimize current flow, the constant voltage level is only generated during active cycle, ie either active CLEN or active RL1_. RL1_ provides the early setting of the output to the regulated level, whereas CLEN sustains it for a certain delay after RL1_ goes to its inactive state.
- CRDSP: - COLUMN REDUNDANCY DECODER SET PULSE
- schematic FIG. 61

This schematic is basically the same as the row redundancy, RRDSP schematic. Four pulses are generated in the circuit. They are used for the column address latching in the CRRA and CRCA circuits. The pulses are triggered by CRDST signal from RRDSP, i.e. after all the row redundancy addresses have been latched.

### INPUT/OUTPUT CIRCUITS

- CATD: - COLUMN ADDRESS TRANSITION DETECTOR
- schematic FIG. 62

As the name suggests, this circuit detects changes in the column addresses. There are nine of these circuits. They detect the changes in address CA2 through CA9 and CLEN_ signal. The purpose of the CATDs is to signal the device to do the appropriate initialization whenever there is a new set of data to be dumped onto the I/O lines. This also enables the device to operate in 'ENHANCED PAGE ' mode, i.e. when the column address changes, I/O lines are preset to the idle state before the new set of data is propagated.

Note that only CA2 through CA9 are used. CA10, CA11, CA1 and CA0 are not needed as they are address lines used for quadrant and I/O line selection. CA2 through CA9 are the addresses that determines the column factors and activate the Y-select. Thus, they select the sets of columns which will have their data propagated into the I/O lines.

As for CLEN_L this signal times the propagation of external address as column address. Thus, the activation of this signal starts the acceptance of a column address and propagation of column data onto the I/O lines. Hence, the transition of CLEN_ L needs to be detected to do the proper presetting.

In a 'PAGE ' mode operation, propagation of active data on the I/O lines starts with the detection of a CLEN_L transition. Next sets of data can then be PAGED whenever the column address changes.

For the CATD circuit, it consists of two special complex gates. The special gates are the totem pole of two p-ch gates and two n-ch gates. The top p-ch of the complex gate is connected to the bottom n-ch of the other complex gate. Gates of the p-ch are connected through an inverter. The circuit performance is described in APPENDIX 47.

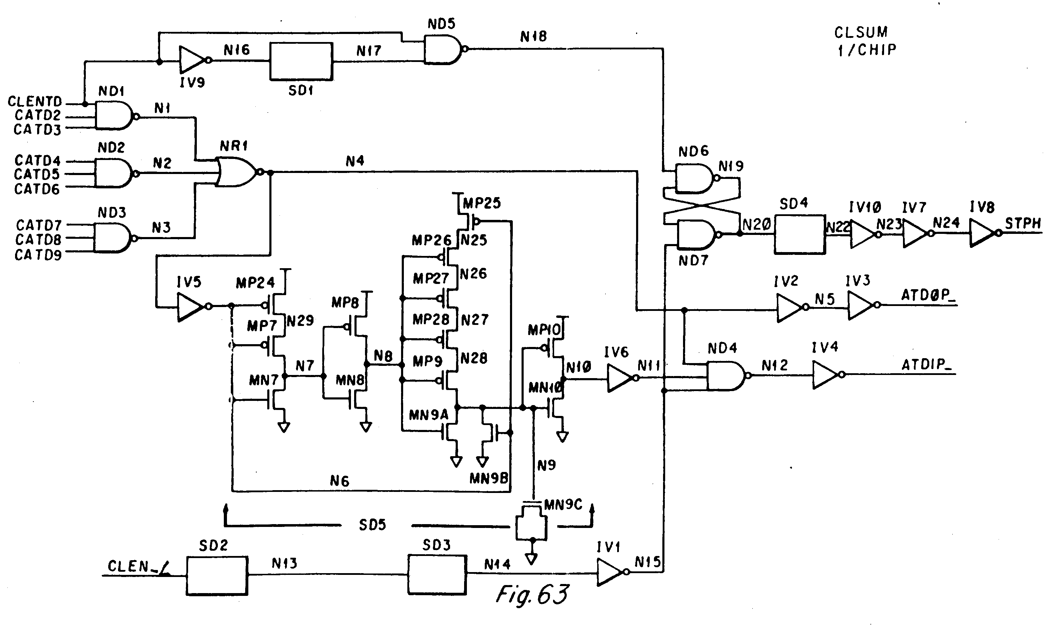

Note that the delay generators SD1 and SD2 are delays for high to low transition only.
- CLSUM: - COLUMN LOGIC SUMMATION
- schematic FIG. 63

CLSUM combines all the CATD outputs together to provide a single set of signals to be used by the device, i.e. for the preset and initialization conditions mentioned in the CATD section.

The first signal that is generated is the ATD0P_. This is merely the combination of all the CATD outputs and it has the same polarity as CATD.

The ATD0P signal is inverted and buffered into four separate ATDP signals in the CLSUMDR circuit. The ATD0 pulse is used to initialize the LOCAL I/O lines in the IOCLMP circuit.

The ATD1P_ signal is generated from the combination of all the CATD signals and CLEN_L. The ATD1P signal is then inverted and buffered into four separate signals in the CLSUMDR circuit.

The ATD1 signals are at a logic "1" level during the precharge cycle, and will flip to a low level on the falling edge of the ATD0 pulse. During PAGE mode, a transition in any of the column addresses, CA2 through CA9, will generate another ATD0 pulse. This results in the generation of an ATD1 pulse that is 2ns longer than the ATD0 pulse. The ATD1 signals control the amplification of data through the LOCAL I/O AMP circuit.

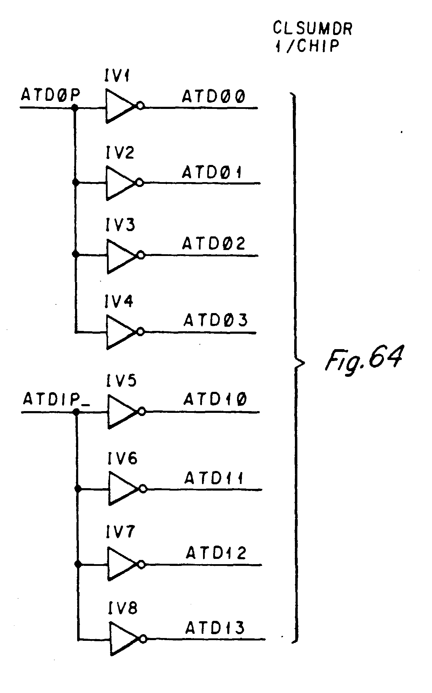

The last signal that is generated is the STPH signal. The gated CATD signal triggers STPH from logic '0' to logic 1 at the trailing edge of its pulse. Once STPH is triggered, it is latched until it reseted in the precharge. By doing so, it serves as an interlock of activities where the stop of the 'T' signal will only occur after the completion of I/O lines initialization. This is to avoid the I/O initialization from disrupting the sensing operation. Besides this, it isolates the sense amplifiers when there is new data to be dumped onto the I/O path during 'PAGE ' mode.
- CLRSUMDR: - COLUMN LOGIG DRIVER
- schematic FIG. 64

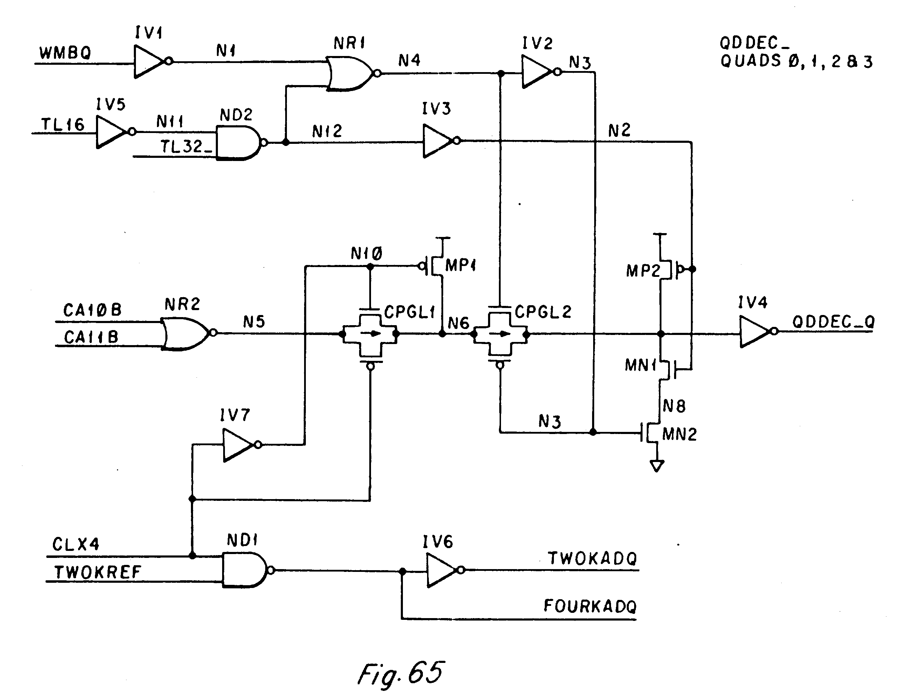

The CLSUMDR circuit takes the ATD0P_ and the ATD2P_ signals and inverts and buffers from each into four separate ATD0 and ATD2 signals. The four outputs from each signal go to the four array quadrants, and are located in close proximity to the quadrant it serves. The purpose of these signals are described in the CLSUM paragraph.
- QDDEC: - QUADRANT SELECT
- QDDEC_CODE: - QUADRANT SELECT CODE
- schematic FIG. 65 APPENDIX 12
QDDEC does the decoding for selection of an active quadrant. QDDEC_CODE shows the decoding scheme. In a device there are FOUR DATA LINES, where each of the data lines represents a quadrant.

Addresses CA10 and CA11 are used in the decoding. In the X1 device, only one of the four DATA LINES is active. Whereas for the X4 devices, all four DATA LINES are active with valid data. In X4 operation the CLX4 signal disables the passgate CPGL2, thus masking off the address decoding. CLX4 enables all four QDDEC by pulling up node N6 through MP1.

If the device is in DFT X16 or X32 mode, all 4 DATA LINES are activated regardless of device type. The DFT signals TL16 and TL32_ shut off the passgate CPGL2 and pull up node N7 through MP2.

For the X4 device, there is the 'WRITE PER BIT' operation. This operation allows the user the option of selecting the quadrant to be masked off, i.e. data is not written into that quadrant during a write cycle. In this operation, the signal WMBQ is a logic '0' if that quadrant is to be masked, else, it is a logic '1'. This logic '0' shuts off passgate CPGL2 and disables the output by pulling node N7 low through MN2 and MN1 Note that by having MN1, controlled by the DFT signals, it serves as an interlock, ie the 'WRITE PER BIT' only operates in non DFT mode.

Besides the main operation of decoding the active quadrant, QDDEC generates two other signals which are needed for I/O line decoding in a 2K REFRESH, X4 device. The two signals are TWOKADQ and FOURKADQ. These signals are generated by combining CLX4 and the TWOKREF signal.

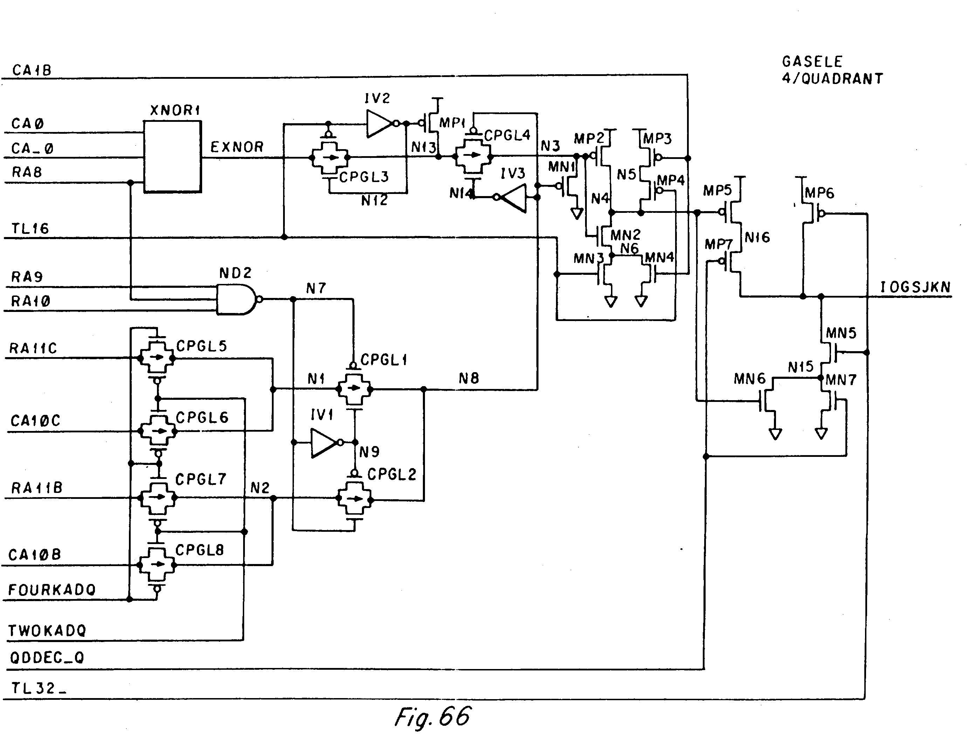

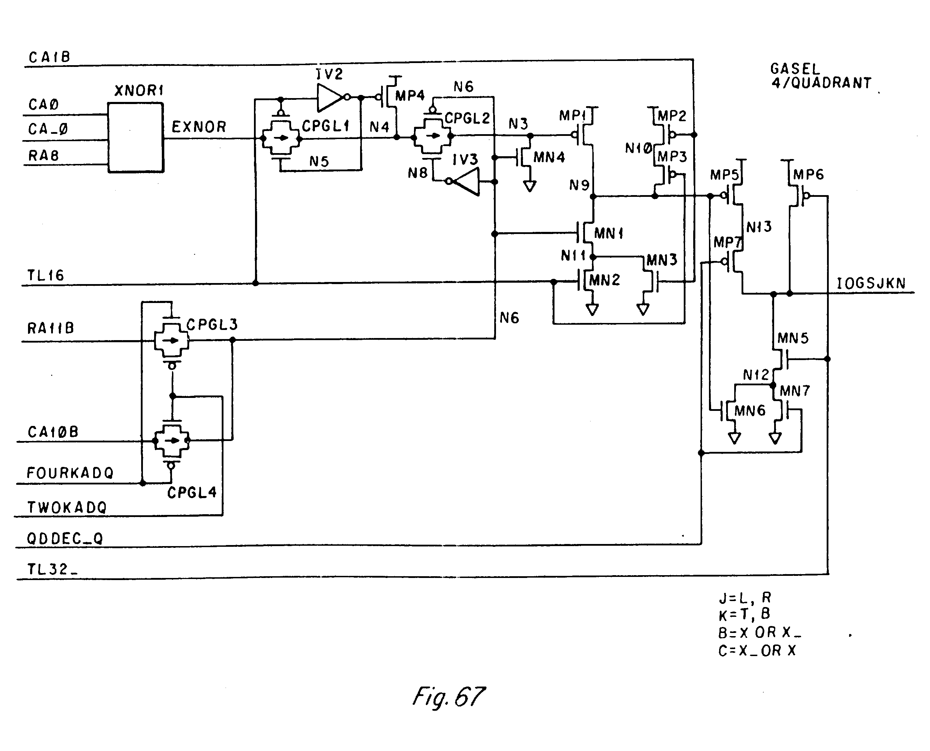

An active TWOKADQ signal represents a X4 device operating in 2K refresh mode. An active FOURKADQ represents all X1 devices or just a X4 device with 4K refresh.
- GASELE: - GLOBAL AMPLIFIER SELECT END
- GASEL: - GLOBAL AMPLIFIER SELECT - schematic FIG. 66, 67
- APPENDIX 13 and 14

In a quadrant, there are eight GLOBAL I/O lines. In normal read operation, only one of the eight data lines is selected to allow propagation of data to the quadrant DATA LINE. In a normal write cycle, the write data on the quadrant DATA LINE is propagated to a single GLOBAL I/O line. This selection is done by GASEL and GASELE. There are four GASELE and four GASEL circuits in a quadrant. Each of these is used to select 1 of 8 GLOBAL I/O line to be activated. Besides merely doing the 1 in 8 selection, these circuits use the QDDEC_ signal to activate the active quadrant's GLOBAL I/O lines only.

The way the GLOBAL I/O lines are grouped into GASEL AND GASELE is as follows;
- GASELE: - GLOBAL I/O# 0, 1, 4 & 5 , ie the End I/O lines.
- GASEL: - GLOBAL I/O# 2, 3, 6 & 7 , ie the Normal I/O lines.

Two types of decoding, as shown above is needed because end GLOBAL I/O lines ( #0, 1, 4 & 5) need a more complicated decoding compared to the other four GLOBAL I/O lines. Note that for decoding of the normal GLOBAL I/O lines, the address RA11 is either logic high or a logic low. But for the end GLOBAL I/O lines, the decoding scheme requires both the logic high (RA11) and the logic low (RA_11) addresses for the global I/O selection.

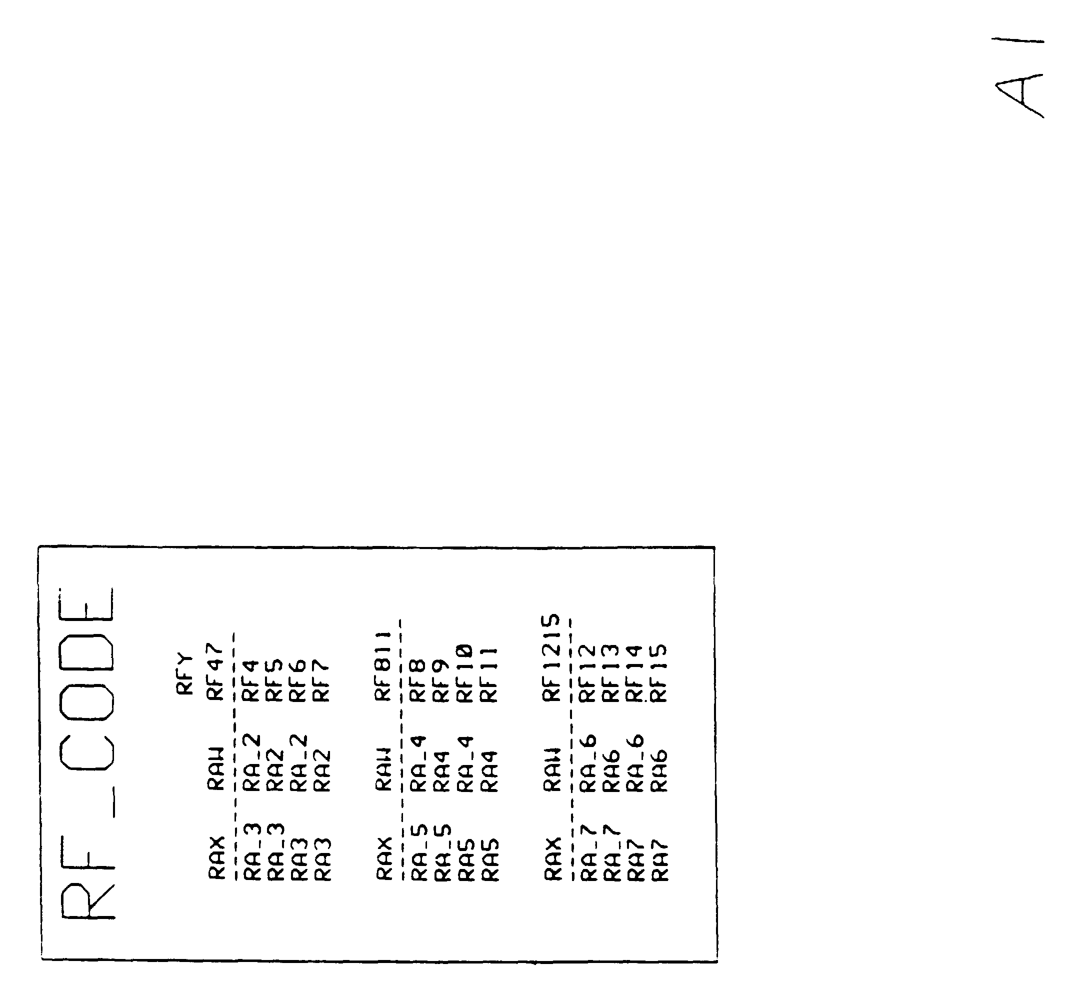

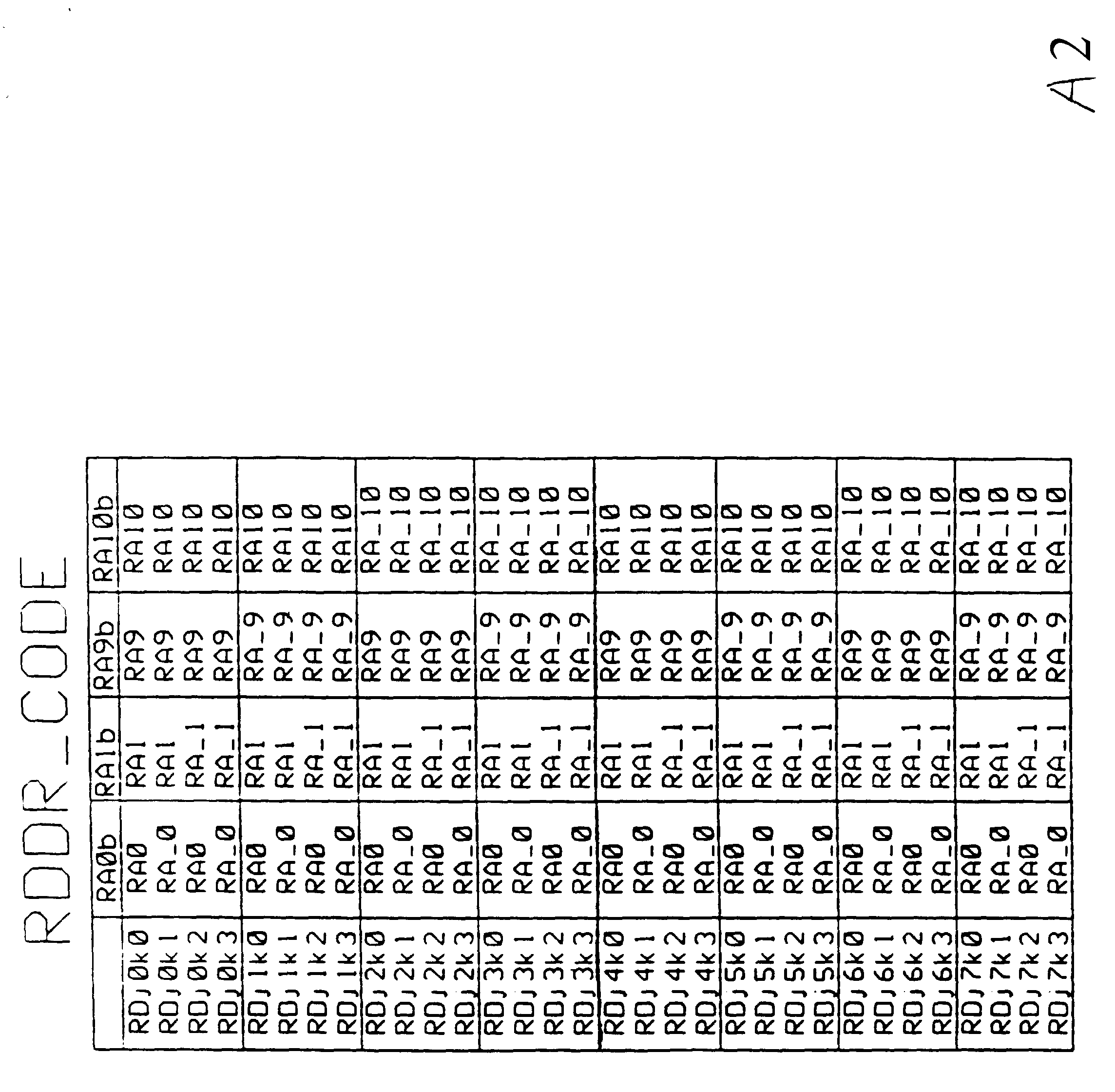

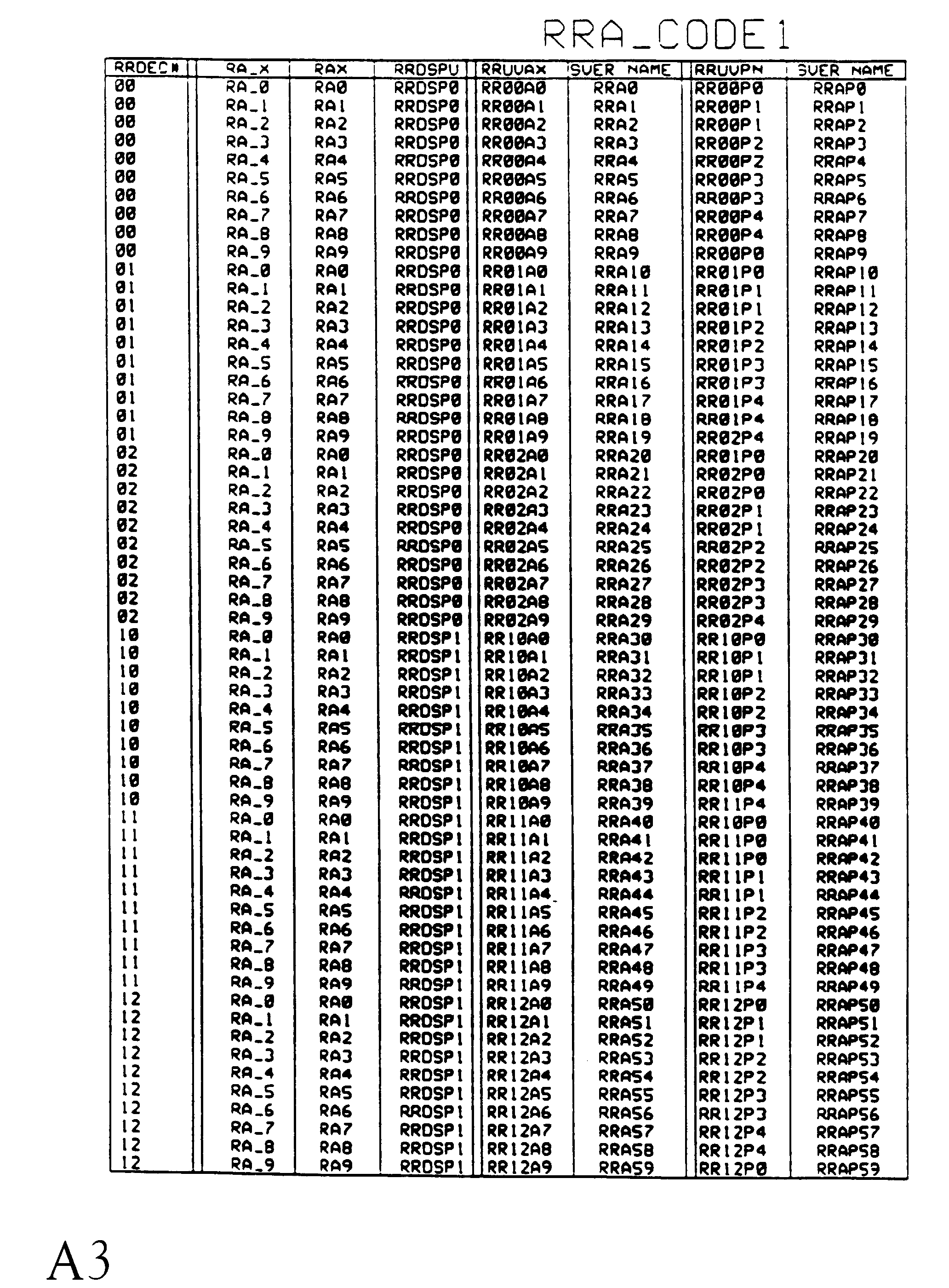

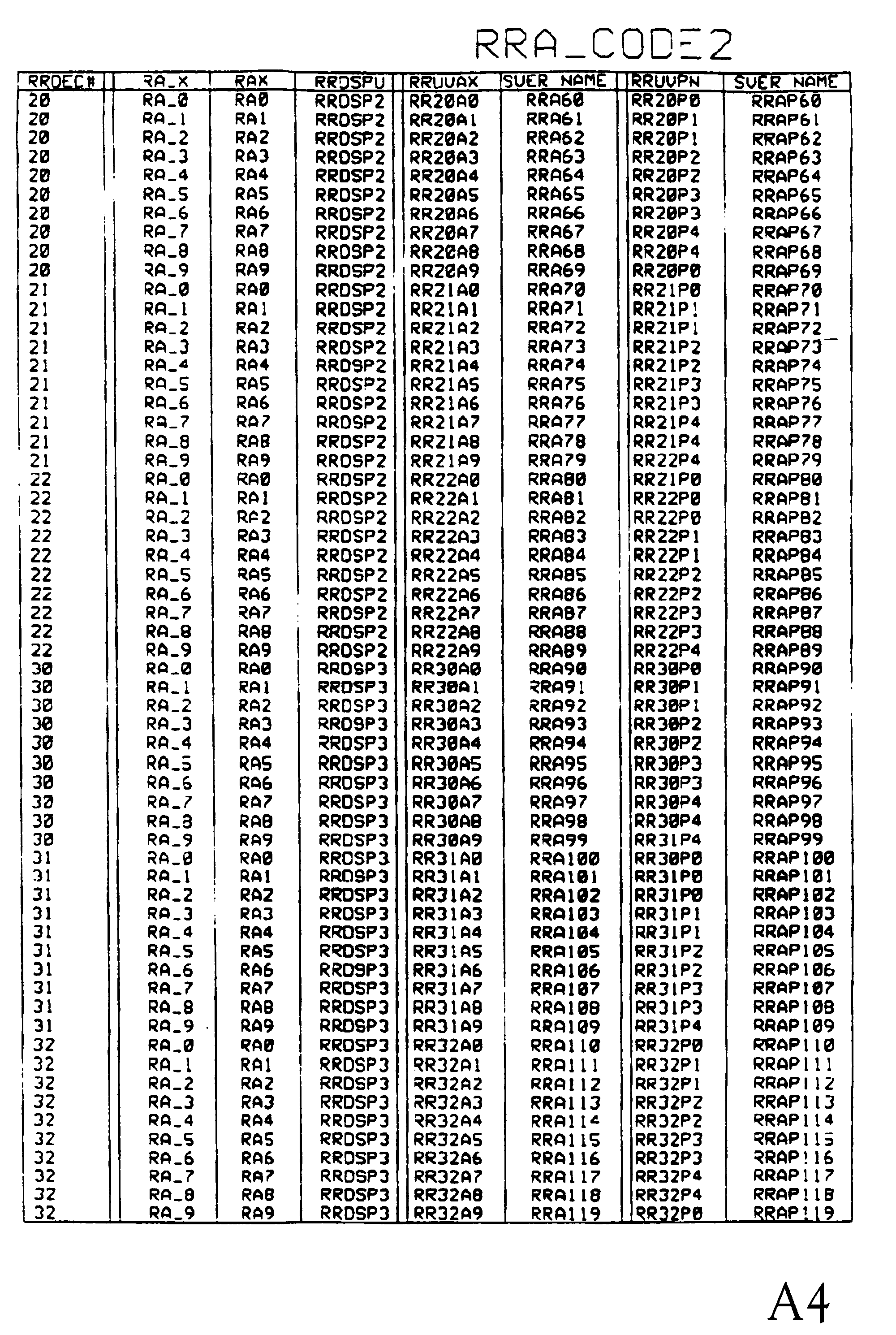

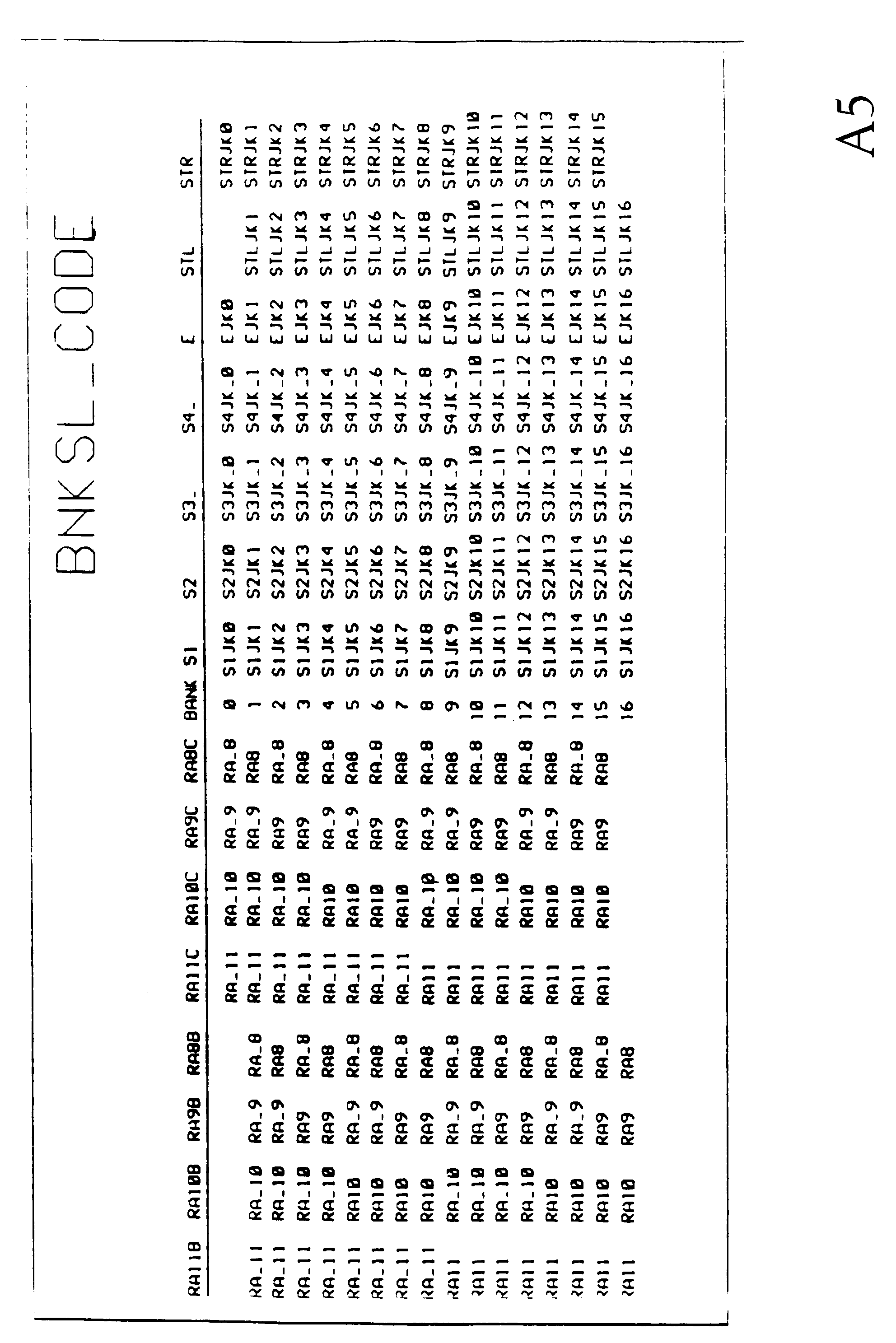

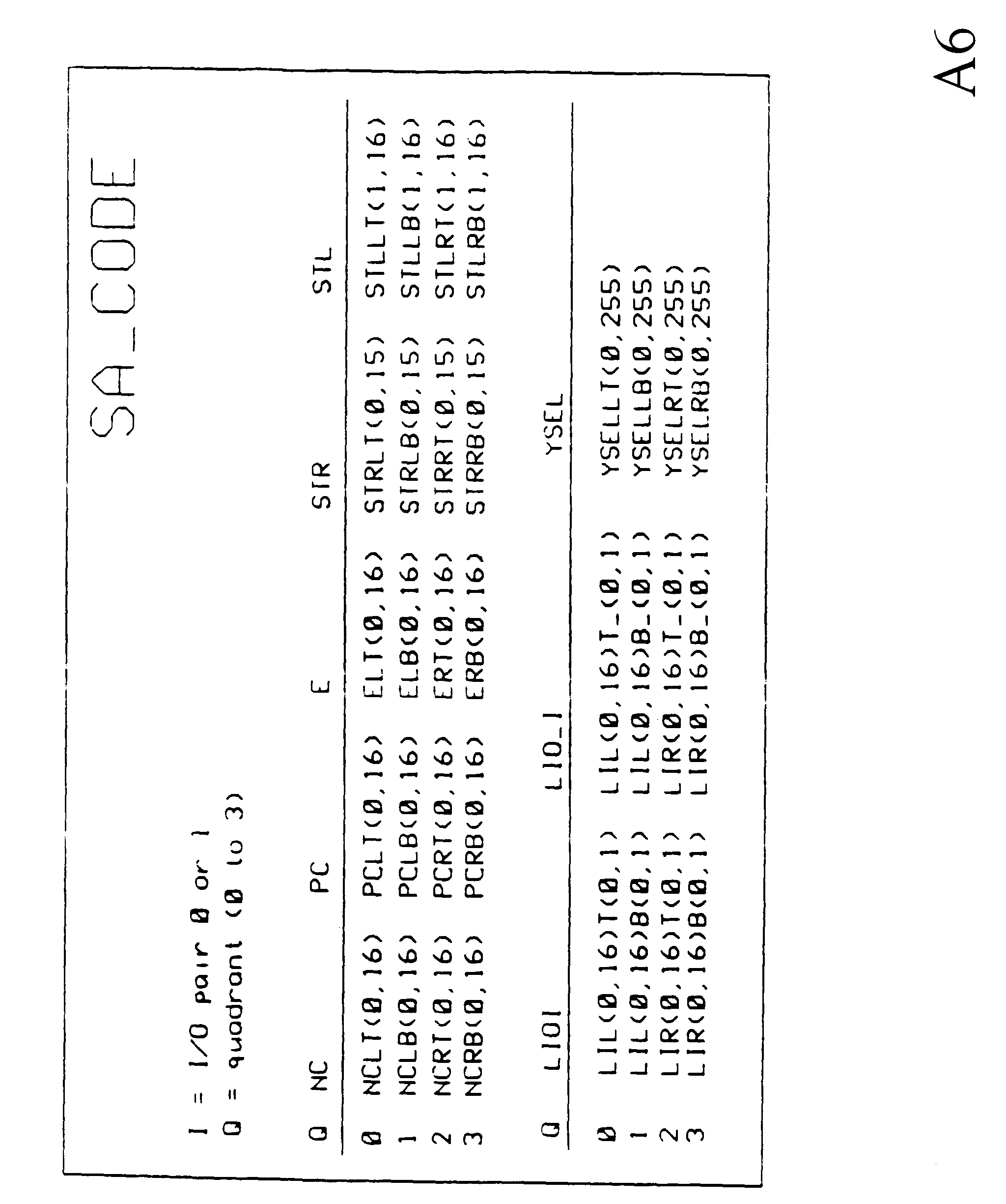

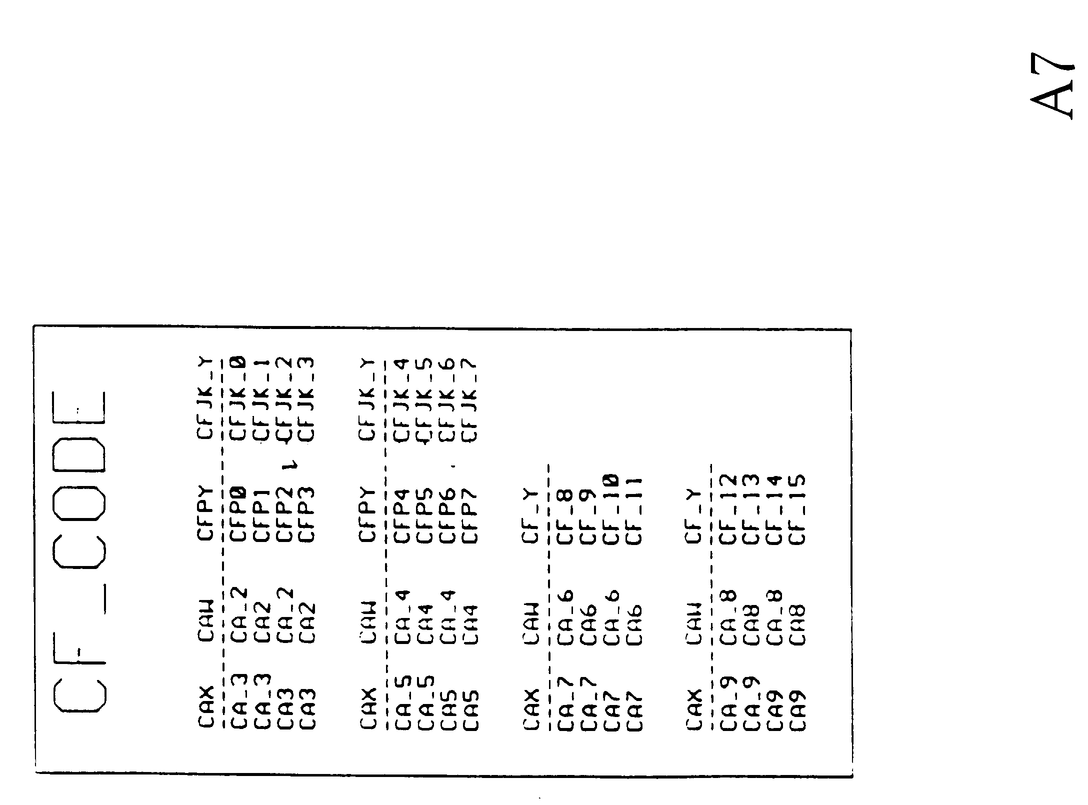

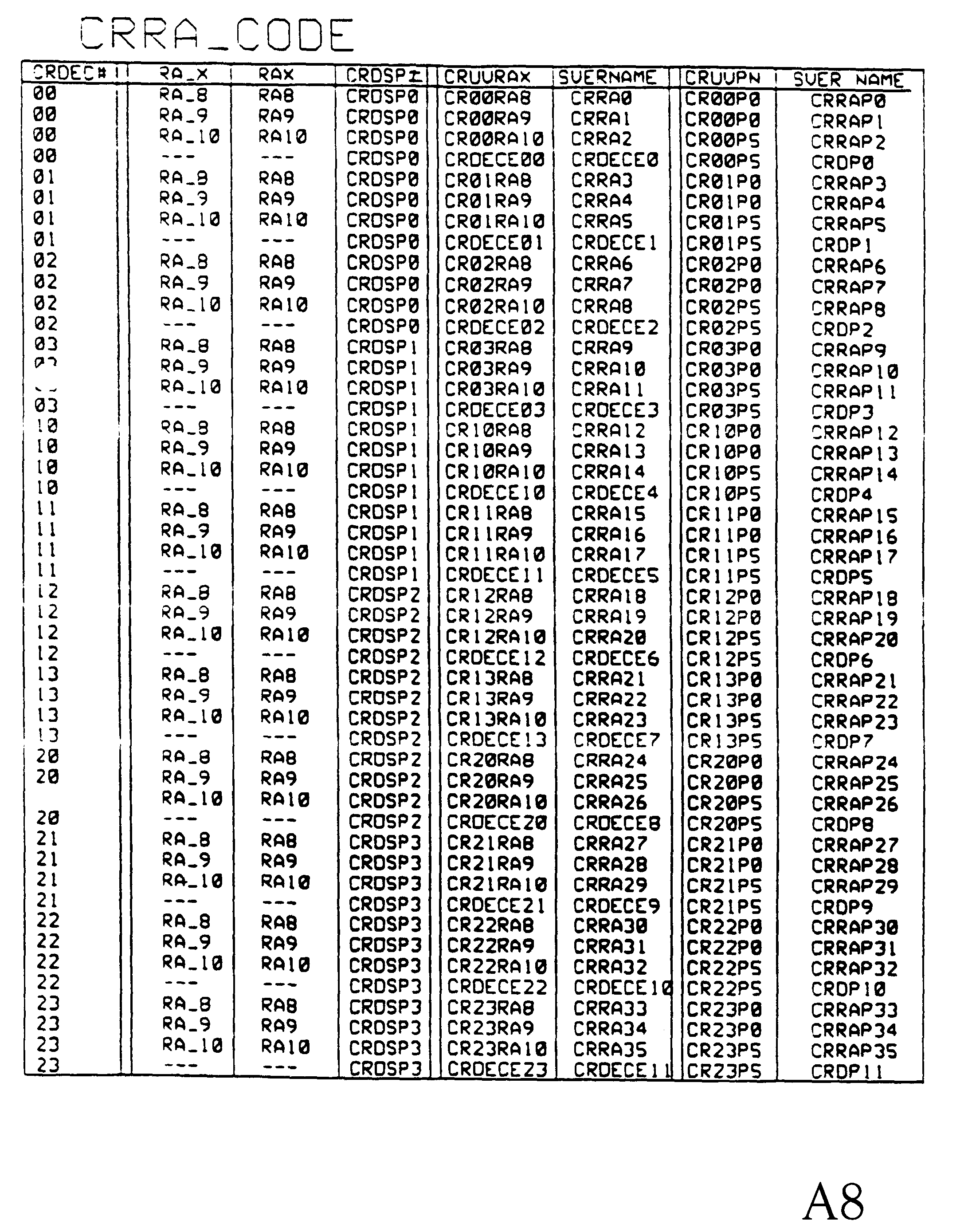

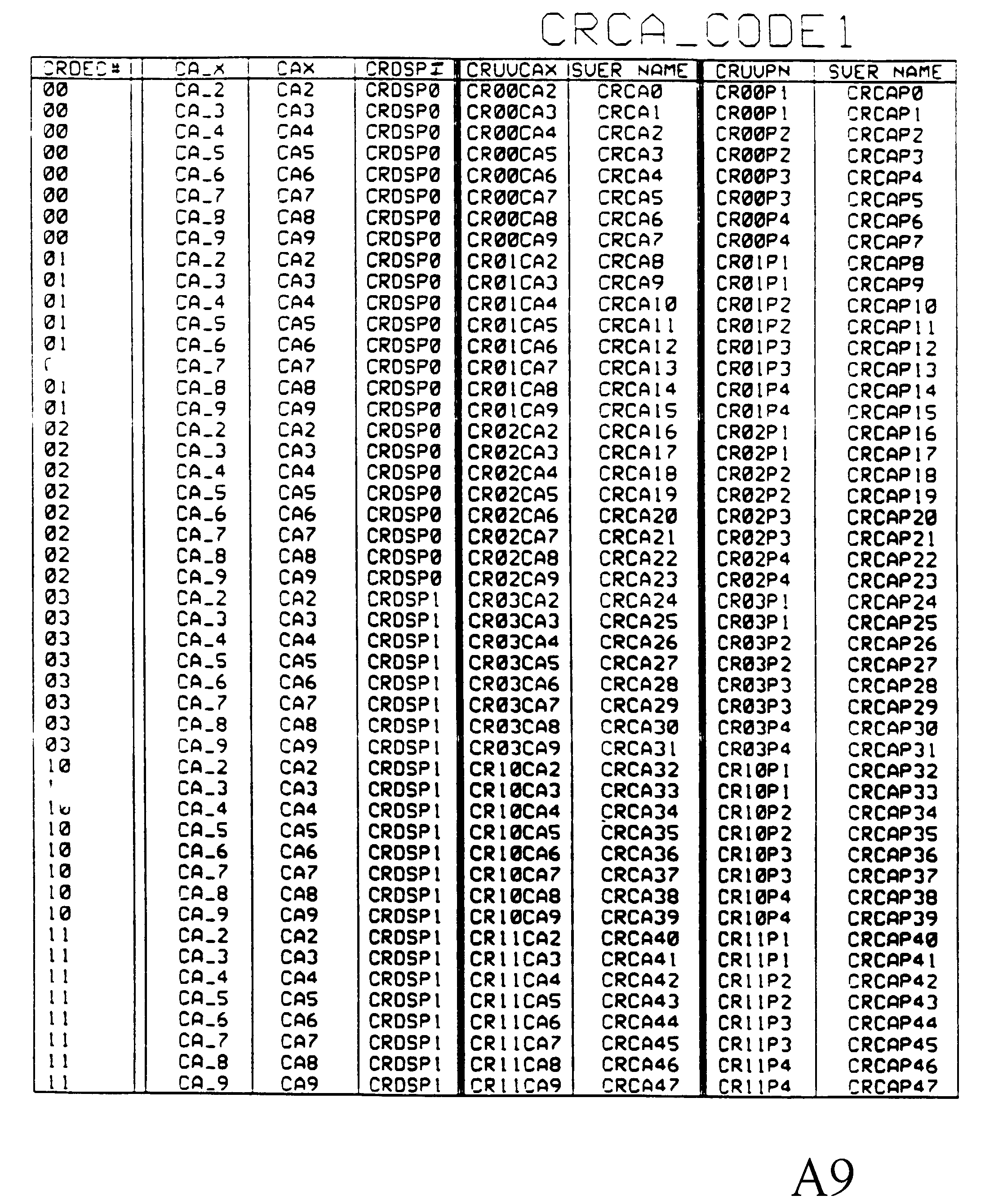

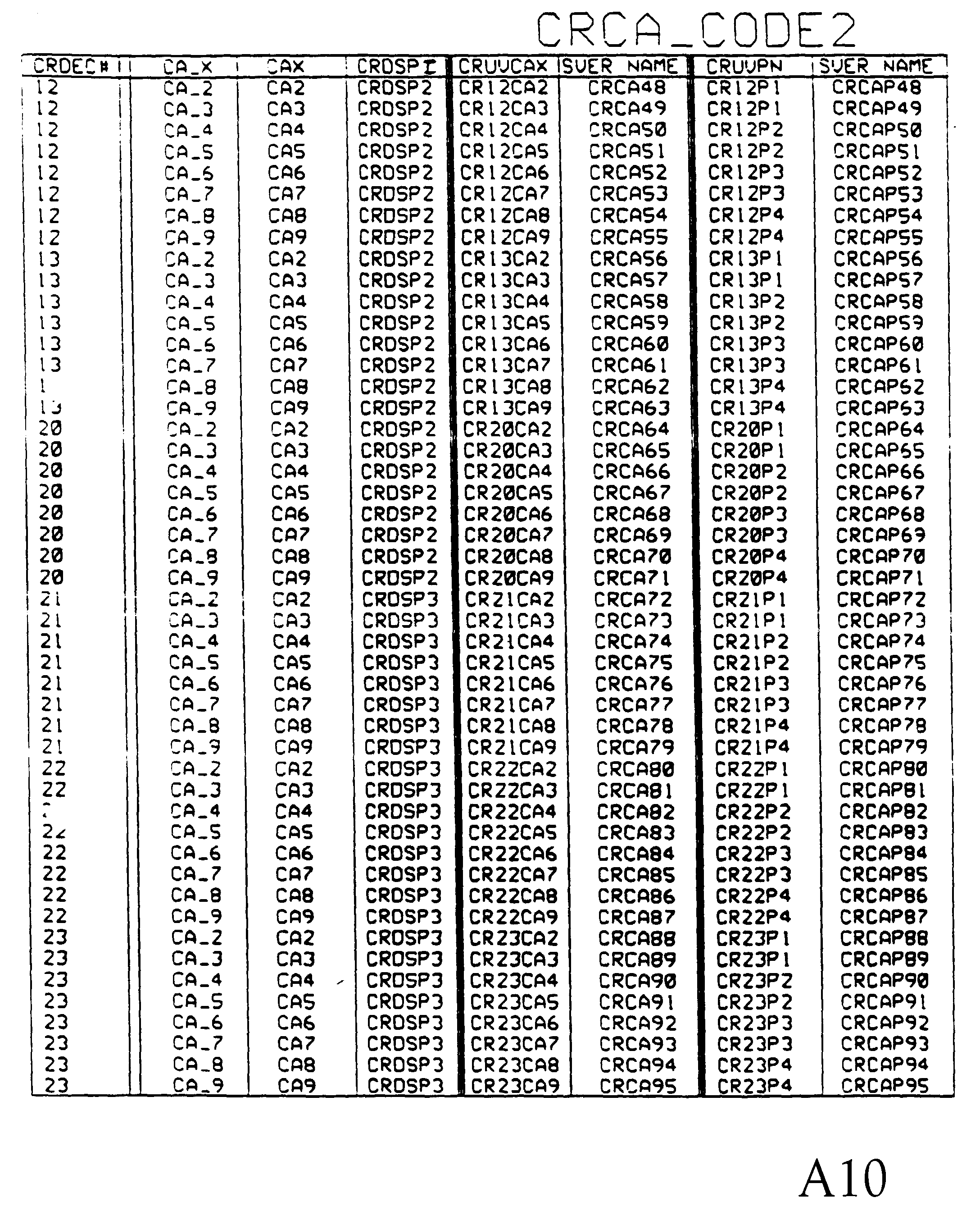

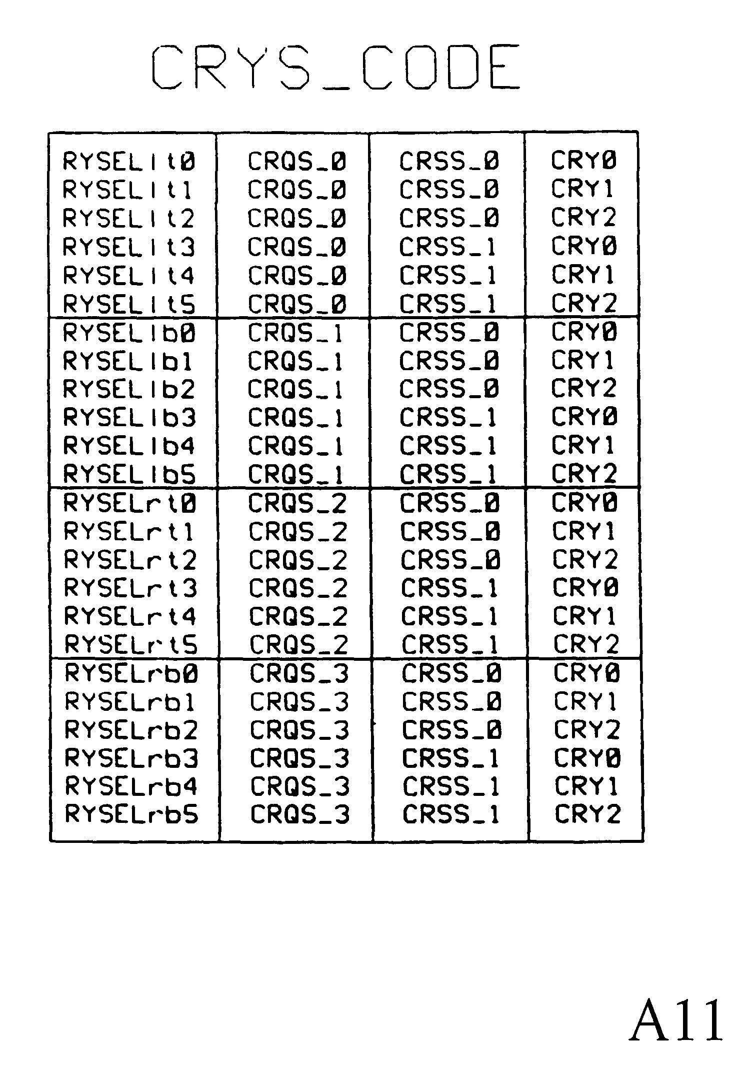

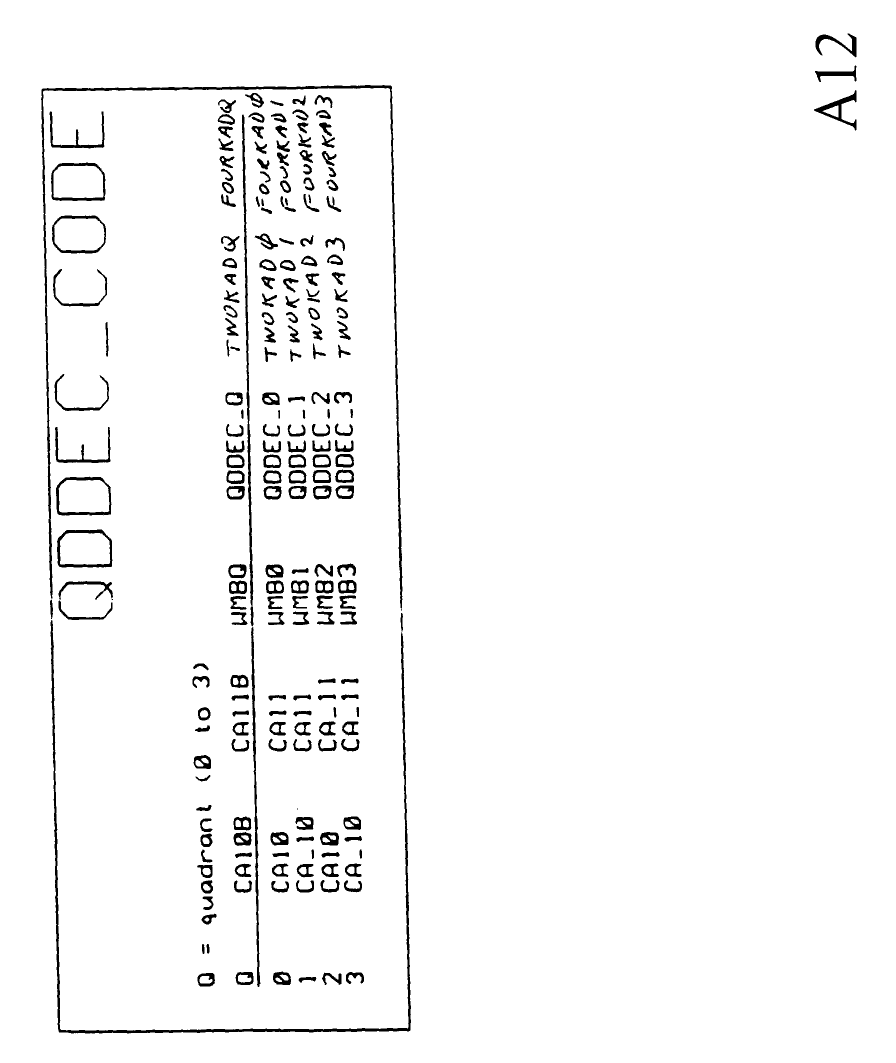

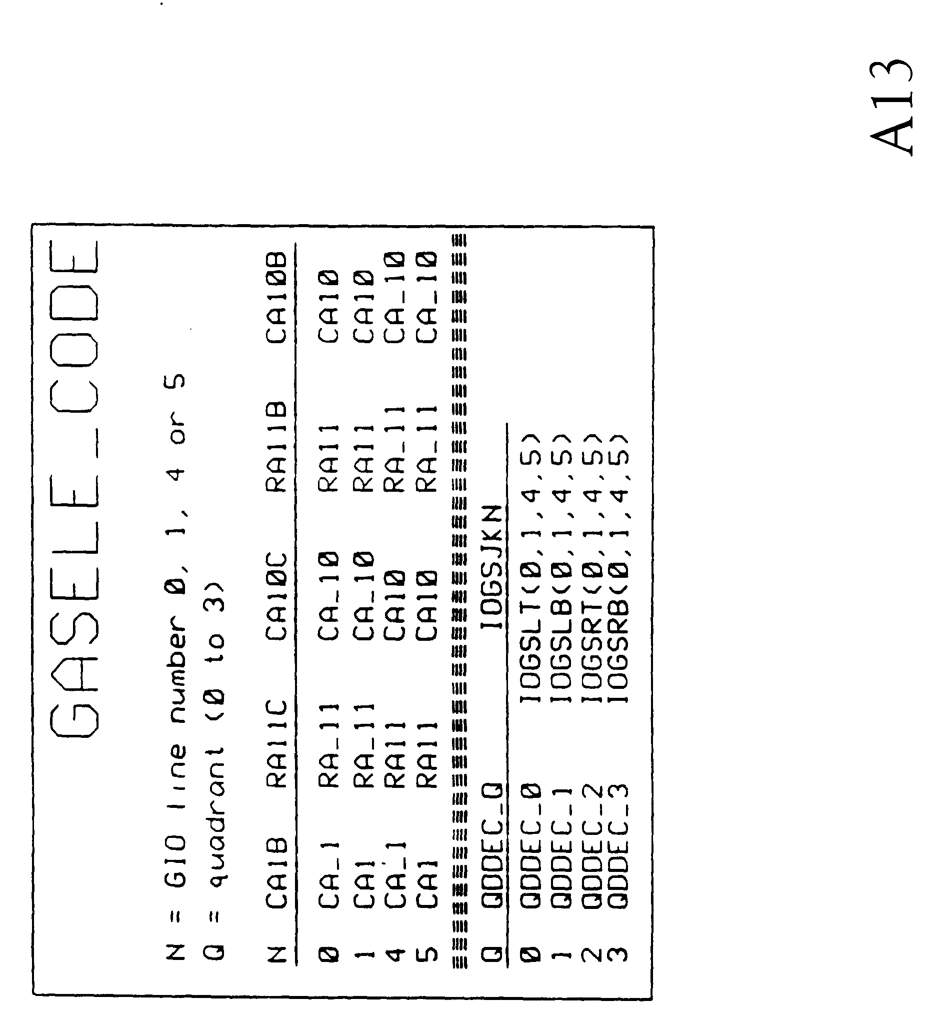

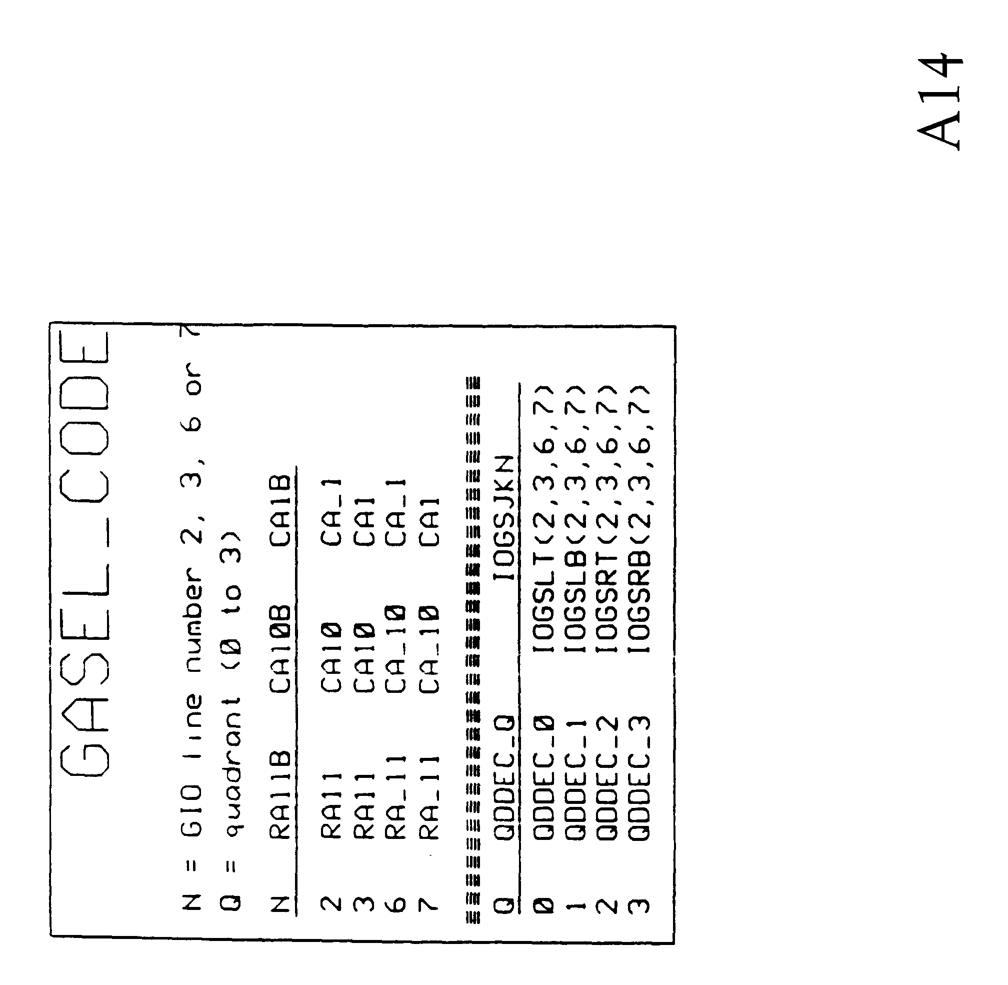

## Claims

1. A memory device comprising:
a plurality of memory arrays (Quadrant 0-3) having memory cells, each memory array including a section of redundant memory cells to substitute for a section of defective main memory cells;
circuitry to read information from the main memory cells and to write information into the main memory cells, the circuitry being responsive to the address of a section of defective main memory cells and arranged to select a section of redundant memory cells;
a first. redundant decoder (RRDEC, CRDEC_) that is programmable to receive the address (RRA, CRA) of a section of defective main memory cells and to store the address of (RRA, CRA) said section of defective main memory cells;
a second redundant decoder (RRQS, CRQS) that is programmable to hold the address of the array containing the section of defective main memory cells;
redundant enabler circuitry (RLEN_, CLEN) for enabling a section of redundant memory cells in only the memory array containing the section of defective main memory cells; and
characterised in that the first redundant decoder (RRDEC, CRDEC_) generates redundant row or column decode signals and redundant row or column factor enable signals (RLEN_R, RLEN_L, CLEN_R, CLEN_L), and that the second redundant decoder (RRQS, CRQS) receives said redundant row or column decode signals and generates an array select signal (RRQS Q, CRQS_Q), the redundant enabler circuitry (RLEN_, CLEN) being arranged to receive the row or column factor enable signals (RLEN_R, RLEN L_, CLEN_R, CLEN_L) and the array select signal (RRQS Q, CRQS_Q), the column or row factor enable signals (RLEN_R, RLEN_L, CLEN_R, CLEN_L) identifying the address of the section of defective main memory cells and the array select signal (RRQS Q, CRQS_Q) identifying the array of main memory cells containing the section of defective main memory cells.

2. The memory device of Claim 1, wherein the first redundant decoder (RRDEC, CRDEC) further comprises:
a two-part programmable redundant decoder, programmable to hold the addresses of a section of defective main memory cells, the redundant decoder being further programmable to hold information identifying the memory array containing the section of defective main memory cells.

3. The memory device of Claims 1 - 2, wherein the or each section of redundant memory cells is a row of memory cells, the redundant row of memory cells being substituted for a defective row of main memory cells.

4. The memory device of Claims 1 - 2, wherein the or each section of redundant memory cells is a column of redundant memory cells, the column of redundant memory cells being substituted for a defective column of main memory cells.

5. The memory device of Claims 1 - 2, wherein the or each section of redundant memory cells comprises rows of redundant memory cells and columns of redundant memory cells, the rows and columns of redundant memory cells being substituted for defective rows and defective columns of main memory cells respectively.

6. The memory device of Claims 1 - 5, wherein the memory device is a dynamic random access memory (DRAM).

7. A method of replacing defective main memory cells in a semiconductor memory device having a plurality of memory arrays of main memory cells, which method comprising the steps of :
reading information from the memory cells and writing information into memory cells;
determining the address of a section of defective main memory cells, and selecting a section of redundant memory cells in only the memory array having a section of defective memory cells;
programming a first redundant decoder (RRDEC, CRDEC_) with the address of a section of defective main memory cells; and
programming a second redundant decoder (RRQS, CRQS) with the address of the array containing the section of defective main memory cells;
enabling, using redundant enabler circuitry (RLEN_, CLEN), a section of redundant memory cells in only the array containing the section of defective main memory cells; and
characterised in that the method further comprises the steps of :
- said first redundant decoder generating redundant row or column decoder signals and redundant row or column factor enable signals (RLEN_R, RLEN_L, CLEN_R, CLEN_L);
- said second redundant decoder receiving said redundant row or column decode signals and generating an array select signal (RRQS Q, CRQS_Q); and
- said redundant enabler circuitry (RLEN_, CLEN) receiving the row or column factor enable signals (RLEN_R, RLEN_L, CLEN_R, CLEN_L) and said array select signal (RRQSQ, CRQS_Q);
the row or column factor enable signals (RLEN_R, RLEN_L, CLEN_R, CLEN_L) identifying the address of the section of defective main memory cells and the array select signal (RRQS Q, CRQS_Q) identifying the array of main memory cells containing the section of defective main memory cells.

## Patentansprüche

1. Speichervorrichtung, mit:
mehreren Speichermatrizen (Quadrant 0-3) mit Speicherzellen, wobei jede Speichermatrix einen Abschnitt aus redundanten Speicherzellen enthält, um einen Abschnitt aus fehlerhaften Hauptspeicherzellen zu ersetzen;
einer Schaltungsanordnung zum Lesen von Information von den Hauptspeicherzellen und zum Schreiben von Information in die Hauptspeicherzellen, wobei die Schaltungsanordnung auf die Adresse eines Abschnitts aus fehlerhaften Hauptspeicherzellen anspricht und so beschaffen ist, daß sie einen Abschnitt aus redundanten Speicherzellen wählt;
einem ersten redundanten Decodierer (RRDEC, CRDEC_), der so programmierbar ist, daß er die Adresse (RRA, CRA) eines Abschnitts aus fehlerhaften Hauptspeicherzellen empfängt und die Adresse (RRA, CRA) des Abschnitts aus fehlerhaften Hauptspeicherzellen speichert;
einem zweiten redundanten Decodierer (RRQS, CRQS), der so programmierbar ist, daß er die Adresse der den Abschnitt aus fehlerhaften Hauptspeicherzellen enthaltenden Matrix hält;
einer redundanten Freigabeschaltungsanordnung (RLEN_, CLEN), die einen Abschnitt aus redundanten Speicherzellen lediglich in derjenigen Speichermatrix freigibt, die den Abschnitt aus fehlerhaften Hauptspeicherzellen enthält; und
dadurch gekennzeichnet, daß der erste redundante Decodierer (RRDEC, CRDEC_) redundante Zeilen- oder Spaltendecodierungssignale und redundante Zeilen- oder Spaltenfaktorfreigabesignale (RLEN_R, RLEN_L, CLEN_R, CLEN_L) erzeugt und daß der zweite redundante Decodierer (RRQS, SRQS) die redundanten Zeilen- oder Spaltendecodierungssignale empfängt und ein Matrixwählsignal (RRQSQ, CRQS_Q) erzeugt, wobei die redundante Freigabeschaltungsanordnung (RLEN_, CLEN) so beschaffen ist, daß sie die Zeilen- oder Spaltenfaktorfreigabesignale (RLEN_R, RLEN_L, CLEN_R, CLEN_L) und das Matrixwählsignal (RRQSQ, CRQS_Q) empfängt, wobei die Spalten- oder Zeilenfaktorfreigabesignale (RLEN_R, RLEN_L, CLEN_R, CLEN_L) die Adresse des Abschnitts aus fehlerhaften Hauptspeicherzellen identifizieren und das Matrixwählsignal (RRQSQ, CRQS_Q) diejenige Matrix aus Speicherzellen identifiziert, die den Abschnitt aus fehlerhaften Hauptspeicherzellen enthält.

2. Speichervorrichtung nach Anspruch 1, in der der erste redundante Decodierer (RRDEC, CRDEC) ferner enthält:
einen zweifach programmierbaren redundanten Decodierer, der so programmierbar ist, das er die Adressen eines Abschnitts aus fehlerhaften Hauptspeicherzellen hält, wobei der redundante Decodierer ferner so programmierbar ist, daß er Information hält, die diejenige Speichermatrix identifiziert, die den Abschnitt aus fehlerhaften Hauptspeicherzellen enthält.

3. Speichervorrichtung nach den Ansprüchen 1-2, in der der oder jeder Abschnitt aus redundanten Speicherzellen eine Zeile von Speicherzellen ist, wobei die redundante Zeile aus Speicherzellen eine fehlerhafte Zeile aus Hauptspeicherzellen ersetzt.

4. Speichervorrichtung nach den Ansprüchen 1-2, in der der oder jeder Abschnitt aus redundanten Speicherzellen eine Spalte aus redundanten Speicherzellen ist, wobei die Spalte aus redundanten Speicherzellen eine fehlerhafte Spalte aus Hauptspeicherzellen ersetzt.

5. Speichervorrichtung nach den Ansprüchen 1-2, in der der oder jeder Abschnitt aus redundanten Speicherzellen Zeilen aus redundanten Speicherzellen und Spalten aus redundanten Speicherzellen enthält, wobei die Zeilen und Spalten aus redundanten Speicherzellen fehlerhafte Zeilen bzw. fehlerhafte Spalten aus Hauptspeicherzellen ersetzen.

6. Speichervorrichtung nach den Ansprüchen 1-5, wobei die Speichervorrichtung ein dynamischer Schreib-Lese-Speicher (DRAM) ist.

7. Verfahren zum Ersetzen fehlerhafter Hauptspeicherzellen in einer Halbleiterspeichervorrichtung mit mehreren Speichermatrizen aus Hauptspeicherzellen, wobei das Verfahren die Schritte enthält:
Lesen von Informationen aus den Speicherzellen und Schreiben von Informationen in die Speicherzellen;
Bestimmen der Adresse eines Abschnitts aus fehlerhaften Hauptspeicherzellen und Auswählen eines Abschnitts aus redundanten Speicherzellen lediglich in derjenigen Speichermatrix, die einen Abschnitt aus fehlerhaften Speicherzellen besitzt;
Programmieren eines ersten redundanten Decodierers (RRDEC, CRDEC_) mit der Adresse eines Abschnitts aus fehlerhaften Hauptspeicherzellen; und
Programmieren eines zweiten redundanten Decodierers (RRQS, CRQS) mit der Adresse der Matrix, die den Abschnitt aus fehlerhaften Hauptspeicherzellen enthält;
Freigeben eines Abschnitts aus redundanten Speicherzellen lediglich in der den Abschnitt aus fehlerhaften Hauptspeicherzellen enthaltenden Matrix unter Verwendung einer redundanten Freigabeschaltungsanordnung (RLEN_, CLEN); und
dadurch gekennzeichnet, daß das Verfahren ferner die Schritte enthält:
Erzeugen von redundanten Zeilen- oder Spaltendecodierungssignalen und von redundanten Zeilen- oder Spaltenfaktorfreigabesignalen (RLEN_R, RLEN_L, CLEN_R, CLEN_L) durch den ersten redundanten Decodierer;
Empfangen der redundanten Zeilen- oder Spaltendecodierungssignale und Erzeugen eines Matrixwählsignals (RRQSQ, CRQS_Q) durch den zweiten redundanten Decodierer; und
Empfangen der Zeilen- oder Spaltenfaktorfreigabesignale (RLEN_R, RLEN_L, CLEN_R, CLEN_L) und des Matrixwählsignals (RRQSQ, CRQS_Q) durch die redundante Freigabeschaltungsanordnung (RLEN_, CLEN);
wobei die Zeilen- oder Spaltenfaktorfreigabesignale (RLEN_R, RLEN_L, CLEN_R, CLEN_L) die Adresse des Abschnitts aus fehlerhaften Hauptspeicherzellen identifizieren und das Matrixwählsignal (RRQSQ, CRQS_Q) diejenige Matrix von Hauptspeicherzellen identifiziert, die den Abschnitt aus fehlerhaften Hauptspeicherzellen enthält.

## Revendications

1. Dispositif de mémoire comprenent :
une pluralité de réseaux de mémoire (Quadrant 0 à 3) ayant des cellules de mémoire, chaque réseau de mémoire incluant une section de cellules de mémoire redondantes pour remplacer à une section de cellules de mémoire principale défectueuses ;
un circuit pour lire des informations depuis les cellules de mémoire principale et pour écrire des informations dans les cellules de mémoire principale, le circuit étant apte à répondre à l'adresse d'une section de cellules de mémoire principale défectueuses et agencé pour sélectionner une section de cellules de mémoire redondantes ;
un premier décodeur redondant (RRDEC, CRDEC_) qui est programmable pour recevoir l'adresse (RRA, CRA) d'une section de cellules de mémoire principale défectueuses et pour stocker l'adresse (RRA, CRA) de ladite section de cellules de mémoire principale défectueuses ;
un second décodeur redondant (RRQS, CRQS) qui est programmable pour retenir l'adresse du réseau contenant la section de cellules de mémoire principale défectueuses ;
un circuit d'activation redondant (RLEN_, CLEN) pour activer une section de cellules de mémoire redondantes dans seulement le réseau de mémoire contenant la section de cellules de mémoire principale défectueuses ; et
caractérisé en ce que le premier décodeur redondant (RRDEC, CRDEC_) engendre des signaux redondants de décodage de colonnes ou de rangées et des signaux redondants d'activation de facteurs de colonnes ou de rangées (RLEN_R, RLEN_L, CLEN_R, CLEN_L), et en ce que le second décodeur redondant (RRQS, CRQS) reçoit lesdits signaux redondants de décodage de colonnes ou de rangées et engendre un signal de sélection de réseau (RRQSQ, CRQS_Q,) le circuit d'activation redondant (RLEN_, CLEN) étant agencé pour recevoir les signaux d'activation de facteurs de colonnes ou de rangées (RLEN_R, RLEN_L, CLEN_R, CLEN_L) et le signal de sélection de réseau (RRQSQ, CRQS_Q), les signaux d'activation de facteurs de rangées ou de colonnes (RLEN_R, RLEN_L, CLEN_R, CLEN_L) identifiant l'adresse de la section de cellules de mémoire principale défectueuses et le signal de sélection de réseau (RRQSQ, CRQS_Q) identifiant le réseau des cellules de mémoire principale contenant la section de cellules de mémoire principale défectueuses.

2. Dispositif de mémoire selon la revendication 1, dans lequel le premier décodeur redondant (RRDEC, CRDEC) comprend en outre :
un décodeur redondant programmable en deux parties, programmable pour retenir les adresses d'une section de cellules de mémoire principale défectueuses, le décodeur redondant étant en outre programmable pour retenir des informations identifiant le réseau de mémoire contenant la section de cellules de mémoire principale défectueuses.

3. Dispositif de mémoire des revendications 1 à 2, dans lequel la ou chaque section de cellules de mémoire redondantes est une rangée de cellules de mémoire, la rangée redondante de cellules de mémoire étant substituée pour une rangée défectueuse de cellules de mémoire principale.

4. Dispositif de mémoire des revendications 1 à 2, dans lequel la ou chaque section de cellules de mémoire redondantes est une colonne de cellules de mémoire redondantes, la colonne de cellules de mémoire redondantes étant substituée pour une colonne défectueuse de cellules de mémoire principale.

5. Dispositif de mémoire des revendications 1 à 2, dans lequel la ou chaque section de cellules de mémoire redondantes comprend des rangées de cellules de mémoire redondantes et des colonnes de cellules de mémoire redondantes, les rangées et colonnes de cellules de mémoire redondantes étant substituées pour des rangées défectueuses et des colonnes défectueuses de cellules de mémoire principale, respectivement.

6. Dispositif de mémoire des revendications 1 à 5, dens lequel le dispositif de mémoire est une mémoire dynamique à accès aléatoire (DRAM).

7. Procédé de remplacement de cellules de mémoire principale défectueuses dans un dispositif de mémoire à semiconducteur ayant une pluralité de réseaux de mémoire de cellules de mémoire principale, lequel procédé comprend les étapes de :
- lire des informations des cellules de mémoire et écrire des informations dans les cellules de mémoire ;
- déterminer l'adresse d'une section de cellules de mémoire principale défectueuses, et sélectionner une section de cellules de mémoire redondantes dans seulement le réseau de mémoires ayant une section de cellules de mémoire défectueuses ;
- programmer un premier décodeur redondant (RRDEC, CRDEC_) avec l'adresse d'une section de cellules de mémoire principale défectueuses ; et
- programmer un second décodeur redondant (RRQS, CRQS) avec l'adresse du réseau contenant la section de cellules de mémoire principale défectueuses ;
- permettre l'utilisation d'un circuit d'activation redondant (RLEN_, CLEN), une section de cellules de mémoire redondantes dans seulement le réseau contenant la section de cellules de mémoire principale défectueuses ; et
caractérisé en ce que le procédé comprend en outre les étapes
- ledit premier décodeur redondant engendre des signaux redondants de décodage de colonnes ou de rangées et des signaux redondants d'activation de facteurs de colonnes ou de rangées redondants (RLEN_R, RLEN_L, CLEN_R, CLEN_L) ;
- ledit second décodeur redondant reçoit lesdits signaux redondants de décodage de colonnes ou de rangées et engendre un signal de sélection de réseau (RRQSQ, CRQS_Q) ; et
- ledit circuit d'activation redondant (RLEN_, CLEN) reçoit les signaux d'activation de facteurs de rangées ou de colonnes (RLEN_R, RLEN_L, CLEN_R, CLEN_L) et ledit signal de sélection de réseau (RRQSQ, CRQS_Q);
- les signaux d'activation de facteurs de colonnes ou de rangées (RLEN_R, RLEN_L, CLEN_R, CLEN_L) identifient l'adresse de la section de cellules de mémoire principale défectueuses et le signal de sélection de réseau (RRQSQ, CRQS_Q) identifie le réseau de cellules de mémoire principale contenant la section de cellules de mémoire principale défectueuses.
